# EUROPEAN PATENT APPLICATION

(11) **EP 3 409 722 A1**
(43) Date of publication of application: **05.12.2018**
(21) Application number: 17744304.1
(22) Date of filing: 26.01.2017
(51) Int. Cl.: C08L 65/00, C08G 61/12, C08K 3/08, C08K 5/50, C09D 11/102, H01L 29/786

(54) **COMPOSITION AND ORGANIC THIN FILM TRANSISTOR USING SAME**

(30) Priority: 29.01.2016 JP 2016015249
(71) Applicant: Sumitomo Chemical Company Limited, Tokyo 104-8260 (JP)
(72) Inventor: KANESAKA, Sho, Tsukuba-shi Ibaraki 300-3294 (JP); YOSHIDA, Hidekazu, Osaka-shi Osaka 554-8558 (JP); KASHIKI, Tomoya, Osaka-shi Osaka 554-8558 (JP)
(74) Representative: J A Kemp
(86) International application number: PCT/JP2017/002673
(87) International publication number: WO 2017/131074

(57) **Abstract**

A composition comprising a polymer compound containing a structural unit represented by the formula (1) and at least one compound selected from the group consisting of a compound containing Pd, a compound containing P and a compound containing Pd and P, wherein the content rate of the polymer compound is 95% by mass or more, the content rate of Pd is 50 ppm by mass or less and the content rate of P is 60 ppm by mass or less: 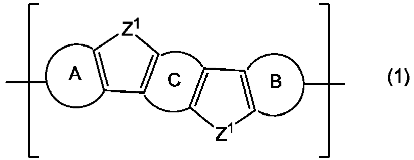 wherein the ring A and the ring B each independently represent a hetero ring having a number of carbon atoms of 2 to 30 optionally having a substituent. The ring C represents an aromatic hydrocarbon ring having a number of carbon atoms of 6 to 30 optionally having a substituent or a hetero ring having a number of carbon atoms of 2 to 30 optionally having a substituent.

Z¹ represents a group represented by the formula (Z-1), a group represented by the formula (Z-2), a group represented by the formula (Z-3), a group represented by the formula (Z-4) or a group represented by the formula (Z-5). A plurality of Z¹ may be mutually the same or different. 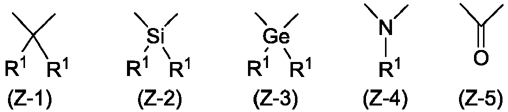 wherein R¹ represents an alkyl group having a number of carbon atoms of 1 to 30 optionally having a substituent, a cycloalkyl group having a number of carbon atoms of 3 to 30 optionally having a substituent, or the like. When a plurality of R¹ are present, they may be the same or different.

## Description

### Technical Field

The present invention relates to a composition and an organic thin film transistor using the same.

### Background Art

Organic thin film transistors using organic semiconductor materials are actively researched and developed since they can be manufactured at lower temperature compared with conventional transistors using inorganic semiconductor materials and further it is expected to reduce device weight and manufacturing cost thereof. As a composition used for the organic semiconductor material, compositions containing a Pd-containing compound and a polymer compound represented by the following formula of which content rate of Pd is 508 to 3124 ppm have been reported (Non-patent document 1).

In addition, it is reported that the content rate of Pd in the composition does not affect electric field-effect mobility, in these compositions.

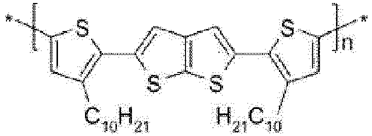

### [Prior Art Document]

### [Non-Patent Document]

[Non-patent document 1] Org. Electron., 2009, 10, 215-221

### Summary of the Invention

### Problem to be Solved by the Invention

However, an organic thin film transistor using the organic semiconductor material has not necessarily been satisfied with electric field-effect mobility, depending on the type of the organic semiconductor material.

Accordingly, an object of the present invention is to provide a composition which is useful for production of an organic thin film transistor having high electric field-effect mobility and this organic thin film transistor.

### Means for Solving the Problem

The present invention is as described below.
[1] A composition comprising a polymer compound containing a structural unit represented by the formula (1) and at least one compound selected from the group consisting of a compound containing Pd, a compound containing P and a compound containing Pd and P, wherein the content rate of the polymer compound is 95% by mass or more, the content rate of Pd is 50 ppm by mass or less and the content rate of P is 60 ppm by mass or less: 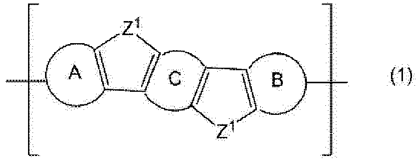 [wherein,
   the ring A and the ring B each independently represent a hetero ring having a number of carbon atoms of 2 to 30 optionally having a substituent.

The ring C represents an aromatic hydrocarbon ring having a number of carbon atoms of 6 to 30 optionally having a substituent or a hetero ring having a number of carbon atoms of 2 to 30 optionally having a substituent. The substituent which these groups optionally have is selected from the following Group 1.

Z¹ represents a group represented by the formula (Z-1), a group represented by the formula (Z-2), a group represented by the formula (Z-3), a group represented by the formula (Z-4) or a group represented by the formula (Z-5). A plurality of Z¹ may be mutually the same or different.

Group 1: an alkyl group having a number of carbon atoms of 1 to 30, a cycloalkyl group having a number of carbon atoms of 3 to 30, an alkoxy group having a number of carbon atoms of 1 to 30, a cycloalkoxy group having a number of carbon atoms of 3 to 30, an alkylthio group having a number of carbon atoms of 1 to 30, a cycloalkylthio group having a number of carbon atoms of 3 to 30, an aryl group having a number of carbon atoms of 6 to 30, a monovalent hetero ring group having a number of carbon atoms of 2 to 30, a halogen atom, a group represented by -Si(R')₃ (three R' each independently represent a hydrogen atom, an alkyl group having a number of carbon atoms of 1 to 30, a cycloalkyl group having a number of carbon atoms of 3 to 30 or a monovalent hetero ring group having a number of carbon atoms of 2 to 30 optionally having an alkyl group.), a group represented by -N(R')₂ (two R' represent the same meaning as described above.), an alkenyl group having a number of carbon atoms of 2 to 30, a cycloalkenyl group having a number of carbon atoms of 3 to 30, an alkynyl group having a number of carbon atoms of 2 to 30, a cycloalkynyl group having a number of carbon atoms of 3 to 30, a hydroxy group, a nitro group, a cyano group, a carboxy group, an alkylcarbonyl group having a number of carbon atoms of 2 to 30, a cycloalkylcarbonyl group having a number of carbon atoms of 4 to 30, an alkoxycarbonyl group having a number of carbon atoms of 2 to 30 and a cycloalkoxycarbonyl group having a number of carbon atoms of 4 to 30.] 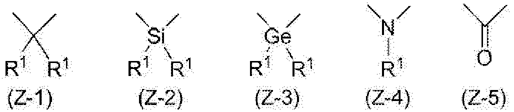 [wherein,
R¹ represents an alkyl group having a number of carbon atoms of 1 to 30 optionally having a substituent, a cycloalkyl group having a number of carbon atoms of 3 to 30 optionally having a substituent, an alkoxy group having a number of carbon atoms of 1 to 30 optionally having a substituent, a cycloalkoxy group having a number of carbon atoms of 3 to 30 optionally having a substituent, an alkylthio group having a number of carbon atoms of 1 to 30 optionally having a substituent, a cycloalkylthio group having a number of carbon atoms of 3 to 30 optionally having a substituent, an aryl group having a number of carbon atoms of 6 to 30 optionally having a substituent or a monovalent hetero ring group having a number of carbon atoms of 2 to 30 optionally having a substituent. When a plurality of R¹ are present, they may be the same or different.].
[2] The composition according to [1], comprising a polymer compound containing a structural unit represented by the formula (1) and at least one compound selected from the group consisting of a compound containing Pd, a compound containing P and a compound containing Pd and P, wherein the content rate of the polymer compound is 95% by mass or more, the content rate of Pd is 50 ppm by mass or less and the content rate of P is 30 ppm by mass or less.
[3] The composition according to [1] or [2], wherein the structural unit represented by the above-described formula (1) is a structural unit represented by the formula (1-1), a structural unit represented by the formula (1-2) or a structural unit represented by the formula (1-3): 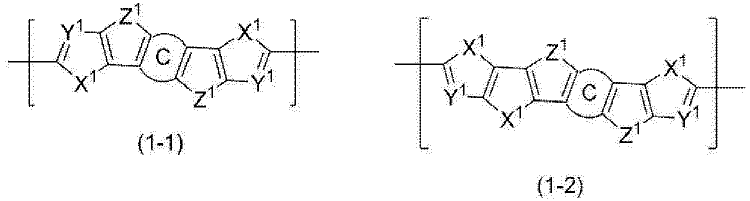 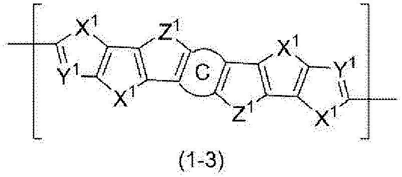 [wherein,
   the ring C and Z¹ represent the same meaning as described above.
   X¹ represents an oxygen atom, a sulfur atom or a selenium atom. A plurality of X¹ may be mutually the same or different.
   Y¹ represents a nitrogen atom or a group represented by -CR²= (R² represents a hydrogen atom, an alkyl group having a number of carbon atoms of 1 to 30 optionally having a substituent, a cycloalkyl group having a number of carbon atoms of 3 to 30 optionally having a substituent, an alkoxy group having a number of carbon atoms of 1 to 30 optionally having a substituent, a cycloalkoxy group having a number of carbon atoms of 3 to 30 optionally having a substituent, an alkylthio group having a number of carbon atoms of 1 to 30 optionally having a substituent, a cycloalkylthio group having a number of carbon atoms of 3 to 30 optionally having a substituent, an aryl group having a number of carbon atoms of 6 to 30 optionally having a substituent, a monovalent hetero ring group having a number of carbon atoms of 2 to 30 optionally having a substituent or a halogen atom.). A plurality of Y¹ may be mutually the same or different.].
[4] The composition according to any one of [1] to [3], wherein the ring A and the ring B in the above-described formula (1) are each independently a hetero ring having a number of carbon atoms of 3 to 10 constituted of a 5-membered and/or 6-membered hetero ring optionally having a substituent.
[5] The composition according to [4], wherein the ring A and the ring B in the above-described formula (1) are the same and represent a thiophene ring optionally having a substituent or a thienothiophene ring optionally having a substituent.
[6] The composition according to any one of [1] to [5], wherein the above-described ring C is a benzene ring optionally having a substituent, a naphthalene ring optionally having a substituent, a benzodithiophene ring optionally having a substituent, a benzothiophene ring optionally having a substituent or a thienothiophene ring.
[7] The composition according to [6], wherein the above-described ring C is a benzene ring optionally having a substituent or a naphthalene ring optionally having a substituent.
[8] The composition according to [3], [6] or [7], wherein the above-described X¹ is a sulfur atom.
[9] The composition according to [3], [6], [7] or [8], wherein the above-described Y¹ is a group represented by - CH=.
[10] The composition according to any one of [1] to [9], wherein the above-described Z¹ is a group represented by the above-described formula (Z-1).
[11] The composition according to any one of [1] to [10], wherein the polymer compound containing a structural unit represented by the above-described formula (1) further contains a structural unit represented by the formula (2) (different from the structural unit represented by the above-described formula (1)):

   ⁅Ar⁆ (2)

   [wherein, Ar represents an arylene group having a number of carbon atoms of 6 to 60 optionally having a substituent or a divalent hetero ring group having a number of carbon atoms of 2 to 30 optionally having a substituent. The substituent which these groups optionally have is selected from the following Group 2. However, the structural unit represented by the formula (2) is different from the structural unit represented by the formula (1).
   Group 2: an alkyl group having a number of carbon atoms of 1 to 30, a cycloalkyl group having a number of carbon atoms of 3 to 30, an alkoxy group having a number of carbon atoms of 1 to 30, a cycloalkoxy group having a number of carbon atoms of 3 to 30, an alkylthio group having a number of carbon atoms of 1 to 30, a cycloalkylthio group having a number of carbon atoms of 3 to 30, a monovalent aryl group having a number of carbon atoms of 6 to 30, a monovalent hetero ring group having a number of carbon atoms of 2 to 30 and a halogen atom.].
[12] An ink composition comprising the composition according to any one of [1] to [11] and an organic solvent, wherein the value of (mass of composition)/(mass of composition and organic solvent) × 100 is 0.1% by mass or more and 20% by mass or less.
[13] An organic thin film transistor having a gate electrode, a source electrode, a drain electrode, an organic semiconductor layer and a gate insulation layer, wherein the above-described organic semiconductor layer contains the composition according to any one of [1] to [11] .

### Brief Explanation of Drawings

Fig. 1 is a schematic cross-sectional view of an organic thin film transistor according to a first embodiment.
Fig. 2 is a schematic cross-sectional view of an organic thin film transistor according to a second embodiment.
Fig. 3 is a schematic cross-sectional view of an organic thin film transistor according to a third embodiment.
Fig. 4 is a schematic cross-sectional view of an organic thin film transistor according to a fourth embodiment.
Fig. 5 is a schematic cross-sectional view of an organic thin film transistor according to a fifth embodiment.
Fig. 6 is a schematic cross-sectional view of an organic thin film transistor according to a sixth embodiment.
Fig. 7 is a schematic cross-sectional view of an organic thin film transistor according to a seventh embodiment.

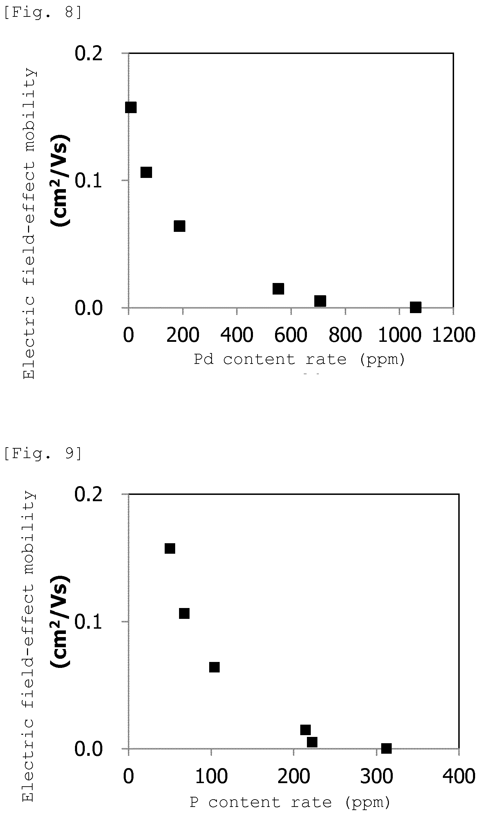

Fig. 8 is a graph showing dependency of mobility measured using the organic thin film transistor of Examples 7 to 9 and Comparative Examples 6 to 8 on the amount of Pd contained in a polymer compound.
Fig. 9 is a graph showing dependency of mobility measured using the organic thin film transistor of Examples 7 to 9 and Comparative Examples 6 to 8 on the amount of P contained in a polymer compound.

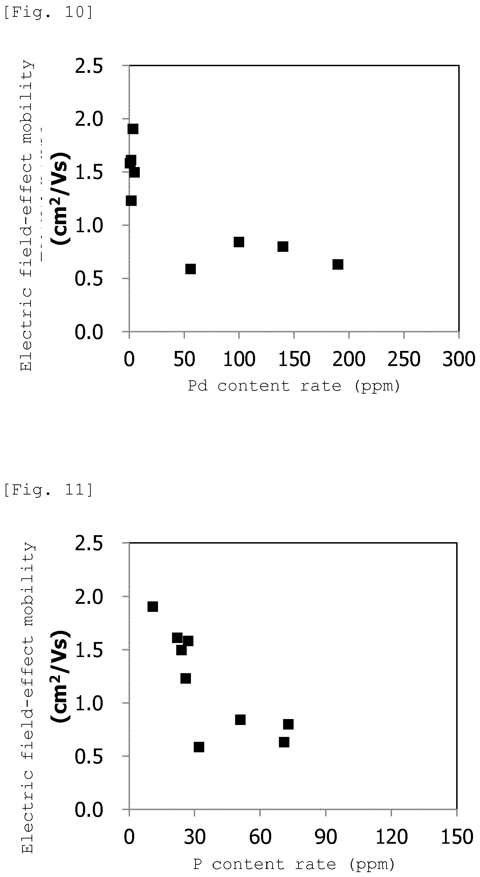

Fig. 10 is a graph showing dependency of mobility measured using the organic thin film transistor of Examples 10 to 14 and Comparative Examples 9 to 12 on the amount of Pd contained in a polymer compound.
Fig. 11 is a graph showing dependency of mobility measured using the organic thin film transistor of Examples 10 to 14 and Comparative Examples 9 to 12 on the amount of P contained in a polymer compound.

### Modes for Carrying Out the Invention

Preferred embodiments of the present invention will be described in detail below with reference to the drawings as necessary. In the description of the drawings, the same elements are denoted by the same numeral references, and duplicate descriptions are omitted.

### <Explanation of common terms>

The terms commonly used in the present specification have the following meanings unless otherwise stated.

### (Pd and P)

Pd and P represent a palladium atom and a phosphorus atom, respectively.

The compound containing Pd denotes a compound containing Pd and not containing P, and the compound containing P denotes a compound containing P and not containing Pd.

### (Number of carbon atoms)

The number of carbon atoms does not include the number of carbon atoms of a substituent.

### (Hetero ring)

The hetero ring has a number of carbon atoms of 2 to 30, preferably 2 to 14, more preferably 3 to 10.

The hetero ring includes, for example, a furan ring, a thiophene ring, a selenophene ring, a pyrrole ring, an oxazole ring, a thiazole ring, an imidazole ring, a pyridine ring, a benzofuran ring, a benzothiophene ring, a thienothiophene ring and a 2,1,3-benzothiadiazole ring.

### (Aromatic hydrocarbon ring)

The aromatic hydrocarbon ring has a number of carbon atoms of 6 to 30, preferably 6 to 24, more preferably 6 to 18.

The aromatic hydrocarbon ring includes, for example, a benzene ring, a naphthalene ring, an anthracene ring, a pyrene ring and a fluorene ring.

### (Alkyl group)

The alkyl group may be any of a linear alkyl group or a branched alkyl group.

The number of carbon atoms which the linear alkyl group has is usually 1 to 30, preferably 1 to 20. The number of carbon atoms which the branched alkyl group has is usually 3 to 30, preferably 3 to 20.

The linear alkyl group includes, for example, a methyl group, an ethyl group, a n-propyl group, a n-butyl group, a n-hexyl group, a n-octyl group, a n-dodecyl group, a n-hexadecyl group and the like. The branched alkyl group includes, for example, an isopropyl group, an isobutyl group, a sec-butyl group, a tert-butyl group, a 2-ethylhexyl group, a 3,7-dimethyloctyl group and the like.

### (Cycloalkyl group)

The number of carbon atoms which the cycloalkyl group has is usually 3 to 30, preferably 3 to 20.

The cycloalkyl group includes, for example, a cyclopentyl group, a cyclohexyl group and the like.

### (Alkoxy group)

The alkoxy group may be any of a linear alkoxy group or a branched alkoxy group.

The number of carbon atoms which the linear alkoxy group has is usually 1 to 30, preferably 1 to 20. The number of carbon atoms which the branched alkoxy group has is usually 3 to 30, preferably 3 to 20.

The linear alkoxy group includes, for example, a methoxy group, an ethoxy group, a n-propyloxy group, a n-butyloxy group, a n-hexyloxy group, a n-octyloxy group, a n-dodecyloxy group, a n-hexadecyloxy group and the like, and the branched alkoxy group includes an isopropyloxy group, an isobutyloxy group, a sec-butyloxy group, a tert-butyloxy group, a 2-ethylhexyloxy group, a 3,7-dimethyloctyloxy group and the like.

### (Cycloalkoxy group)

The number of carbon atoms which the cycloalkoxy group has is usually 3 to 30, preferably 3 to 20.

The cycloalkoxy group includes, for example, a cyclopentyloxy group and a cyclohexyloxy group.

### (Alkylthio group)

The alkylthio group may be any of a linear alkylthio group or a branched alkylthio group.

The number of carbon atoms which the linear alkylthio group has is usually 1 to 30, preferably 1 to 20. The number of carbon atoms which the branched alkylthio group has is usually 3 to 30, preferably 3 to 20.

The linear alkylthio group includes, for example, a methylthio group, an ethylthio group, a n-propylthio group, a n-butylthio group, a n-hexylthio group, a n-octylthio group, a n-dodecylthio group, a n-hexadecylthio group and the like. The branched alkylthio group includes an isopropylthio group, an isobutylthio group, a sec-butylthio group, a tert-butylthio group, a 2-ethylhexylthio group, a 3,7-dimethyloctylthio group and the like.

### (Cycloalkylthio group)

The number of carbon atoms which the cycloalkylthio group has is usually 3 to 30, preferably 3 to 20.

The cycloalkylthio group includes, for example, a cyclopentylthio group and a cyclohexylthio group.

### (Aryl group)

The aryl group is an atomic group remaining after removing from an aromatic hydrocarbon one hydrogen atom bonding directly to a carbon atom constituting the ring, and includes groups having a condensed ring and groups in which two or more rings selected from the group consisting of a benzene ring and a condensed ring are bonded directly.

The number of carbon atoms which the aryl group has is usually 6 to 30, preferably 6 to 20.

The aryl group includes, for example, a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group and a 4-phenylphenyl group.

### (Monovalent hetero ring group)

The monovalent hetero ring group is an atomic group remaining after removing from a heterocyclic compound one hydrogen atom bonding directly to a carbon atom or a hetero atom constituting the ring, and includes groups having a condensed ring and groups in which two or more rings selected from the group consisting of a hetero ring and a condensed ring are bonded directly.

The number of carbon atoms which the monovalent hetero ring group has is usually 2 to 30, preferably 3 to 20.

The monovalent hetero ring group includes, for example, a 2-furyl group, a 3-furyl group, a 2-thienyl group, a 3-thienyl group, a 2-pyrrolyl group, a 3-pyrrolyl group, a 2-oxazolyl group, a 2-thiazolyl group, a 2-imidazolyl group, a 2-pyridyl group, a 3-pyridyl group, a 4-pyridyl group, a 2-benzofuryl group, a 2-benzothienyl group, a 2-thienothienyl group and a 4-(2,1,3-benzothiadiazolyl) group.

### (Halogen atom)

The halogen atom denotes a fluorine atom, a chlorine atom, a bromine atom or an iodine atom.

### (Group represented by -Si(R')₃)

The group represented by -Si(R')₃ (three R' each independently represent a hydrogen atom, an alkyl group having a number of carbon atoms of 1 to 30, a cycloalkyl group having a number of carbon atoms of 3 to 30 or a monovalent hetero ring group having a number of carbon atoms of 2 to 30 optionally having an alkyl group.) includes, for example, a trimethylsilyl group, a triethylsilyl group, a triisopropylsilyl group, a tertbutyldimethylsilyl group, a phenylsilyl group and a triphenylsilyl group.

### (Group represented by -N(R')₂)

The group represented by -N(R')₂ (two R' represent the same meaning as described above.) includes, for example, a dimethylamino group, a diethylamino group, a diisopropylamino group and a diphenylamino group.

### (Alkenyl group)

The alkenyl group may be any of a linear alkenyl group or a branched alkenyl group.

The number of carbon atoms which the linear alkenyl group has is usually 2 to 30, preferably 2 to 20. The number of carbon atoms which the branched alkenyl group has is usually 3 to 30, preferably 3 to 20.

The alkenyl group includes, for example, a vinyl group, a 1-propenyl group, a 2-propenyl group, a 1-hexenyl group, a 1-dodecenyl group and a 1-hexadecenyl group.

### (Cycloalkenyl group)

The number of carbon atoms which the cycloalkenyl group has is usually 3 to 30, preferably 3 to 20.

The cycloalkenyl group includes, for example, a 1-cyclohexenyl group.

### (Alkynyl group)

The alkynyl group may be any of a linear alkynyl group or a branched alkynyl group.

The number of carbon atoms which the linear alkynyl group has is usually 2 to 30, preferably 2 to 20. The number of carbon atoms which the branched alkynyl group has is usually 4 to 30, preferably 4 to 20.

The alkynyl group includes, for example, an ethynyl group, 1-propynyl group, 1-hexynyl group, 1-dodecynyl group and 1-hexadecynyl group.

### (Cycloalkynyl group)

The number of carbon atoms which the cycloalkynyl group has is usually 3 to 30, preferably 3 to 20.

### (Alkylcarbonyl group)

The alkylcarbonyl group may be any of a linear alkylcarbonyl group or a branched alkylcarbonyl group.

For example, groups obtained by bonding the above-described alkyl groups and a carbonyl group are mentioned.

The linear alkylcarbonyl group includes, for example, an acetyl group, a n-propanoyl group, a n-butanoyl group, a n-hexanoyl group, a n-octanoyl group, a n-dodecanoyl group, a n-hexadecanoyl group and the like. The branched alkylcarbonyl group includes, for example, an isobutanoyl group, a sec-butanoyl group, a tert-butanoyl group, a 2-ethylhexanoyl group and the like.

### (Cycloalkylcarbonyl group)

For example, groups obtained by bonding the above-described cycloalkyl groups and a carbonyl group are mentioned.

The cycloalkylcarbonyl group includes, for example, a cyclopentylcarbonyl group and a cyclohexylcarbonyl group.

### (Alkoxycarbonyl group)

The alkoxycarbonyl group may be any of a linear alkoxycarbonyl group or a branched alkoxycarbonyl group.

As the alkoxycarbonyl group, for example, groups obtained by bonding the above-described alkoxy groups and a carbonyl group are mentioned.

The linear alkoxycarbonyl group includes, for example, a methoxycarbonyl group, an ethoxycarbonyl group, a n-propyloxycarbonyl group, a n-butoxycarbonyl group, a n-hexyloxycarbonyl group, a n-octyloxycarbonyl group, a n-dodecyloxycarbonyl group, a n-hexadecyloxycarbonyl group and the like. The branched alkoxycarbonyl group includes, for example, an isopropyloxycarbonyl group, an isobutyloxycarbonyl group, a sec-butyloxycarbonyl group, a tert-butyloxycarbonyl group, a 2-ethylhexyloxycarbonyl group and the like.

### (Cycloalkoxycarbonyl group)

As the cycloalkoxycarbonyl group, for example, groups obtained by bonding the above-described cycloalkoxy groups and a carbonyl group are mentioned.

The cycloalkoxycarbonyl group includes, for example, a cyclopentyloxycarbonyl group and a cyclohexyloxycarbonyl group.

### (Arylene group)

The arylene group is an atomic group remaining after removing from an aromatic hydrocarbon two hydrogen atoms bonding directly to carbon atoms constituting the ring, and includes groups having a condensed ring, groups in which two or more rings selected from the group consisting of a benzene ring and a condensed ring are bonded directly and groups in which two or more rings selected from the group consisting of a benzene ring and a condensed ring are bonded via vinylene or the like. The number of carbon atoms which the arylene group has is usually 6 to 60, preferably 6 to 20.

### (Divalent hetero ring group)

The divalent hetero ring group is an atomic group remaining after removing from a heterocyclic compound two hydrogen atoms bonding directly to carbon atoms or hetero atoms constituting the ring, and includes groups having a condensed ring and groups in which two or more rings selected from the group consisting of a hetero ring and a condensed ring are bonded directly. The number of carbon atoms which the divalent hetero ring group has is usually 2 to 30, preferably 3 to 20.

### <Composition>

The composition according to the present invention is
a composition comprising a polymer compound containing a structural unit represented by the formula (1) and at least one compound selected from the group consisting of a compound containing Pd, a compound containing P and a compound containing Pd and P, wherein the content rate of the polymer compound is 95% by mass or more, the content rate of Pd is 50 ppm by mass or less and the content rate of P is 60 ppm by mass or less.

The composition according to the present invention may also be
a composition comprising a polymer compound containing a structural unit represented by the formula (1) and at least one compound selected from the group consisting of a compound containing Pd, a compound containing P and a compound containing Pd and P, wherein the content rate of the polymer compound is 95% by mass or more, the content rate of Pd is 50 ppm by mass or less and the content rate of P is 30 ppm by mass or less. In addition, when moderate impurities are present, the polymer compound containing a structural unit represented by the formula (1) is inhibited to form an ordered structure, tending to increase the amorphous property, so the total content rate of Pd and P is preferably 0.01 ppm by mass or more, more preferably 0.1 ppm by mass or more.

### <Polymer compound>

### (First structural unit)

The polymer compound which the composition of the present invention comprises contains a structural unit represented by the formula (1) (hereinafter, referred to as "first structural unit" in some cases). The first structural unit may be contained only singly or in combination of two or more in the polymer compound. The polymer compound is preferably a conjugated polymer compound. 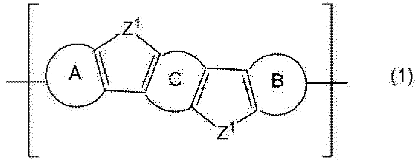 [wherein,
the ring A and the ring B each independently represent a hetero ring having a number of carbon atoms of 2 to 30 optionally having a substituent.

The ring C represents an aromatic hydrocarbon ring having a number of carbon atoms of 6 to 30 optionally having a substituent or a hetero ring having a number of carbon atoms of 2 to 30 optionally having a substituent. The substituent which these groups optionally have is selected from the following Group 1.

Z¹ represents a group represented by the formula (Z-1), a group represented by the formula (Z-2), a group represented by the formula (Z-3), a group represented by the formula (Z-4) or a group represented by the formula (Z-5). A plurality of Z¹ may be mutually the same or different.

Group 1: an alkyl group having a number of carbon atoms of 1 to 30, a cycloalkyl group having a number of carbon atoms of 3 to 30, an alkoxy group having a number of carbon atoms of 1 to 30, a cycloalkoxy group having a number of carbon atoms of 3 to 30, an alkylthio group having a number of carbon atoms of 1 to 30, a cycloalkylthio group having a number of carbon atoms of 3 to 30, an aryl group having a number of carbon atoms of 6 to 30, a monovalent hetero ring group having a number of carbon atoms of 2 to 30, a halogen atom, a group represented by -Si(R')₃ (three R' each independently represent a hydrogen atom, an alkyl group having a number of carbon atoms of 1 to 30, a cycloalkyl group having a number of carbon atoms of 3 to 30 or a monovalent hetero ring group having a number of carbon atoms of 2 to 30 optionally having an alkyl group.), a group represented by -N(R')₂ (two R' represent the same meaning as described above.), an alkenyl group having a number of carbon atoms of 2 to 30, a cycloalkenyl group having a number of carbon atoms of 3 to 30, an alkynyl group having a number of carbon atoms of 2 to 30, a cycloalkynyl group having a number of carbon atoms of 3 to 30, a hydroxy group, a nitro group, a cyano group, a carboxy group, an alkylcarbonyl group having a number of carbon atoms of 2 to 30, a cycloalkylcarbonyl group having a number of carbon atoms of 4 to 30, an alkoxycarbonyl group having a number of carbon atoms of 2 to 30 and a cycloalkoxycarbonyl group having a number of carbon atoms of 4 to 30.]. 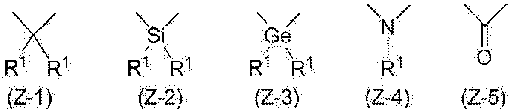 [wherein,
R¹ represents an alkyl group having a number of carbon atoms of 1 to 30 optionally having a substituent, a cycloalkyl group having a number of carbon atoms of 3 to 30 optionally having a substituent, an alkoxy group having a number of carbon atoms of 1 to 30 optionally having a substituent, a cycloalkoxy group having a number of carbon atoms of 3 to 30 optionally having a substituent, an alkylthio group having a number of carbon atoms of 1 to 30 optionally having a substituent, a cycloalkylthio group having a number of carbon atoms of 3 to 30 optionally having a substituent, an aryl group having a number of carbon atoms of 6 to 30 optionally having a substituent or a monovalent hetero ring group having a number of carbon atoms of 2 to 30 optionally having a substituent. When a plurality of R¹ are present, they may be the same or different.].

The substituent which the alkyl group represented R¹ optionally has includes, for example, an alkoxy group, a cycloalkoxy group, an aryl group and a halogen atom.

The substituent which the alkoxy group represented R¹ optionally has includes, for example, an alkyl group, an aryl group and a halogen atom.

The substituent which the alkylthio group represented R¹ optionally has includes, for example, an alkyl group, a cycloalkyl group, an alkoxy group, a cycloalkoxy group, an aryl group and a halogen atom.

The substituent which the aryl group represented R¹ optionally has includes, for example, an alkyl group, a cycloalkyl group, an alkoxy group, a cycloalkoxy group, an alkylthio group, a cycloalkylthio group, a monovalent hetero ring group and a halogen atom. The aryl group having a substituent includes, for example, a 4-hexadecylphenyl group, a 3,5-dimethoxyphenyl group and a pentafluorophenyl group. When the aryl group has a substituent, the substituent is preferably an alkyl group.

The substituent which the hetero ring group represented R¹ optionally has includes, for example, an alkyl group, a cycloalkyl group, an alkoxy group, a cycloalkoxy group, an alkylthio group, a cycloalkylthio group, an aryl group and a halogen atom. The monovalent hetero ring group having a substituent includes, for example, a 5-octyl-2-thienyl group and a 5-phenyl-2-furyl group. When the monovalent hetero ring group has a substituent, the substituent is preferably an alkyl group.

### (Regarding ring A and ring B)

It is preferable that the ring A and the ring B are the same hetero ring in the formula (1), since synthesis of the polymer compound of the present invention is easy.

It is preferable that the ring A and the ring B are each independently constituted of a 5-membered and/or 6-membered hetero ring optionally having a substituent and it is more preferable that the ring A and the ring B are each independently a hetero ring having a number of carbon atoms of 3 to 10 constituted of a 5-membered and/or 6-membered hetero ring optionally having a substituent, since the electric field-effect mobility of an organic thin film transistor produced using the composition of the present invention is more excellent.

Examples of such a hetero ring include a 5-membered hetero ring optionally having a substituent, a 6-membered hetero ring optionally having a substituent, a hetero ring constituted by condensation of two or more 5-membered hetero rings optionally having a substituent, a hetero ring constituted by condensation of two or more 6-membered hetero rings optionally having a substituent, and a hetero ring constituted by condensation of at least one 5-membered hetero ring optionally having a substituent and at least one 6-membered hetero ring optionally having a substituent. The 5-membered hetero ring optionally having a substituent referred to herein is preferably a thiophene ring optionally having a substituent.

From the standpoint of more improvement of the electric field-effect mobility of an organic thin film transistor produced using the composition of the present invention, it is further preferable that the ring A and the ring B are constituted only of a 5-membered hetero ring optionally having a substituent, and in order not to lower the solubility, it is particularly preferable that the ring A and the ring B are each a thiophene ring optionally having a substituent or a thienothiophene ring optionally having a substituent.

### (Regarding ring C)

In the formula (1), the ring C is preferably an aromatic hydrocarbon ring or a hetero ring, more preferably a benzene ring optionally having a substituent, a naphthalene ring optionally having a substituent, a benzodithiophene ring optionally having a substituent, a benzothiophene ring optionally having a substituent or a thienothiophene ring, particularly preferably a benzene ring optionally having a substituent, a naphthalene ring optionally having a substituent or a benzothiophene ring optionally having a substituent, since the electric field-effect mobility of an organic thin film transistor produced using the composition of the present invention is more excellent.

The ring C preferably has an alkyl group having a number of carbon atoms of 1 to 30, a cycloalkyl group having a number of carbon atoms of 3 to 30, an alkoxy group having a number of carbon atoms of 1 to 30, a cycloalkoxy group having a number of carbon atoms of 3 to 30, an alkylthio group having a number of carbon atoms of 1 to 30, a cycloalkylthio group having a number of carbon atoms of 3 to 30, a group represented by -N(R')₂ (two R' represent the same meaning as described above.) or a hydroxy group, more preferably has an alkyl group having a number of carbon atoms of 1 to 30, a cycloalkyl group having a number of carbon atoms of 3 to 30, an alkoxy group having a number of carbon atoms of 1 to 30 or a cycloalkoxy group having a number of carbon atoms of 3 to 30, further preferably has an alkoxy group having a number of carbon atoms of 1 to 30 or a cycloalkoxy group having a number of carbon atoms of 3 to 30, as the substituent.

### (Regarding Z¹)

In the formula (1), a plurality of Z¹ are preferably the same group, since synthesis of the polymer compound of the present invention is easy.

Z¹ is preferably a group represented by the formula (Z-1) or the formula (Z-2), more preferably a group represented by the formula (Z-1), since the electric field-effect mobility of an organic thin film transistor produced using the composition of the present invention is more excellent.

In the formula (Z-1) to the formula (Z-5), R¹ is preferably an alkyl group having a number of carbon atoms of 1 to 30, a cycloalkyl group having a number of carbon atoms of 3 to 30 or an aryl group having a number of carbon atoms of 6 to 30, from the standpoint of more improvement of the electric field-effect mobility of an organic thin film transistor produced using the composition of the present invention.

The structural unit represented by the formula (1) is preferably a structural unit represented by the formula (1-1), a structural unit represented by the formula (1-2) or a structural unit represented by the formula (1-3), more preferably a structural unit represented by the formula (1-1), from the standpoint of more improvement of the electric field-effect mobility of an organic thin film transistor produced using the composition of the present invention. 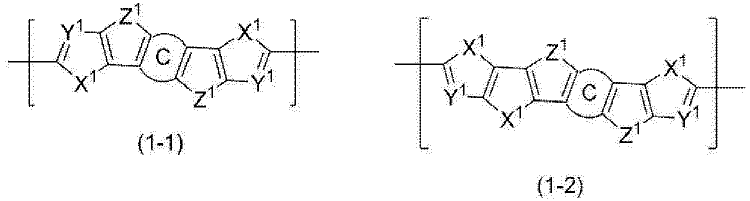 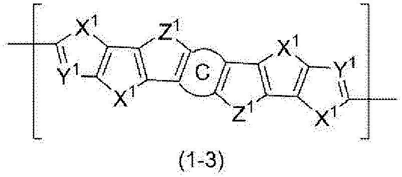 [wherein,
the ring C and Z¹ represent the same meaning as described above.
X¹ represents an oxygen atom, a sulfur atom or a selenium atom. A plurality of X¹ may be mutually the same or different.
Y¹ represents a nitrogen atom or a group represented by -CR²= (R² represents a hydrogen atom, an alkyl group having a number of carbon atoms of 1 to 30 optionally having a substituent, a cycloalkyl group having a number of carbon atoms of 3 to 30 optionally having a substituent, an alkoxy group having a number of carbon atoms of 1 to 30 optionally having a substituent, a cycloalkoxy group having a number of carbon atoms of 3 to 30 optionally having a substituent, an alkylthio group having a number of carbon atoms of 1 to 30 optionally having a substituent, a cycloalkylthio group having a number of carbon atoms of 3 to 30 optionally having a substituent, an aryl group having a number of carbon atoms of 6 to 30 optionally having a substituent, a monovalent hetero ring group having a number of carbon atoms of 2 to 30 optionally having a substituent or a halogen atom.). A plurality of Y¹ may be mutually the same or different.].

The substituent which the alkyl group represented R² optionally has includes the same examples as for the substituent which the alkyl group represented by R¹ optionally has.

The substituent which the alkoxy group represented R² optionally has includes the same examples as for the substituent which the alkoxy group represented by R¹ optionally has.

The substituent which the alkylthio group represented R² optionally has includes the same examples as for the substituent which the alkylthio group represented by R¹ optionally has.

The substituent which the aryl group represented R² optionally has includes the same examples as for the substituent which the aryl group represented by R¹ optionally has.

The substituent which the hetero ring group represented R² optionally has includes the same examples as for the substituent which the hetero ring group represented by R¹ optionally has.

X¹ is preferably a sulfur atom, from the standpoint of more improvement of the electric field-effect mobility of an organic thin film transistor produced using the composition of the present invention.

Y¹ is preferably a group represented by -CR²= and R² is preferably a hydrogen atom, an alkyl group having a number of carbon atoms of 1 to 30 optionally having a substituent, a cycloalkyl group having a number of carbon atoms of 3 to 30 optionally having a substituent, an alkoxy group having a number of carbon atoms of 1 to 30 optionally having a substituent, a cycloalkoxy group having a number of carbon atoms of 3 to 30 optionally having a substituent or a halogen atom, more preferably a hydrogen atom, an alkyl group having a number of carbon atoms of 1 to 30 optionally having a substituent, a cycloalkyl group having a number of carbon atoms of 3 to 30 optionally having a substituent or a halogen atom, further preferably a hydrogen atom, since synthesis of the polymer compound containing a structural unit represented by the formula (1) is easy.

The structural unit represented by the formula (1) (may also be a structural unit represented by the formula (1-1) to the formula (1-3)) includes, for example, structural units represented by the formula (1-11-1) to the formula (1-11-11), the formula (1-12-1) to the formula (1-12-10) and the formula (1-13-1) to the formula (1-13-10).

From the standpoint of more improvement of the electric field-effect mobility of an organic thin film transistor produced using the composition of the present invention, the structural unit represented by the formula (1) is preferably a structural unit represented by the formula (1-11-1), the formula (1-11-2), the formula (1-11-3), the formula (1-11-11), the formula (1-12-1), the formula (1-12-3), the formula (1-12-5), the formula (1-13-1), the formula (1-13-3) or the formula (1-13-5), more preferably a structural unit represented by the formula (1-11-1), the formula (1-11-2), the formula (1-11-3), the formula (1-11-11), the formula (1-12-1), the formula (1-12-3), the formula (1-13-1) or the formula (1-13-3), further preferably a structural unit represented by the formula (1-11-1), the formula (1-11-2), the formula (1-11-3) or the formula (1-11-11).

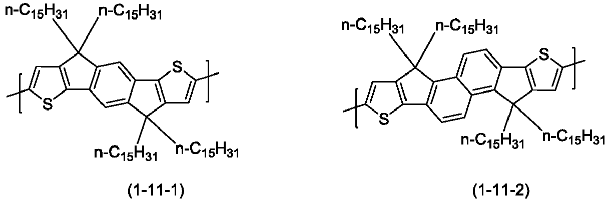

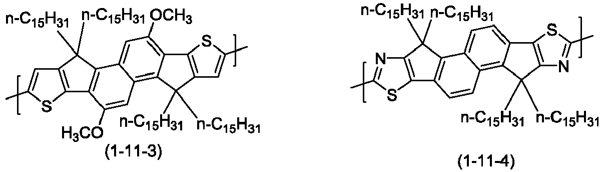

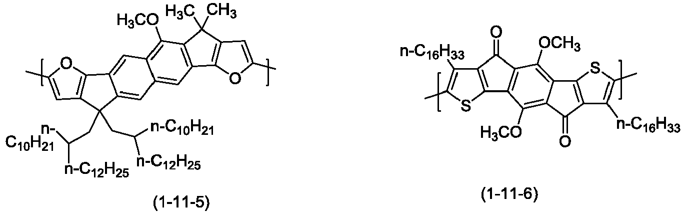

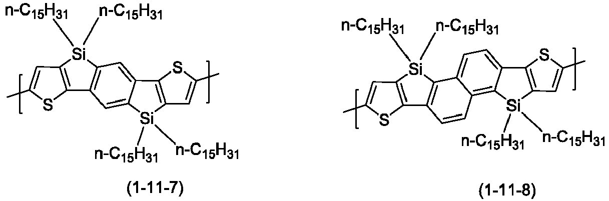

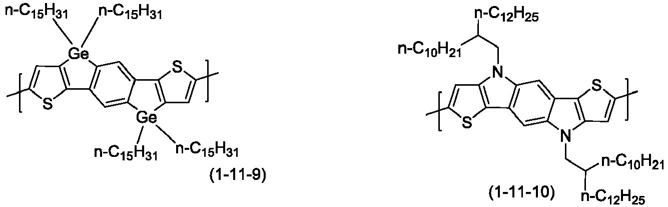

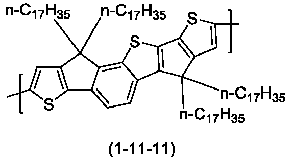

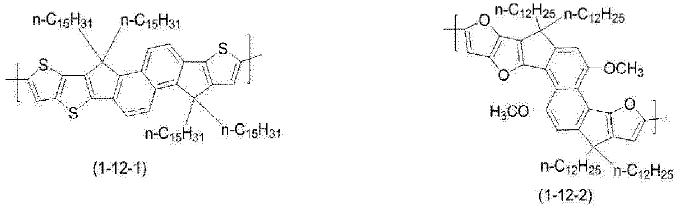

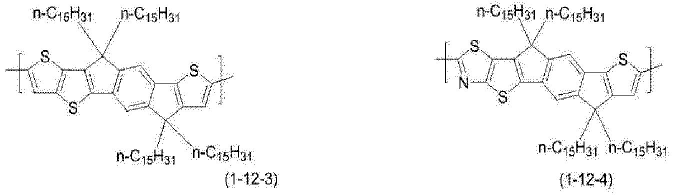

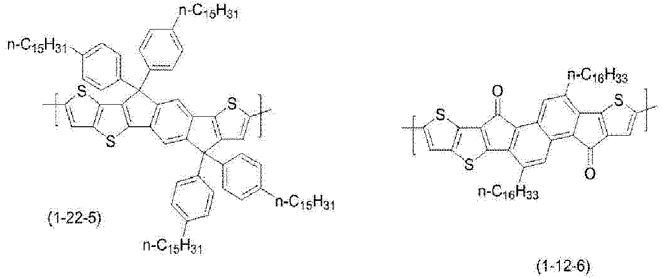

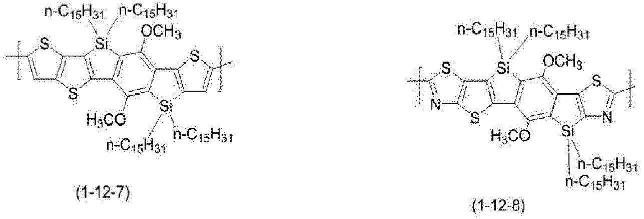

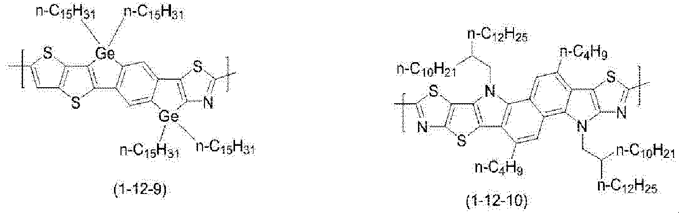

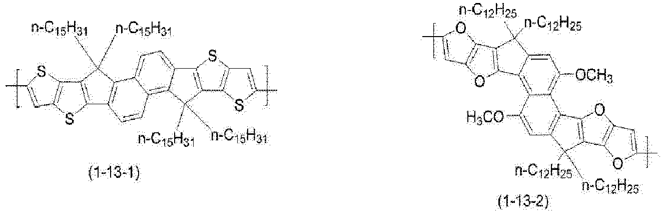

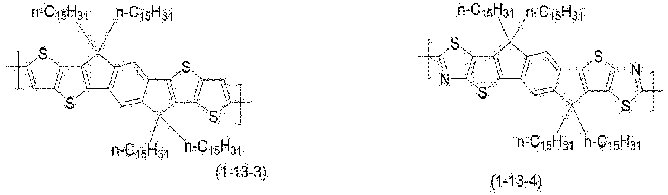

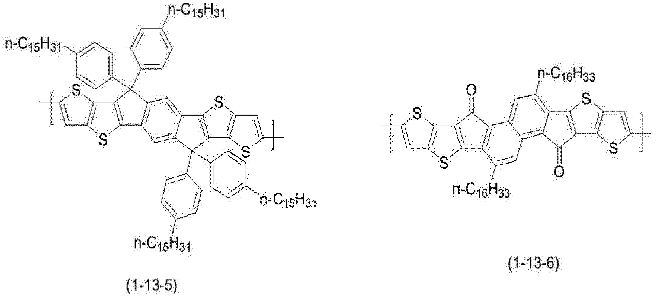

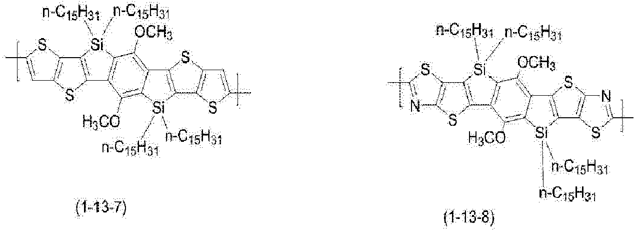

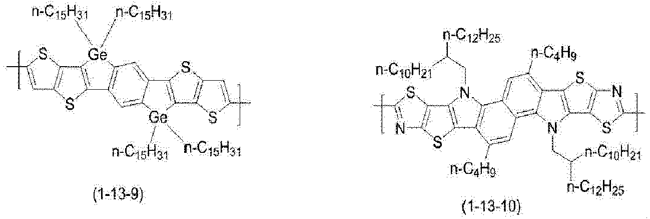

### (Second structural unit)

It is preferable that the polymer compound containing a structural unit represented by the formula (1) further contains a structural unit represented by the formula (2) (different from the structural unit represented by the above-described formula (1)) (hereinafter, referred to as "second structural unit" in some cases), in addition to the structural unit represented by the formula (1).

⁅Ar⁆ (2)

[wherein, Ar represents an arylene group having a number of carbon atoms of 6 to 60 optionally having a substituent or a divalent hetero ring group having a number of carbon atoms of 2 to 30 optionally having a substituent. The substituent which these groups optionally have is selected from the following Group 2. However, the structural unit represented by the formula (2) is different from the structural unit represented by the formula (1).

Group 2: an alkyl group having a number of carbon atoms of 1 to 30, a cycloalkyl group having a number of carbon atoms of 3 to 30, an alkoxy group having a number of carbon atoms of 1 to 30, a cycloalkoxy group having a number of carbon atoms of 3 to 30, an alkylthio group having a number of carbon atoms of 1 to 30, a cycloalkylthio group having a number of carbon atoms of 3 to 30, a monovalent aryl group having a number of carbon atoms of 6 to 30, a monovalent hetero ring group having a number of carbon atoms of 2 to 30 and a halogen atom.].

When the polymer compound of the present invention contains the second structural unit, it is preferable that the structural unit represented by the formula (1) (may also be a structural unit represented by the formula (1-1) to the formula (1-3)) and the structural unit represented by the formula (2) for a conjugate.

In the present specification, conjugation denotes a state in which unsaturated bonds and single bonds are alternately continued in the structure of a molecule, and the bonding electrons are present without localization. The term "unsaturated bond" as used herein refers to a double bond or a triple bond.

The arylene group represented by Ar includes, for example, arylene groups represented by the following formulae 1 to 12. 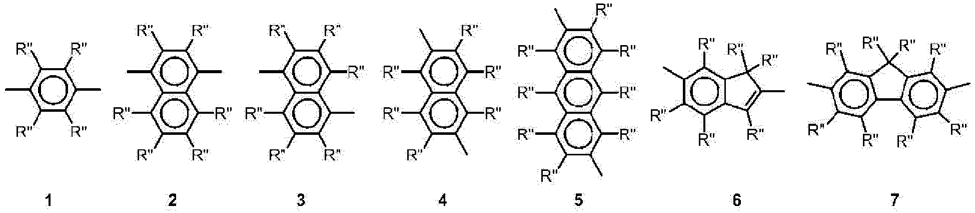 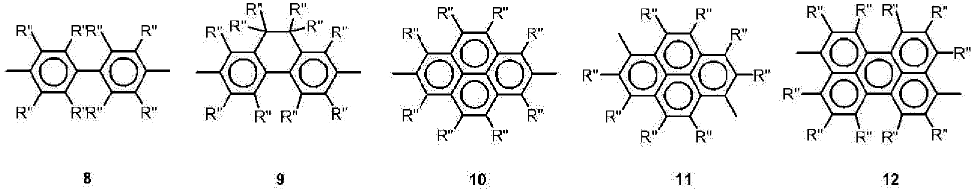 [in the formulae 1 to 12,
R" represents a hydrogen atom, an alkyl group having a number of carbon atoms of 1 to 30, a cycloalkyl group having a number of carbon atoms of 3 to 30, an alkoxy group having a number of carbon atoms of 1 to 30, a cycloalkoxy group having a number of carbon atoms of 3 to 30, an alkylthio group having a number of carbon atoms of 1 to 30, a cycloalkylthio group having a number of carbon atoms of 3 to 30, an aryl group having a number of carbon atoms of 6 to 30, a monovalent hetero ring group having a number of carbon atoms of 2 to 30 or a halogen atom. A plurality of R" may be the same or different.].

The divalent hetero ring group represented by Ar is preferably a divalent aromatic hetero ring group.

The divalent hetero ring group represented by Ar includes, for example, divalent hetero ring groups represented by the following formulae 13 to 65. 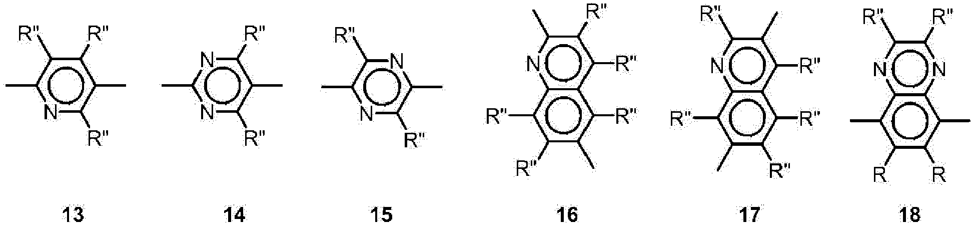 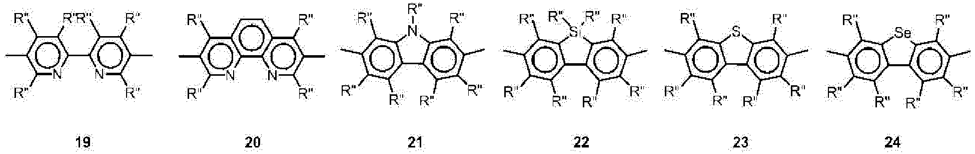 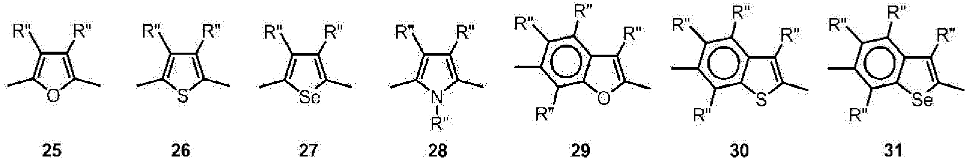 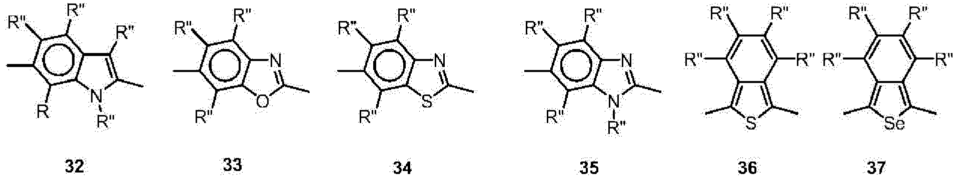 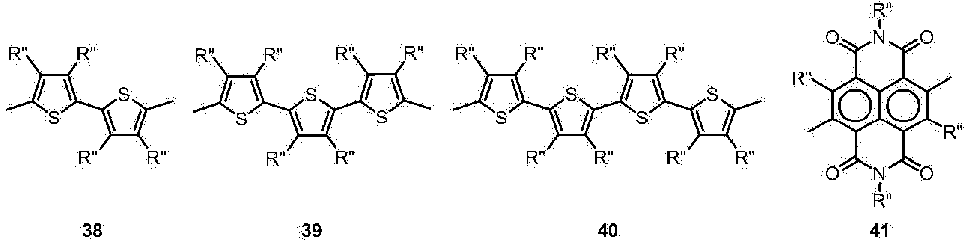 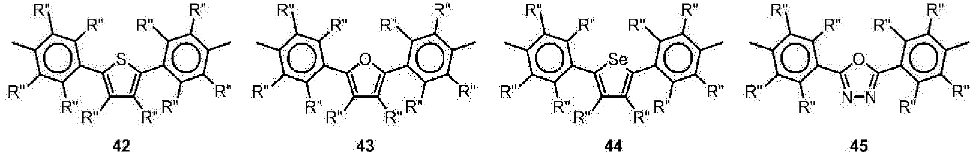 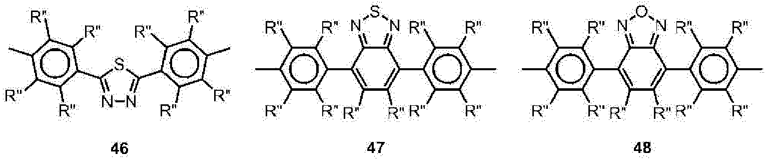 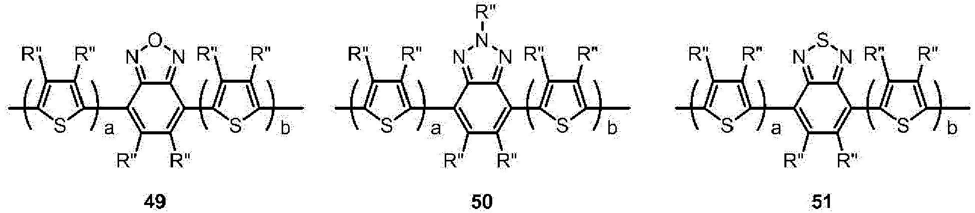 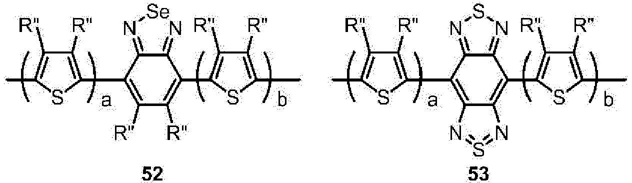 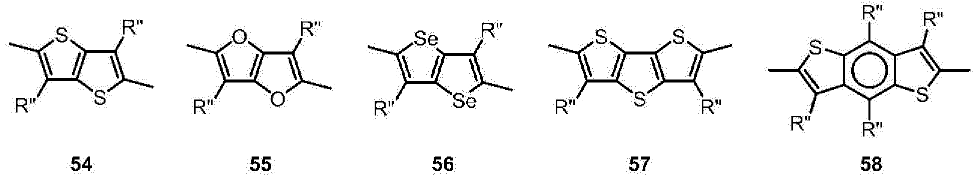 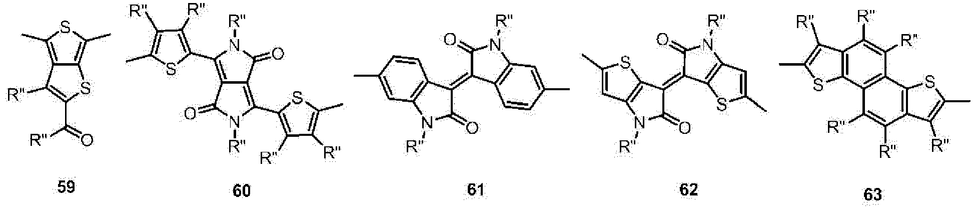 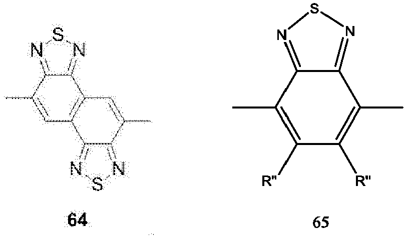 [in the formulae 13 to 65, R" represents the same meaning as described above. a and b each independently represent the number of repetition and usually an integer of 0 to 5, preferably an integer of 0 to 3, more preferably an integer of 0 to 1.].

From the standpoint of more improvement of the electric field-effect mobility of an organic thin film transistor produced using the composition of the present invention, the second structural unit is preferably a divalent hetero ring group, more preferably a divalent hetero ring group represented by the formula 49 to the formula 54, the formula 59 to the formula 62 or the formula 64, further preferably a divalent hetero ring group represented by the formula 51, the formula 54 or the formula 64, particularly preferably a divalent hetero ring group represented by the formula 65 (the formula 65 denotes a case in which a = b = 0 in the formula 51).

The polystyrene-equivalent number-average molecular weight (Mn) measured by gel permeation chromatography (hereinafter, referred to as "GPC") of the polymer compound containing a structural unit represented by the formula (1) is usually 1×10³ to 1×10⁷. From the standpoint of forming a good film, the number-average molecular weight is preferably 3×10³ or more. From the standpoint of enhancing solubility in a solvent and facilitating film formation, the number-average molecular weight is preferably 1×10⁶ or less.

Moreover, the polymer compound containing a structural unit represented by the formula (1) is which having high solubility in a solvent (preferably, organic solvent), and specifically, it preferably has solubility by which a solution containing the polymer compound containing a structural unit represented by the formula (1) in an amount of 0.1% by mass (hereinafter, referred to as "wt%" in some cases) or more can be prepared, more preferably has solubility by which a solution containing the polymer compound in an amount of 0.4% by mass or more can be prepared.

Regarding the content of a structural unit represented by the formula (1) in the polymer compound of the present invention, at least one structural unit represented by the formula (1) may be contained in the polymer compound, three or more structural units represented by the formula (1) are preferably contained in the polymer compound, and five or more structural units represented by the formula (1) are more preferably contained in the polymer compound.

The content of structural units represented by the formula (1) is usually 25 to 100 mol% with respect to all constitutional units contained in the polymer compound.

The polymer compound of the present invention may be any kind of copolymer, and may be any of, for example, a block copolymer, a random copolymer, an alternate copolymer or a graft copolymer. From the standpoint of more improvement of the electric field-effect mobility of an organic thin film transistor produced using the composition of the present invention, the polymer compound of the present invention is preferably a copolymer of a structural unit represented by the formula (1) and a structural unit represented by the formula (2), more preferably an alternate copolymer of a structural unit represented by the formula (1) and a structural unit represented by the formula (2).

When the polymer compound of the present invention contains a structural unit represented by the formula (2), the content of the structural unit represented by the formula (2) is usually in a range of over 0 mol and 2 mol or less with respect to 1 mol of a structural unit represented by the formula (1).

When a group which is active for the polymerization reaction remains at the molecular chain end in the polymer compound, there is a possibility of decrease of the electric field-effect mobility of an organic thin film transistor produced using the polymer compound of the present invention. Hence, it is preferable that the molecular chain end is a stable group such as an aryl group, a monovalent aromatic hetero ring group or the like.

### (Regarding compound containing Pd, compound containing P and compound containing Pd and P)

The composition of the present invention contains at least one compound selected from the group consisting of a compound containing Pd, a compound containing P and a compound containing Pd and P, depending on equipment and compounds used for synthesis, the atmosphere and the like.

The content rate of Pd and the content rate of P contained in the composition of the present invention are 50 ppm by mass or less and 60 ppm by mass or less, respectively.

The content rate of Pd and the content rate of P contained in the composition of the present invention may also be 50 ppm by mass or less and 30 ppm by mass or less, respectively.

The total content rate of Pd and P contained in the composition of the present invention may be 60 ppm by mass or less.

The content rates of Pd and P can be adjusted in a desired range in the composition of the present invention, by appropriately adopting composition purification methods described later.

At least one compound selected from the group consisting of compounds containing Pd and P may be appropriately added to the composition obtained by purification. In the case of addition, for example, compounds listed as the base and the catalyst used in polymerizations described later may be added.

The polymer compound containing a structural unit represented by the formula (1) is an amorphous polymer, and thought to be likely to interact with at least one compound selected from the group consisting of a compound containing Pd, a compound containing P and a compound containing Pd and P, as compared with a crystalline polymer. Hence, from the standpoint of suppressing interaction, the content rate of Pd is more preferably 20 ppm by mass or less.

In addition, from the standpoint of suppressing interaction, it is more preferable that the total content rate of Pd and Pd is 60 ppm by mass or less, it is further preferable that the total content rate of Pd and P is 60 ppm by mass or less and the content rate of Pd is 20 ppm by mass or less.

In the present specification, the crystalline polymer means a polymer having a spatially ordered structure at ordinary temperature and pressure, for example, and the amorphous polymer means a polymer not having a spatially ordered structure at ordinary temperature and pressure, for example. Whether or not to have the ordered structure can be measured by a method such as, for example, X-ray diffractometry or the like.

The content rate of P and Pd contained in a composition is measured as described below.

A composition is dried and weighed. This value is taken as the mass of the composition.

The composition obtained by drying is sealed in a microwave decomposition device together with hydrochloric acid and nitric acid and decomposed. The decomposed composition is used as a sample, and the content (mass) of Pd is measured by using a graphite furnace atomic absorption apparatus. The decomposed composition is used as a sample, and the content (mass) of P is measured by using an ICP-AES apparatus.

The values (ppm by mass) of (content (mass) of P)/(mass of composition) and (content (mass) of Pd)/(mass of composition) are adopted as the content rate of P and the content rate of Pd, respectively.

Also an ink composition containing a composition and a solvent is measured by the same method. An ink composition is dried, and weighed as the composition. This value is taken as the mass of the composition.

The composition obtained by drying is sealed in a microwave decomposition device together with hydrochloric acid and nitric acid and decomposed. The decomposed composition is used as a sample, and the content of Pd is measured by using a graphite furnace atomic absorption apparatus. The decomposed composition is used as a sample, and the content (mass) of P is measured by using an ICP-AES apparatus.

The values (ppm by mass) of (content (mass) of P)/(mass of composition) and (content (mass) of Pd)/(mass of composition) are adopted as the content rate of P and the content rate of Pd, respectively.

### <Production method of composition>

The production method of the composition of the present invention will be illustrated below, but the production method of the composition of the present invention is not limited to this.

### (Polymerization of polymer compound)

A polymerization method of a polymer compound containing a structural unit represented by the formula (1) and a structural unit represented by the formula (2) will be described below.

The polymer compound may be polymerized by any method, and polymerization methods such as, for example, known aryl coupling in which a compound represented by the formula (11) and a compound represented by the formula (12) are, if necessary, dissolved in an organic solvent, and a base is added as required, and a suitable catalyst is used, and the like, are mentioned.

X²¹-A¹¹-X²² (11)

[A¹¹ represents a structural unit represented by the formula (1). X²¹ and X²² each independently represent a halogen atom, a boric acid residue, a borate residue or an organotin residue.]

X²³-A¹²-X²⁴ (12)

[A¹² represents a structural unit represented by the formula (2). X²³ and X²⁴ each independently represent a halogen atom, a boric acid residue, a borate residue or an organotin residue.]

The boric acid residue represented by X²¹, X²², X²³ or X²⁴ denotes a group represented by -B(OH)₂.

The borate residue represented by X²¹, X²², X²³ or X²⁴ includes, for example, groups represented by the following formulae.

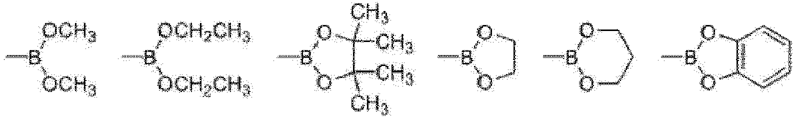

The organotin residue represented by X²¹, X²², X²³ or X²⁴ denotes a group represented by -SnR^{e}₃ (R^{e} represents a hydrogen atom, an alkyl group having a number of carbon atoms of 1 to 30, a cycloalkyl group having a number of carbon atoms of 3 to 30 or an aryl group having a number of carbon atoms of 6 to 30).

The organotin residue includes a trialkylstannyl group and a tricycloalkylstannyl group, specifically, a trimethylstannyl group, a tributylstannyl group and a tricyclohexylstannyl group.

The above-described polymerization method such as aryl coupling and the like includes, for example, a method of polymerization by the Suzuki coupling reaction (Chemical Review, 1995, vol. 95, pp. 2457 to 2483) and a method of polymerization by the Stille coupling reaction (European Polymer Journal, 2005, vol. 41, pp. 2923 to 2933).

The group represented by X²¹, X²², X²³ and X²⁴ is preferably a halogen atom, a borate residue or a boric acid residue when a nickel catalyst or a palladium catalyst is used like in the Suzuki coupling reaction and the like and is preferably a bromine atom, an iodine atom or a borate residue, for simplification of the polymerization reaction.

When the polymer compound of the present invention is polymerized by the Suzuki coupling reaction, the ratio of the total number of moles of a bromine atom and an iodine atom as the above-described polymerization reactive group to the total number of moles of a borate residue as the above-described polymerization reactive group is preferably 0.7 to 1.3, more preferably 0.8 to 1.2.

The group represented by X²¹, X²², X²³ and X²⁴ is preferably a halogen atom or an organotin residue substituted with three alkyl groups when a palladium catalyst is used like in the Stille coupling reaction and the like, and is preferably a bromine atom, an iodine atom, or an organotin residue substituted with three alkyl groups or three cycloalkyl groups since the polymerization reaction is simplified.

When the polymer compound of the present invention is polymerized by the Stille coupling reaction, the ratio of the total number of moles of a bromine atom and an iodine atom as the above-described polymerization reactive group to the total number of moles of an organotin residue substituted with three alkyl groups or three cycloalkyl groups as the above-described polymerization reactive group is preferably 0.7 to 1.3, more preferably 0.8 to 1.2.

The organic solvent used in polymerization includes, for example, benzene, toluene, xylene, chlorobenzene, dichlorobenzene, tetrahydrofuran and dioxane. These organic solvents may be used singly or in combination of two or more.

The base used in polymerization includes, for example, inorganic bases such as sodium carbonate, potassium carbonate, cesium carbonate, potassium fluoride, cesium fluoride, tripotassium phosphate and the like and organic bases such as tetrabutylammonium fluoride, tetrabutylammonium chloride, tetrabutylammonium bromide, tetraethylammonium hydroxide, tetrabutylammonium hydroxide and the like.

The catalyst used in polymerization is preferably a catalyst composed of a transition metal complex such as commercially available palladium complexes and the like such as bis(tri-tert-butylphosphine)palladium, tetrakis(triphenylphosphine)palladium, tris(dibenzylideneacetone)dipalladium, palladium acetate, dichlorobistriphenylphosphinepalladium and the like and, if necessary, a commercially available ligand such as triphenylphosphine, tri-tert-butylphosphine, tricyclohexylphosphine, and the like. As these catalysts, those synthesized previously may be used, or those prepared in the reaction system may be used as they are.

These catalysts may be used singly or in combination of two or more.

The polymerization reaction temperature is preferably 0 to 200°C, more preferably 0 to 150°C, further preferably 0 to 60°C, further preferably 0 to 30°C.

The polymerization reaction time is usually 1 hour or more, preferably 2 to 500 hours.

The post treatment of polymerization can be conducted by a known method and, for example, the reaction solution obtained in the above-described polymerization is added to a lower alcohol such as methanol and the like to cause deposition of a precipitate which is then filtrated and dried.

### (Purification method of composition)

The polymer compound is usually purified since it is obtained as a composition by the above-described polymerization method.

The method of purifying a composition includes washing with a washing solution containing water, an alcohol such as methanol and the like, an acid, a base, a chelating agent, alumina, silica gel or acetone; recrystallization; continuous extraction with a Soxhlet extractor; column chromatography in which the stationary phase is silica gel, alumina or activated carbon, and the like, and these purification methods can be appropriately combined to obtain compositions having desired content rates of Pd and P, for example, a composition having a content rate of Pd of 50 ppm by mass or less and a content rate of P of 60 ppm by mass or less.

As the purification method for obtaining the composition according to the present invention, for example, a purification method in which washing with a washing solution containing a chelating agent is conducted and washing with a washing solution containing alumina is conducted and a purification method in which washing with a washing solution containing a chelating agent is conducted and purification by column chromatography using alumina as the stationary phase is conducted are preferable.

Still another purification method may be combined with these purification methods, and for example, washing with a washing solution containing water, an alcohol such as methanol and the like, a base or an acid may be used together.

The chelating agent contained in the washing solution includes sodium N,N-diethyldithiocarbamate, ethylenediamine, bipyridine, ethylenediaminetetraacetic acid, phenanthroline, porphyrin, crown ether and the like. These chelating agents may be used singly or in combination of two or more.

The acid contained in the washing solution includes acetic acid, hydrochloric acid, sulfuric acid, nitric acid, oxalic acid and the like.

These acids may be used singly or in combination of two or more.

The base contained in the washing solution includes ammonia, sodium carbonate, potassium carbonate, cesium carbonate, potassium phosphate, sodium hydroxide, potassium hydroxide and the like. These bases may be used singly or in combination of two or more.

When a composition is purified by column chromatography, it is preferable to previously mix and stir the stationary phase and a polymer solution from the standpoint of efficiently bringing it into contact with the stationary phase.

The stationary phase used in column chromatography is preferably used in an amount of 0.5 to 200 times, more preferably 1 to 100 times the amount of the polymer compound.

The solvent used in column chromatography includes, for example, aromatic hydrocarbon solvents such as benzene, toluene, xylene, chlorobenzene and dichlorobenzene, and aliphatic hydrocarbon solvents such as hexane, heptane, chloroform, dichloromethane and the like. These organic solvents may be used singly or in combination of two or more. Solvents in which the above-described polymer compound is dissolved are preferable. The solution may be heated for the solvent used in column chromatography to dissolve the polymer compound.

Additives such as a stabilizer, an antioxidant and the like may be added to the solvent used in column chromatography for preventing decomposition of the polymer compound.

### (Compound represented by the formula (11))

The compound represented by the formula (11) is preferably a compound represented by the formula (11-1), a compound represented by the formula (11-2) or a compound represented by the formula (11-3) from the standpoint of easy synthesis. 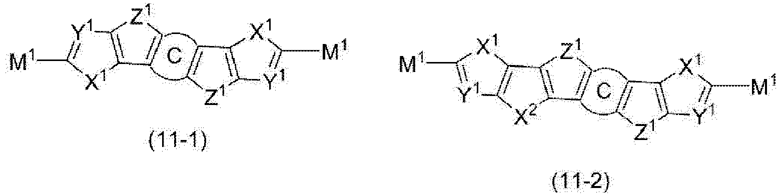 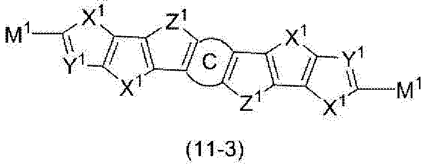 [in the formula (11-1) to the formula (11-3),
the ring C, Z¹, X¹ and Y¹ represent the same meaning as described above.

M¹ represents a halogen atom, a boric acid residue, a borate residue or an organotin residue. A plurality of M¹ may be the same or different.]

The definitions and specific examples of a halogen atom, a boric acid residue, a borate residue and an organotin residue represented by M¹ are the same as those of these groups represented by X²¹, X²², X²³ or X²⁴.

The compound represented by the formula (11) (may also be a compound represented by the formula (11-1) to the formula (11-3)) includes, for example, compounds represented by the formula (5a-11-1) to the formula (5a-11-11), the formula (5a-12-1) to the formula (5a-12-10) and the formula (5a-13-1) to the formula (5a-13-10). A compound represented by the formula (5a-11-1), the formula (5a-11-2), the formula (5a-11-3), the formula (5a-11-11), the formula (5a-12-1), the formula (5a-12-3), the formula (5a-12-5), the formula (5a-13-1), the formula (5a-13-3) or the formula (5a-13-5) is preferable, a compound represented by the formula (5a-11-1), the formula (5a-11-2), the formula (5a-11-3), the formula (5a-11-11), the formula (5a-12-1), the formula (5a-12-3), the formula (5a-13-1) or the formula (5a-13-3) is more preferable, a compound represented by the formula (5a-11-1), the formula (5a-11-2), the formula (5a-11-3) or the formula (5a-11-11) is further preferable, since synthesis of the compound represented by the formula (11) is easy.

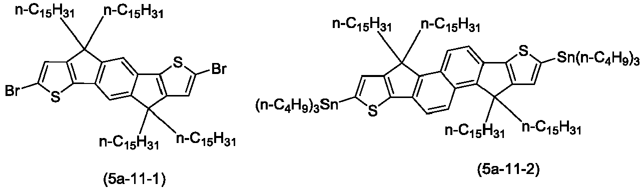

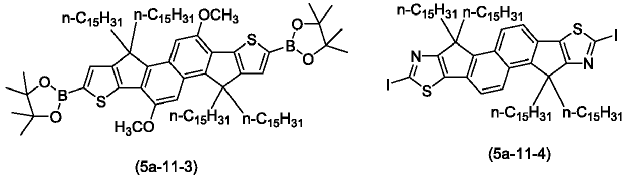

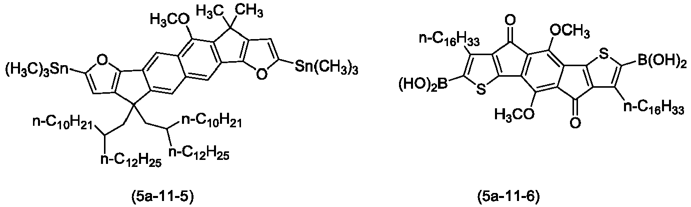

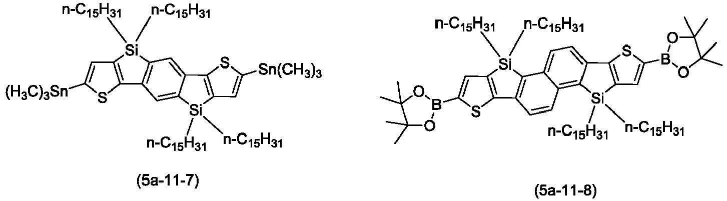

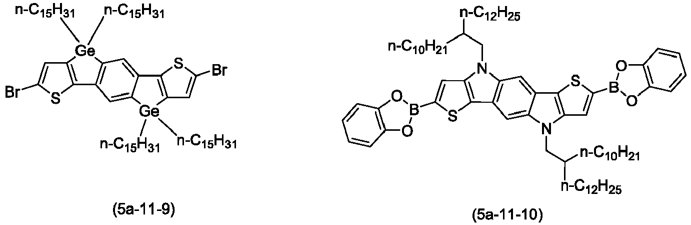

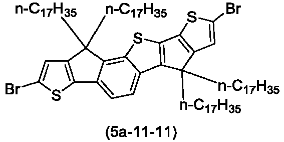

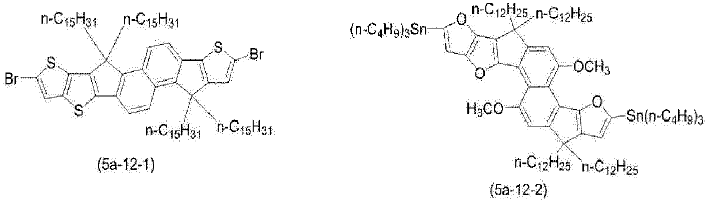

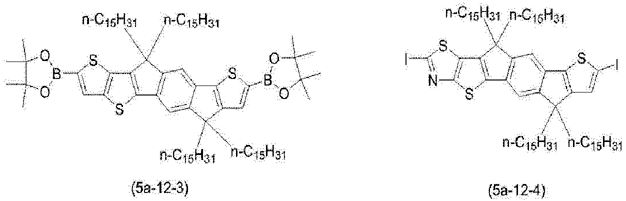

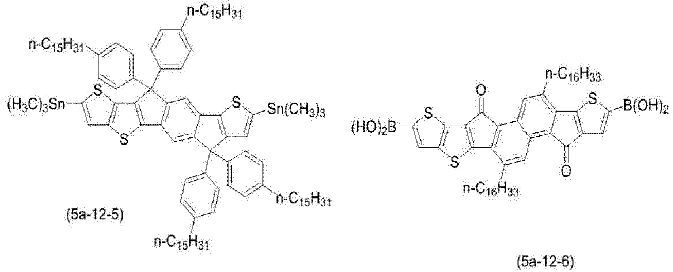

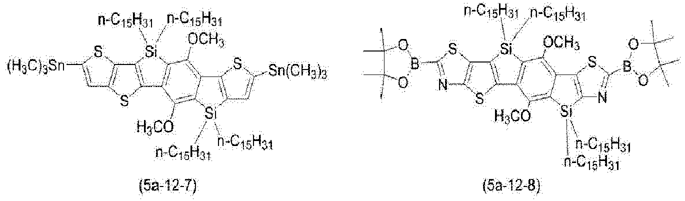

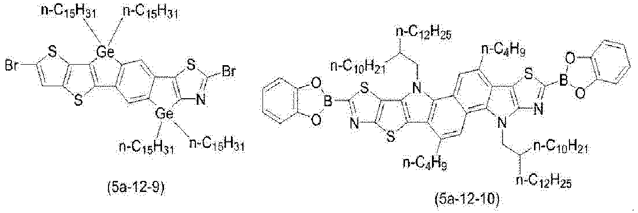

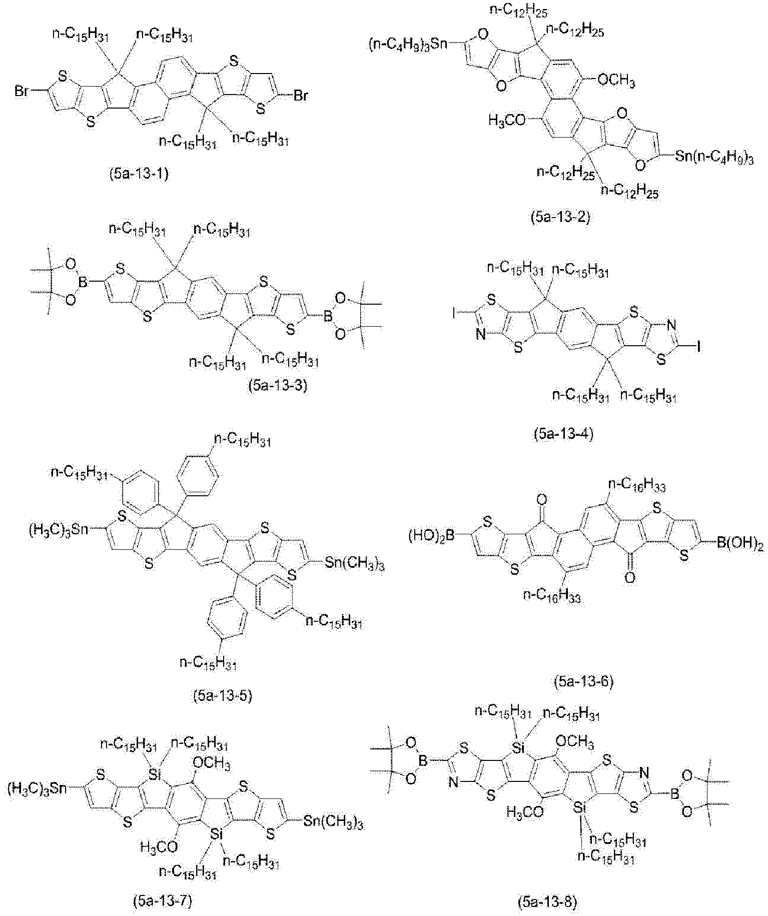

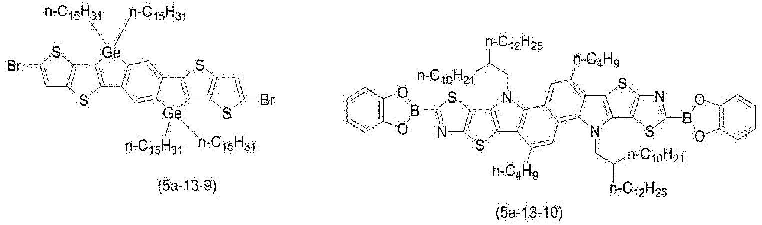

### (Production method of compound represented by the formula (11))

Next, a production method of a compound represented by the formula (11) is described.

The compound represented by the formula (11) may be produced by any method, and for example, can be produced by a bromination reaction, the Suzuki coupling reaction, the Wolff-Kishner reduction reaction, the Buchwald-Hartwig amination reaction or an oxidative reduction reaction as explained below.

When Z¹ in the constitutional unit represented by the formula (1) contained in the formula (11) is a group represented by the formula (Z-5), a compound represented by the formula (11) can be obtained, for example, by a production method containing
a first step in which a compound represented by the formula (S1), a compound represented by the formula (S2) and a compound represented by the formula (S3) are reacted by the Suzuki coupling reaction to synthesize a compound represented by the formula (S4),
a second step in which the compound represented by the formula (S4) obtained in the first step is intramolecularly cyclized to synthesize a compound represented by the formula (S5), and
a third step in which the compound represented by the formula (S5) obtained in the second step is
(I) reacted with a halogenating agent such as N-bromosuccinimide and the like,
(II) coupling-reacted using a palladium catalyst or the like, or
(III) reacted with an alkyllithium to be lithiated, and further, reacted with tributylbutyltin chloride and the like
to synthesize a compound represented by the formula (11) . 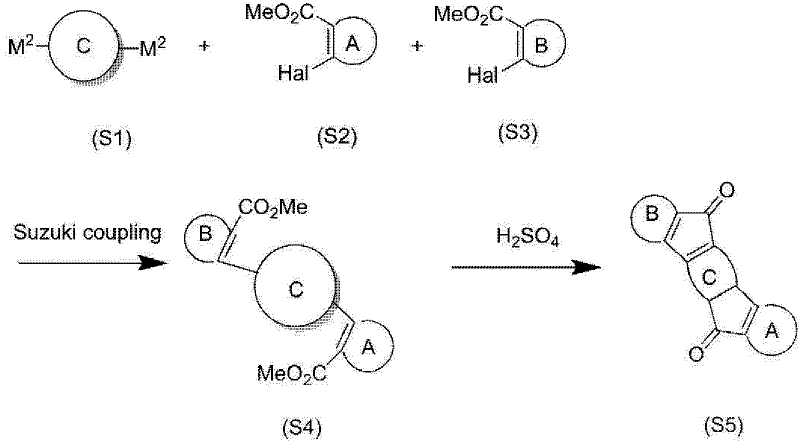 [in the formulae (S1) to (S5), the ring A, the ring B and the ring C represent the same meaning as described above. M² represents a boric acid residue (a group represented by -B(OH)₂) or a borate residue. A plurality of M² may be the same or different. Hal represents an iodine atom, a bromine atom or a chlorine atom. Hal in the formula (S2) and Hal in the formula (S3) may be the same or different.].

When Z¹ in the constitutional unit represented by the formula (1) contained in the formula (11) is a group represented by the formula (Z-1), a compound represented by the formula (11) can be obtained, for example, by a production method containing
a first step in which a compound represented by the above-described formula (S5) is reacted by the Wolff-Kishner reduction reaction to synthesize a compound represented by the formula (S6),
a second step in which the compound represented by the formula (S6) obtained in the first step, a base such as a sodium alkoxide and the like, and an alkyl halide are reacted to synthesize a compound represented by the formula (S7), and
a third step in which the compound represented by the formula (S7) obtained in the second step is
(I) reacted with a halogenating agent such as N-bromosuccinimide and the like,
(II) coupling-reacted using a palladium catalyst or the like, or
(III) reacted with an alkyllithium to be lithiated, and further, reacted with tributylbutyltin chloride and the like
to synthesize a compound represented by the formula (11) . 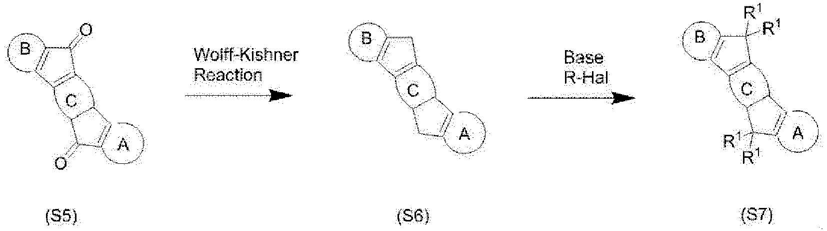 [in the formulae (S5) to (S7), R¹, the ring A, the ring B, the ring C and Hal represent the same meaning as described above.].

When Z¹ in the constitutional unit represented by the formula (1) contained in the formula (11) is a group represented by the formula (Z-1), a compound represented by the formula (11) can also be obtained by a production method containing
a first step in which a compound represented by the formula (S1), a compound represented by the formula (S8) and a compound represented by the formula (S9) are reacted by the Suzuki coupling reaction to synthesize a compound represented by the formula (S10),
a second step in which the compound represented by the formula (S10) obtained in the first step is reacted with butyllithium to be lithiated, and further, reacted with a ketone to synthesize a compound represented by the formula (S11),
a third step in which the compound represented by the formula (S11) obtained in the second step is reacted with an acid such as trifluoroboric acid, sulfuric acid and the like to be cyclized, to synthesize a compound represented by the formula (S7), and
a fourth step in which the compound represented by the formula (S7) obtained in the third step is
(I) reacted with a halogenating agent such as N-bromosuccinimide and the like,
(II) coupling-reacted using a palladium catalyst or the like, or
(III) reacted with an alkyllithium to be lithiated, and further, reacted with tributylbutyltin chloride and the like
to synthesize a compound represented by the formula (11) . 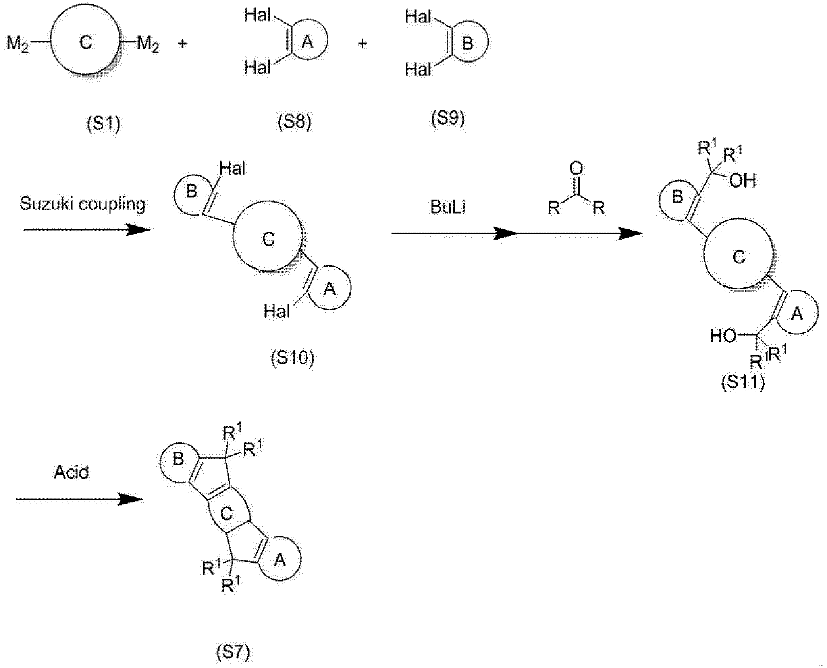 [in the formulae (S1) and (S7) to (S11), R¹, M₂, the ring A, the ring B, the ring C and Hal represent the same meaning as described above. A plurality of Hal present in the formula (S8) may be the same or different, a plurality of Hal present in the formula (S9) may be the same or different, and Hal in the formula (S8) and Hal in the formula (S9) may be the same or different.].

When Z¹ in the constitutional unit represented by the formula (1) contained in the formula (11) is a group represented by the formula (Z-2) or the formula (Z-4), a compound represented by the formula (11) can be obtained, for example, by a production method containing
a first step in which a compound represented by the formula (S10) is reacted with a halogenating agent such as N-bromosuccinimide and the like to synthesize a compound represented by the formula (S12),
a second step in which the compound represented by the formula (S12) obtained in the first step is reacted with butyllithium to be lithiated, and further, reacted with a compound represented by the formula: R₂ECl₂ (E represents a silicon atom or a germanium atom) and the like to synthesize a compound represented by the formula (S13), and
a third step in which the compound represented by the formula (S13) obtained in the second step is
(I) reacted with a halogenating agent such as N-bromosuccinimide and the like,
(II) coupling-reacted using a palladium catalyst or the like, or
(III) reacted with an alkyllithium to be lithiated, and further, reacted with tributylbutyltin chloride and the like
to synthesize a compound represented by the formula (11) . 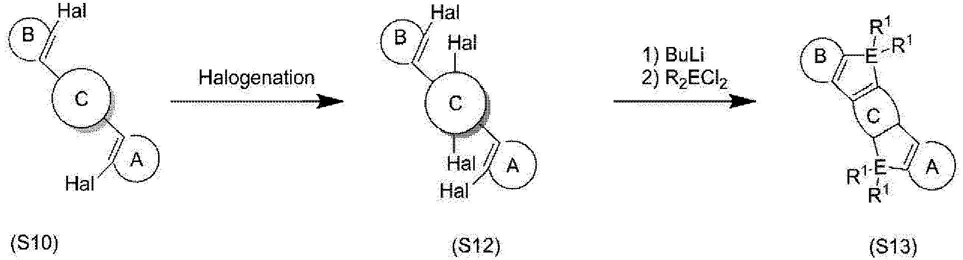 [in the formulae (S10), (S12) and (S13), R¹, the ring A, the ring B, the ring C, Hal and E represent the same meaning as described above. A plurality of Hal present in the formula (S10) may be the same or different, and a plurality of Hal present in the formula (S12) may be the same or different, and Hal in the formula (S10) and Hal in the formula (S12) may be the same or different.]

When Z¹ in the constitutional unit represented by the formula (1) contained in the formula (11) is a group represented by the formula (Z-4), a compound represented by the formula (11) can be obtained, for example, by a production method containing
a first step in which a compound represented by the formula (S12) and a compound represented by the formula (S14) reacted by the Buchwald-Hartwig amination reaction to synthesize a compound represented by the formula (S15), and
a second step in which the compound represented by the formula (S15) obtained in the first step is
(I) reacted with a halogenating agent such as N-bromosuccinimide and the like,
(II) coupling-reacted using a palladium catalyst or the like, or
(III) reacted with an alkyllithium to be lithiated, and further, reacted with tributylbutyltin chloride and the like
to synthesize a compound represented by the formula (11). 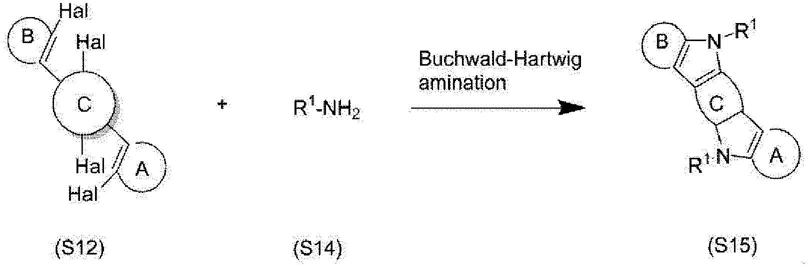 [in the formulae (S12), (S14) and (S15), R¹, the ring A, the ring B, the ring C and Hal represent the same meaning as described above. A plurality of Hal present in the formula (S12) may be the same or different.]

When Z¹ in the constitutional unit represented by the formula (1) contained in the formula (11) is a group represented by the formula (Z-5), a compound represented by the formula (11) can also be obtained by a production method containing
a first step in which a compound represented by the formula (S16), a compound represented by the formula (S19) and a compound represented by the formula (S20) are reacted by the Suzuki coupling reaction to synthesize a compound represented by the formula (S21),
a second step in which the compound represented by the formula (S21) obtained in the first step is intramolecularly cyclized to synthesize a compound represented by the formula (S7), and
a third step in which the compound represented by the formula (S7) obtained in the second step is
(I) reacted with a halogenating agent such as N-bromosuccinimide and the like,
(II) coupling-reacted using a palladium catalyst or the like, or
(III) reacted with an alkyllithium to be lithiated, and further, reacted with tributylbutyltin chloride and the like
to synthesize a compound represented by the formula (11). 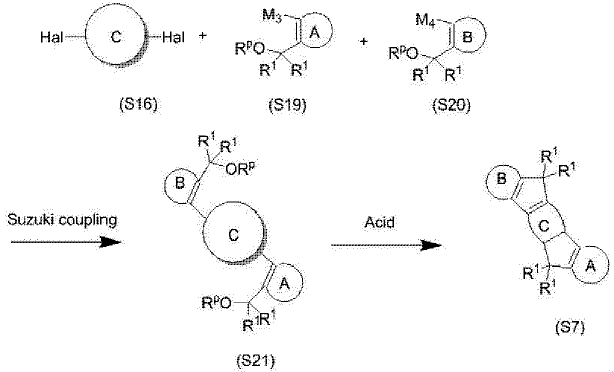 [in the formulae (S7), (S16), (S19), (S20) and (S21), R¹, the ring A, the ring B and Hal represent the same meaning as described above. R^{p} represents an alkyl group having a number of carbon atoms of 1 to 30, a group represented by - Si(R')₃ (three R' each independently represent a hydrogen atom, an alkyl group having a number of carbon atoms of 1 to 30 or a hetero ring group having a number of carbon atoms of 2 to 30 optionally having an alkyl group) or an acetyl group. A plurality of Hal present in the formula (S16) may be the same or different. R^{p} in the formula (S19) and R^{p} in the formula (S20) may be the same or different, and a plurality of R^{p} in the formula (S21) may be the same or different.].

The compound represented by the formula (11) can also be synthesized according to methods described, for example, in Japanese Unexamined Patent Application Publication (JP-A) No. 2009-155648, JP-A No. 2009-209134, Japanese Translation of PCT International Application Publication (JP-T) No. 2012-500308, JP-T No. 2013-501076 and International Publication WO 2013/010614.

### <Ink composition containing composition and organic solvent>

The present invention may also be an ink composition containing the composition according to the present invention and an organic solvent from the standpoint of facilitating work such as application or the like. The ink composition may be a solution or a dispersion. The ink composition includes, for example, an ink composition containing the composition and an organic solvent in which the value of (mass of composition)/(mass of composition and organic solvent) × 100 is 0.1% by mass or more and 20% by mass or less.

It is more preferable for the ink composition that the value of (mass of composition)/(mass of composition and organic solvent) × 100 is 0.4% by mass or more and 5% by mass or less.

Preferable as the organic solvent are halogenated saturated hydrocarbon solvents such as carbon tetrachloride, chloroform, dichloromethane, dichloroethane, chlorobutane, bromobutane, chloropentane, bromopentane, chlorohexane, bromohexane, chlorocyclohexane, bromocyclohexane and the like and halogenated unsaturated hydrocarbon solvents such as chlorobenzene, dichlorobenzene, trichlorobenzene and the like, and additionally, tetrahydrofuran, tetrahydropyran, dioxane, toluene, xylene, mesitylene, tetralin, decalin, bicyclohexyl, cyclohexylbenzene and cyclohexane.

It is preferable that the ink composition has suitable viscosity for application methods as described later.

The ink composition may further contain other additives.

### <Organic thin film>

An organic thin film can be produced using the ink composition described above.

The organic thin film is a film constituted mainly of the polymer compound containing a structural unit represented by the formula (1) of the present invention, and an organic solvent and other unavoidable components may be partially contained.

The thickness of the organic thin film is preferably 1 nm to 100 µm, more preferably 2 nm to 1000 nm, further preferably 5 nm to 500 nm, particularly preferably 20 nm to 200 nm. When the organic thin film having such a thickness is used, an organic semiconductor device having excellent carrier transportability and sufficient also in strength and the like can be formed.

The organic thin film can be formed by applying the ink composition described above on a prescribed substrate, and the like. The ink composition application method includes application methods such as, for example, a spin coat method, a casting method, a push coat method, a micro gravure coat method, a gravure coat method, a bar coat method, a roll coat method, a wire bar coat method, a dip coat method, a spray coat method, a screen printing method, a flexo printing method, an offset printing method, an inkjet printing method, a dispenser printing method, a micro contact printing method, a nozzle coat method and a capillary coat method. Of them, a spin coat method, a push coat method, a gravure coat method, a screen printing method, a flexo printing method, an offset printing method, an inkjet printing method, a dispenser printing method, a micro contact printing method, a nozzle coat method or a capillary coat method is preferable.

Application may be conducted also under heated condition. By this, a solution or dispersion having high concentration can be applied, a more uniform organic thin film can be formed, and additionally, materials of which application at room temperature has been difficult can be selected and used. Application under heated condition can be attained, for example, by using a solution or dispersion heated previously or by performing application while heating a substrate.

The viscosity of the ink composition is, for example, preferably 0.01 to 1 Pa•s, more preferably 0.05 to 0.2 Pa•s when the organic thin film is formed by a gravure coat method, preferably 0.1 to 100 Pa•s, more preferably 0.5 to 50 Pa•s when the organic thin film is formed by a screen printing method, preferably 0.01 to 1 Pa•s, more preferably 0.05 to 0.5 Pa•s when the organic thin film is formed by a flexo printing method, preferably 1 to 500 Pa•s, more preferably 20 to 100 Pa•s when the organic thin film is formed by an offset printing method, and preferably 0.1 Pa•s or less, more preferably 0.02 Pa•s or less when the organic thin film is formed by an inkjet printing method.

The step of forming an organic thin film by the formation method described above can also be carried out as one step in production of an organic semiconductor device. In this case, for example, a substrate on which an organic thin film is to be formed is a structure generated in a production process of an organic semiconductor device. In an organic semiconductor device, a step of imparting prescribed orientation may be further carried out on an organic thin film formed as described above, from the standpoint of further enhancing the carrier transportability of the organic thin film. In an oriented organic thin film, a polymer compound containing a structural unit represented by the formula (1) constituting this is arranged in one direction, therefore, carrier transportability tends to be further enhanced.

As the orientation method, for example, methods which are known as a means for orienting a liquid crystal can be used. Of them, a rubbing method, a photo-aligning method, a shearing method (shear stress applying method), a draw up application method and the like are simple and thus can be utilized easily as the orientation method, and particularly, a rubbing method or a shearing method is preferable.

### <Organic semiconductor device>

The organic thin film containing the polymer compound of the present invention can exert high carrier (electron or hole) transportability, so, electrons or holes injected from an electrode provided on the organic thin film or charges generated by light absorption can be transported. Further, in production of an organic semiconductor device, the viscosity of a solution or dispersion can be adjusted easily, and additionally, crystallization thereof unlikely occurs, hence, uniform properties are obtained even if the area of the device is increased. Utilizing these characteristics, the organic thin film can be applied to various organic semiconductor devices such as an organic thin film transistor, an organic thin film solar battery, an optical sensor and the like.

### (Organic thin film transistor)

The organic thin film transistor using the organic thin film described above includes one having a constitution having a source electrode and a drain electrode, an organic semiconductor layer (active layer) acting as a current pathway between these electrodes, and a gate electrode controlling the quantity of current passing the current pathway, in which the organic semiconductor layer is constituted of the organic thin film containing the polymer compound of the present invention. Such an organic thin film transistor includes, for example, an electric field-effect organic thin film transistor and an electrostatic induction organic thin film transistor.

The electric field-effect organic thin film transistor preferably has a source electrode and a drain electrode, an organic semiconductor layer (active layer) acting as a current pathway between these electrodes, a gate electrode controlling the quantity of current passing the current pathway, and an insulation layer disposed between the organic semiconductor layer and the gate electrode. Particularly, it is preferable that a source electrode and a drain electrode are disposed in contact with an organic semiconductor layer (active layer), and further, a gate electrode is disposed sandwiching an insulation layer in contact with the organic semiconductor layer. In the electric field-effect organic thin film transistor, the organic semiconductor layer is constituted of an organic thin film containing the composition of the present invention.

The electrostatic induction organic thin film transistor preferably has a source electrode and a drain electrode, an organic semiconductor layer (active layer) acting as a current pathway between these electrodes, and a gate electrode controlling the quantity of current passing the current pathway, wherein this gate electrode is disposed in the organic semiconductor layer. Particularly, it is preferable that a source electrode, a drain electrode and, a gate electrode disposed in an organic semiconductor layer are disposed in contact with the organic semiconductor layer. Here, the gate electrode may have a structure by which a current pathway flowing from a source electrode to a drain electrode can be formed and the quantity of current passing the current pathway can be controlled by voltage applied to the gate electrode, and for example, a comb-shaped electrode is mentioned.

Also in the electrostatic induction organic thin film transistor, the organic semiconductor layer is constituted of an organic thin film containing the composition of the present invention.

The organic semiconductor layer may partially contain a solvent and other unavoidable components used in production. The thickness is preferably 1 nm to 100 µm, more preferably 2 nm to 1000 nm, further preferably 5 nm to 500 nm, particularly preferably 20 nm to 200 nm, from the standpoint of having excellent carrier transportability and from the standpoint of easily forming an organic thin film having sufficient strength.

As the gate insulation layer, a gate insulation film composed of an inorganic insulator or an organic insulator can be used. The inorganic insulator includes silicon oxide, silicon nitride, aluminum oxide, aluminum nitride and titanium oxide. The organic insulator includes polyethylene, polyester, polyimide, polyphenylene sulfide, organic glass, polyvinyl alcohol, polyvinyl phenol, poly-p-xylene, polyacrylonitrile, polytetrafluoroethylene, Cytop (registered trademark), polyvinylidene fluoride, polystyrene, a copolymerized polymer containing styrene and a styrene derivative, polymethacrylate, a copolymerized polymer containing methacrylate and a methacrylate derivative, and the like. The inorganic insulator and the organic insulator may be used singly or in combination of two or more. The thickness of the gate insulation layer is preferably 50 to 1000 nm.

In the gate electrode, materials such as metals such as gold, platinum, silver, copper, chromium, palladium, aluminum, indium, molybdenum, low resistance polysilicon, low resistance amorphous silicon and the like and tin oxide, indium oxide, indium•tin oxide (ITO) and the like can be used. These materials may be used singly or in combination of two or more. Further, as the gate electrode, a silicon substrate doped at high concentration may be used. The silicon substrate doped at high concentration has a nature as a gate electrode and a nature as a substrate together. Hence, in the case of use of the silicon substrate doped at high concentration, representation of a substrate in the following figures may be omitted, in an organic thin film transistor in which a substrate and a gate electrode are in contact. The thickness of the gate electrode is preferably 0.02 to 100 µm.

The source electrode and the drain electrode are preferably constituted of a low resistance material, and the thicknesses of the source electrode and the drain electrode are each preferably 0.02 to 1000 µm.

The substrate includes a glass substrate, a flexible film substrate, a plastic substrate and the like. The thickness of the substrate is preferably 10 to 2000 µm.

In an organic thin film transistor, a layer composed of a compound different from an organic semiconductor material contained in an organic semiconductor layer may be allowed to intervene between source and drain electrodes and the organic semiconductor layer. By intervention of such a layer, contact resistance between source and drain electrodes and the organic semiconductor layer is reduced and the carrier mobility of the organic thin film transistor can be further enhanced in some cases.

The layer containing a compound different from the composition of the present invention contained in an organic semiconductor layer includes layers containing, for example, low molecular weight compounds having electron or hole transportability; alkali metals, alkaline earth metals, rare earth metals, complexes of these metals with an organic compound; halogens such as iodine, bromine, chlorine, iodine chloride and the like; sulfur oxide compounds such as sulfuric acid, anhydrous sulfuric acid, sulfur dioxide, sulfuric acid salt and the like; nitrogen oxide compounds such as nitric acid, nitrogen dioxide, nitric acid salt and the like; halogenated compounds such as perchloric acid, hypochlorous acid and the like; alkylthiol compounds, aromatic thiols, aromatic thiol compounds such as fluorinated alkyl aromatic thiols and the like.

Next, a typical example of an electric field-effect organic thin film transistor will be illustrated referring to drawings.

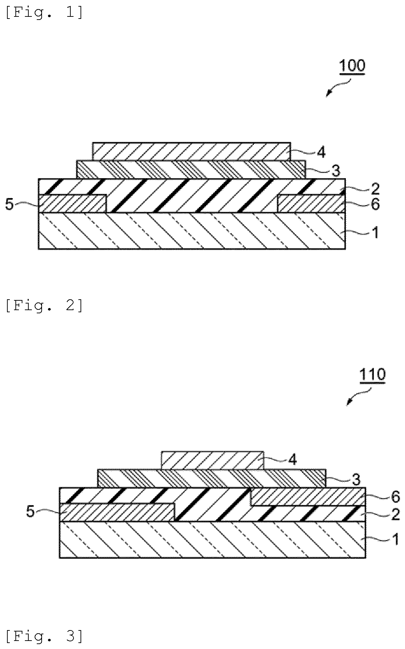

Fig. 1 is a schematic cross-sectional view an organic thin film transistor (electric field-effect organic thin film transistor) according to a first embodiment. The organic thin film transistor 100 shown in Fig. 1 has a substrate 1, a source electrode 5 and a drain electrode 6 formed at a prescribed interval on the substrate 1, an organic semiconductor layer 2 so formed on the substrate 1 as to over the source electrode 5 and the drain electrode 6, an insulation layer 3 formed on the organic semiconductor layer 2, and a gate electrode 4 so formed on the insulation layer 3 as to cover a region of the insulation layer 3 between the source electrode 5 and the drain electrode 6.

Fig. 2 is a schematic cross-sectional view of an organic thin film transistor (electric field-effect organic thin film transistor) according to a second embodiment. The organic thin film transistor 110 shown in Fig. 2 has a substrate 1, a source electrode 5 formed on the substrate 1, an organic semiconductor layer 2 so formed on the substrate 1 as to cover the source electrode 5, a drain electrode 6 formed at a prescribed interval from the source electrode 5 on the organic semiconductor layer 2, an insulation layer 3 formed on the organic semiconductor layer 2 and the drain electrode 6, and a gate electrode 4 so formed on the insulation layer 3 as to cover a region of the insulation layer 3 between the source electrode 5 and the drain electrode 6.

Fig. 3 is a schematic cross-sectional view of an organic thin film transistor (electric field-effect organic thin film transistor) according to a third embodiment. The organic thin film transistor 120 shown in Fig. 3 has a substrate 1, a gate electrode 4 formed on the substrate 1, an insulation layer 3 so formed on the substrate 1 as to cover the gate electrode 4, a source electrode 5 and a drain electrode 6 so formed at a prescribed interval on the insulation layer 3 as to partially cover a region of the insulation layer 3 where the gate electrode 4 is formed beneath, and an organic semiconductor layer 2 so formed on the insulation layer 3 as to partially cover the source electrode 5 and the drain electrode 6.

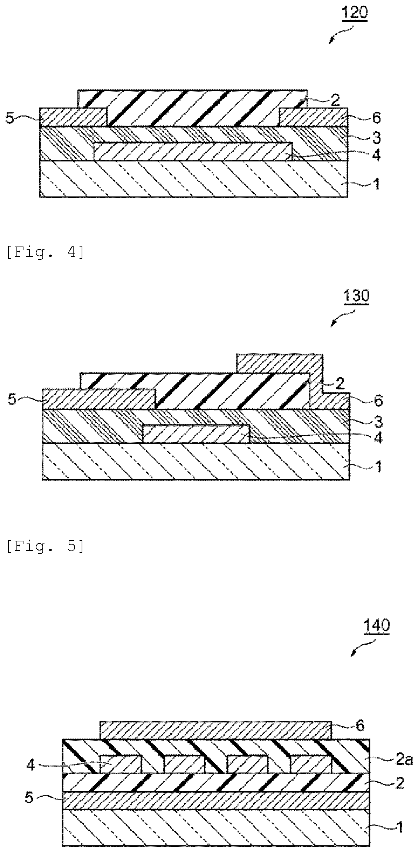

Fig. 4 is a schematic cross-sectional view of an organic thin film transistor (electric field-effect organic thin film transistor) according to a fourth embodiment. The organic thin film transistor 130 shown in Fig. 4 has a substrate 1, a gate electrode 4 formed on the substrate 1, an insulation layer 3 so formed on the substrate 1 as to cover the gate electrode 4, a source electrode 5 so formed on the insulation layer 3 as to partially cover a region of the insulation layer 3 where the gate electrode 4 is formed beneath, an organic semiconductor layer 2 so formed on the insulation layer 3 as to partially cover the source electrode 5, and a drain electrode 6 so formed on the insulation layer 3 at a prescribed interval from the source electrode 5 as to partially cover a region of the organic semiconductor layer 2 where the gate electrode 4 is formed beneath.

Fig. 5 is a schematic cross-sectional view of an organic thin film transistor (electrostatic induction organic thin film transistor) according to a fifth embodiment. The organic thin film transistor 140 shown in Fig. 5 has a substrate 1, a source electrode 5 formed on the substrate 1, an organic semiconductor layer 2 formed on the source electrode 5, a plurality of gate electrodes 4 formed at a prescribed interval on the organic semiconductor layer 2, an organic semiconductor layer 2a so formed on the organic semiconductor layer 2 as to cover all the gate electrodes 4 (the material constituting the organic semiconductor layer 2a may be the same as or different from that of the organic semiconductor layer 2), and a drain electrode 6 formed on the organic semiconductor layer 2a.

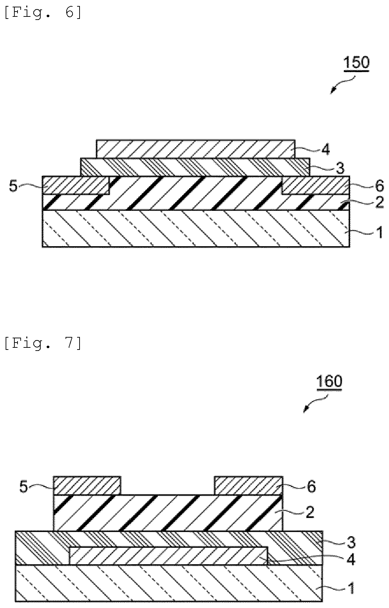

Fig. 6 is a schematic cross-sectional view of an organic thin film transistor (electric field-effect organic thin film transistor) according to a sixth embodiment. The organic thin film transistor 150 shown in Fig. 6 has a substrate 1, an organic semiconductor layer 2 formed on the substrate 1, a source electrode 5 and a drain electrode 6 formed at a prescribed interval on the organic semiconductor layer 2, an insulation layer 3 so formed on the organic semiconductor layer 2 as to partially cover the source electrode 5 and the drain electrode 6, and a gate electrode 4 so formed on the insulation layer 3 as to partially cover a region of the insulation layer 3 where the source electrode 5 is formed beneath and a region of the insulation layer 3 where the drain electrode 6 is formed beneath respectively.

Fig. 7 is a schematic cross-sectional view of an organic thin film transistor (electric field-effect organic thin film transistor) according to a seventh embodiment. The organic thin film transistor 160 shown in Fig. 7 has a substrate 1, a gate electrode 4 formed on the substrate 1, an insulation layer 3 so formed on the substrate 1 as to cover the gate electrode 4, an organic semiconductor layer 2 so formed as to cover a region of the insulation layer 3 where the gate electrode 4 is formed beneath, a source electrode 5 so formed on the organic semiconductor layer 2 as to partially cover a region of the organic semiconductor layer 2 where the gate electrode 4 is formed beneath, and a drain electrode 6 so formed on the organic semiconductor layer 2 at a prescribed interval from the source electrode 5 as to partially cover a region of the organic semiconductor layer 2 where the gate electrode 4 is formed beneath.

In the organic thin film transistors according to the first to seventh embodiments, the organic semiconductor layer 2 and/or the organic semiconductor layer 2a is constituted of an organic thin film composed of the polymer compound according to the suitable embodiments described above, thereby providing a current pathway (channel) between the source electrode 5 and the drain electrode 6.

The gate electrode 4 controls the quantity of current passing a current pathway (channel) in the organic semiconductor layer 2 and/or the organic semiconductor layer 2a by applying voltage.

### <Production method of organic thin film transistor>

The method of producing an organic thin film transistor will be illustrated below, referring to the organic thin film transistor according to the third embodiment shown in Fig. 3 by way of example.

A substrate 1 is not particularly restricted providing it does not disturb a property as an organic thin film transistor, and a glass substrate, a flexible film substrate and a plastic substrate can also be used.

First, a gate electrode 4 is formed on the substrate 1 by a vapor deposition method, a sputtering method, a plating method, a CVD method and the like. As the gate electrode 4, an n-type silicon substrate doped at high concentration may be used.

Next, an insulation layer 3 is formed on the gate electrode 4 by a CVD method, a plasma CVD method, a plasma polymerization method, a thermal vapor deposition method, a thermal oxidation method, an anodization method, a cluster ion beam vapor deposition method, an LB method, a spin coat method, a casting method, a micro gravure coat method, a gravure coat method, a bar coat method, a roll coat method, a wire bar coat method, a dip coat method, a spray coat method, a screen printing method, a flexo printing method, an offset printing method, an inkjet printing method and the like. In the case of use of an n-type silicon substrate doped at high concentration as the gate electrode 4, its surface can be thermally oxidized to form a film of silicon oxide, and this film of silicon oxide may also be used as the insulation layer 3.

Next, a source electrode 5 and a drain electrode 6 are formed on the insulation layer 3 by a vapor deposition method, a sputtering method, a plating method, a CVD method and the like. Though not illustrated in Fig. 3, a layer promoting charge injection may be provided thereafter between the source electrode 5 and the drain electrode 6 and an organic semiconductor layer 2.

When the organic semiconductor layer 2 is formed on the insulation layer 3, it is preferable to use the solution or dispersion described above from the standpoint of production. The organic thin film transistor of the present invention can be produced using the solution or dispersion by a spin coat method, a casting method, a push coat method, a micro gravure coat method, a gravure coat method, a bar coat method, a roll coat method, a wire bar coat method, a dip coat method, a spray coat method, a screen printing method, a flexo printing method, an offset printing method, an inkjet printing method, a micro contact printing method, a gravure-offset printing method and the like.

After fabrication of an organic thin film transistor, a protective film is preferably formed on the organic thin film transistor for protecting the device. By this protective film, the organic thin film transistor is isolated from atmospheric air and lowering of a property of the organic thin film transistor can be suppressed. Further, an influence in forming a driving display device on the organic thin film transistor can be reduced by the protective film.

The method of forming the protective film includes methods of covering with an UV hardening resin, a thermosetting resin, an inorganic SiONx film and the like. For effectively isolating form atmospheric air, it is preferable that a process from fabrication of an organic thin film transistor until formation of a protective film is conducted without exposing to atmospheric air (for example, in a dried nitrogen atmosphere, in vacuo and the like).

The organic thin film transistor of the present invention can be suitably used for an organic electroluminescent device, an electronic tag and a liquid crystal display.

### (Optical sensor)

The composition of the present invention can also be used for production of an OFET sensor. In the OFET sensor of the present invention, an organic electric field-effect transistor is used as a signal conversion device in outputting an input signal as an electric signal, and sensitivity function or selectivity function is imparted to any structure of a metal, an insulation film and an organic semiconductor layer. The OFET sensor of the present invention includes, for example, a biosensor, a gas sensor, an ion sensor and a humidity sensor.

The biosensor has a substrate and an organic thin film transistor disposed on the substrate. The organic thin film transistor has an organic semiconductor layer, a source region and a drain region disposed in contact with the organic semiconductor, a channel region in the organic semiconductor layer disposed between the source region and the drain region, a gate electrode capable of applying electric filed on the channel region, and a gate insulation film disposed between the channel region and the gate electrode. The organic thin film transistor has a probe (sensitive region) specifically interacting with a standard substance in the channel region and/or the gate insulation film, and when the concentration of the standard substance changes, a characteristic change occurs in the probe, providing the function as a biosensor.

The means for detecting the standard substance in a test sample includes, for example, biosensors in which biomolecules such as nucleic acids, proteins and the like or artificially synthesized functional groups are fixed as a probe to the surface of a solid phase support.

In this method, the standard substance is captured to the surface of a solid phase support by utilizing specific affinity of biomolecules such as a mutual action of complementary nucleic acid chains, a mutual action of an antigen-antibody reaction, a mutual action of an enzyme-substrate reaction, a receptor-ligand mutual action and the like. Therefore, a substance showing specific affinity with the standard substance is selected as a probe.

The probe is fixed to the surface of a solid phase support by a method according to the kind of the probe and the kind of the solid phase support. Alternatively, it is also possible to synthesize a probe on the surface of a solid phase support (for example, a method of synthesizing a probe by a nucleic acid elongating reaction). In any cases, the probe-fixed solid phase support surface is brought into contact with a test sample, and culturing is performed under suitable conditions, thus, a probe-standard substance complex is formed on the surface of the solid phase support. The channel region and/or the gate insulation film itself of the organic thin film transistor may function as a probe.

The gas sensor has a substrate and an organic thin film transistor disposed on the substrate. The organic thin film transistor has an organic semiconductor layer, a source region and a drain region disposed in contact with the organic semiconductor, a channel region in the semiconductor layer disposed between the source region and the drain region, a gate electrode capable of applying electric field to the channel region, and a gate insulation film disposed between the channel region and the gate electrode. The channel region and/or the gate insulation film of the organic thin film transistor functions as a gas sensitive part. When a detection gas is adsorbed to or desorbed from the gas sensitive part, characteristic changes (of electric conductivity, dielectric constant and the like) occur on the gas sensitive part, providing a function as a gas sensor.

The gas to be detected includes, for example, an electron accepting gas and an electron donating gas. The electron accepting gas includes, for example, gases of halogens such as F₂, Cl₂ and the like; nitrogen oxide gases; sulfur oxide gases; and gases of organic acids such as acetic acid and the like. The electron donating gas includes, for example, an ammonia gas; gases of amines such as aniline and the like; a carbon monoxide gas; and a hydrogen gas.

The composition of the present invention can also be used for production of a pressure sensor. The pressure sensor of the present invention has a substrate and an organic thin film transistor provided on the substrate. The organic thin film transistor has an organic semiconductor layer, a source region and a drain region disposed in contact with the organic semiconductor, a channel region in the organic semiconductor layer disposed between the source region and the drain region, a gate electrode capable of applying electric field on the channel region, and a gate insulation film disposed between the channel region and the gate electrode. The channel region and/or the gate insulation film of the organic thin film transistor functions as a pressure sensitive part. When the pressure sensitive part senses pressure, a characteristic change occurs on the pressure sensitive part, providing a function as a pressure sensor.

When the gate insulation film functions as a pressure sensitive part, it is preferable that the gate insulation film contains an organic material, since an organic material is excellent in flexibility and a stretching property as compared with an inorganic material.

When the channel region functions as a pressure sensitive part, the organic thin film transistor may further have an orientation layer for further enhancing crystallinity of an organic semiconductor contained in the channel region. The orientation layer includes, for example, a monomolecular film formed on the gate insulation film by using a silane coupling agent such as hexamethyldisilazane and the like.

The composition of the present invention can also be used for production of a conductivity modulation type sensor. The conductivity modulation type sensor of the present invention uses a conductivity measuring device as a signal conversion device in outputting an input signal as an electric signal, and sensitivity function or selectivity function against sensor target input is imparted to a film containing the composition of the present invention or to a coat of a film containing the composition of the present invention. The conductivity modulation type sensor of the present invention detects the sensor target input as a variation of conductivity of the composition of the present invention. The conductivity modulation type sensor of the present invention includes, for example, a biosensor, a gas sensor, an ion sensor and a humidity sensor.

The composition of the present invention can also be used for production of an amplifying circuit containing an organic electric field-effect transistor as an amplifying circuit for amplifying the output signal from various sensors such as a biosensor, a gas sensor, an ion sensor, a humidity sensor, a pressure sensor and the like formed separately.

The composition of the present invention can also be used for production of a sensor array containing a plurality of various sensors such as a biosensor, a gas sensor, an ion sensor, a humidity sensor, a pressure sensor and the like.

Further, the composition of the present invention can also be used for production of an amplifying circuit-equipped sensor array containing a plurality of various sensors such as a biosensor, a gas sensor, an ion sensor, a humidity sensor, a pressure sensor and the like formed separately and containing an organic electric field-effect transistor as an amplifying circuit for individually amplifying the output signal from each sensor.

### EXAMPLES

Examples will be described below in order to explain the present invention in more detail, but the present invention is not limited to them.

### (NMR analysis)

A compound was dissolved in deuterated chloroform and its NMR was measured by using an NMR apparatus (INOVA300, manufactured by Varian, Inc.).

### (Molecular weight analysis)

The number-average molecular weight and the weight-average molecular weight of a polymer compound were determined by using gel permeation chromatography (GPC, trade name: Alliance GPC 2000, manufactured by Waters). The polymer compound to be measured was dissolved in orthodichlorobenzene and the solution was injected into GPC.

As the mobile phase of GPC, orthodichlorobenzene was used. As the column, TSKgel GMHHR-H(S)HT was used (2 columns were connected, manufactured by Tosoh Corp.). As the detector, an UV detector was used.

### (Measurement of content rate of Pd and P)

The content rate of P and Pd contained in a composition was measured as described below.

A composition was dried and weighed. This value was taken as the mass of the composition.

The composition obtained by drying was sealed in a microwave decomposition device (Multi Wave3000, manufactured by Anton Paar) together with hydrochloric acid and nitric acid and decomposed. The decomposed composition was used as a sample, and the content of Pd was measured by using a graphite furnace atomic absorption apparatus (Z2010, manufactured by Hitachi, Ltd.). The decomposed composition was used as a sample, and the content of P was measured by using an ICP-AES apparatus (SPS300, manufactured by SII).

The values of (content (mass) of P)/(mass of composition) and (content (mass) of Pd)/(mass of composition) were adopted as the content rate (ppm by mass) of P and the content rate (ppm by mass) of Pd, respectively.

### Synthesis Example 1

### (Synthesis of compound 2)

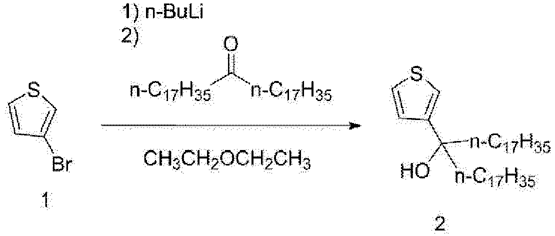

A nitrogen gas atmosphere was prepared in a reaction vessel, then, a compound 1 (32 g, 0.20 mol) and dehydrated diethyl ether (470 mL) were added, to give a uniform solution. A 1.60 M n-butyllithium hexane solution (135 mL, 0.22 mol) was dropped over a period of 30 minutes, while keeping the resultant solution at -68°C. Thereafter, the mixture was stirred at -68°C for 2 hours. Thereafter, to this was added 18-pentatriacontanone (69.7 g, 0.14 mol), the mixture was stirred at -78°C for 10 minutes, then, stirred at room temperature (25°C) for 5 hours. Thereafter, to this was added water (200 mL) to stop the reaction, and a 10 wt% acetic acid aqueous solution was added to make the reaction solution acidic. Thereafter, the reaction product was extracted using hexane. The resultant organic layer was washed with water, and dried over anhydrous magnesium sulfate and filtrated. The resultant filtrate was concentrated by an evaporator, then, the solvent was distilled off, to obtain 125 g of a compound 2. The yield was 100%.

¹H-NMR (300 MHz, CDCl₃): δ (ppm) = 0.88 (t, 6H), 1.25 (m, 60H), 1.75 (m, 4H), 6.96 (d, 1H), 7.27 (d, 1H).

### Synthesis Example 2

### (Synthesis of compound 3)

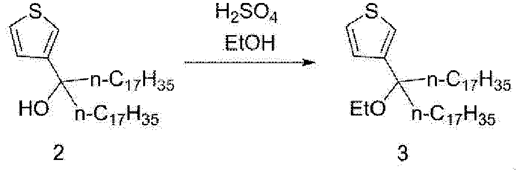

A nitrogen gas atmosphere was prepared in a reaction vessel, then, the compound 2 (232 g, 0.39 mol) and dehydrated ethanol (880 mL) and hexane (350 mL) were added, to give a suspension. To the resultant suspension was added 96 wt% concentrated sulfuric acid (31 mL, 0.59 mol), then, the mixture was stirred at room temperature for 6 hours. Thereafter, to this was added water (200 mL) to stop the reaction, and the reaction product was extracted using hexane. The resultant organic layer was washed with water, and dried over anhydrous magnesium sulfate and filtrated. The resultant filtrate was concentrated by an evaporator, then, the solvent was distilled off. The resultant residue was purified by silica gel column chromatography using hexane as a moving bed, to obtain 104 g of a compound 3. The yield was 43%.

¹H-NMR (300 MHz, CDCl₃): δ (ppm) = 0.88 (t, 6H), 1.13 (t, 3H), 1.24 (m, 60H), 1.77 (m, 4H), 3.15 (q, 2H), 7.05 (m, 2H), 7.24 (d, 1H).

### Synthesis Example 3

### (Synthesis of compound 4)

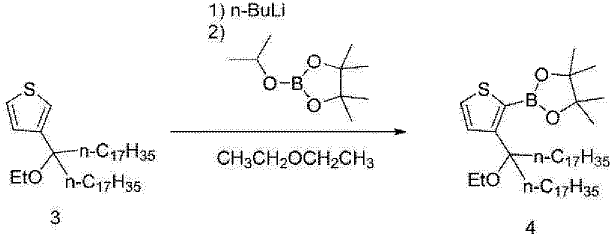

A nitrogen gas atmosphere was prepared in a reaction vessel, then, the compound 3 (104 g, 0.17 mol) and dehydrated diethyl ether (1020 mL) were added, to give a uniform solution. A 1.60 M n-butyllithium hexane solution (136 mL, 0.22 mol) was dropped over a period of 10 minutes, while keeping the resultant solution at -68°C. Thereafter, the mixture was stirred at -68°C for 10 minutes, then, stirred at room temperature (25°C) for 1.5 hours. Thereafter, 2-isopropoxy-4,4,5,5-tetramethyl-1,3,2-dioxaborolane (62.5 g, 0.34 mmol) was added, while keeping the resultant solution at -68°C. Thereafter, the mixture was stirred at -68°C for 10 minutes, then, stirred at room temperature (25°C) for 2 hours. Thereafter, to this was added water (100 mL) to stop the reaction, and the reaction product was extracted using diethyl ether. The resultant organic layer was washed with water, and dried over anhydrous magnesium sulfate and filtrated. The resultant filtrate was concentrated by an evaporator, then, the solvent was distilled off, to obtain 117 g of a compound 4. The yield was 93%.

¹H-NMR (300 MHz, CDCl₃): δ (ppm) = 1.34 (s, 12H), 1.99 (m, 4H), 3.22 (q, 2H), 7.26 (d, 1H), 7.42 (d, 1H).

### Synthesis Example 4

### (Synthesis of compound 6)

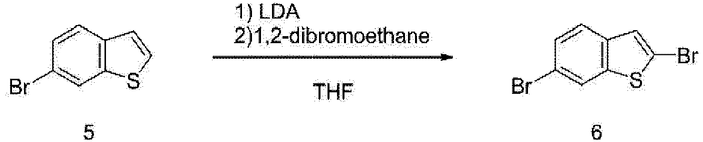

A nitrogen gas atmosphere was prepared in a reaction vessel, then, diisopropylamine (13.3 mL, 93.9 mmol) and dehydrated THF (196 mL) were added, to give a uniform solution. Thereafter, into this was dropped a 1.65 M n-butyllithium hexane solution (58.9 mL, 93.9 mmol) over a period of 10 minutes, and the mixture was stirred at -50°C for 0.5 hours, then, 6-bromobenzothiophene (10.0 g, 46.9 mmol) was added and the mixture was stirred at -50°C for 3 hours. To this was added 1,2-dibromoethane (17.6 g, 93.9 mmol), and the mixture was heated up to room temperature. After stirring for 2 hours, water (20 mL) was added to stop the reaction, and the reaction product was extracted using toluene. The resultant organic layer was washed with water, and dried over anhydrous magnesium sulfate and filtrated. The resultant filtrate was concentrated by an evaporator, then, the solvent was distilled off. The resultant residue was re-crystallized using a mixed solvent of chloroform and methanol, to obtain 8.5 g of a compound 6. The yield was 62%.

¹H-NMR (300 MHz, CDCl₃): δ (ppm) = 7.28 (s, 1H), 7.43 (dd, 1H), 7.54 (d, 1H), 7.87 (d, 1H).

### Synthesis Example 5

### (Synthesis of compound 7)

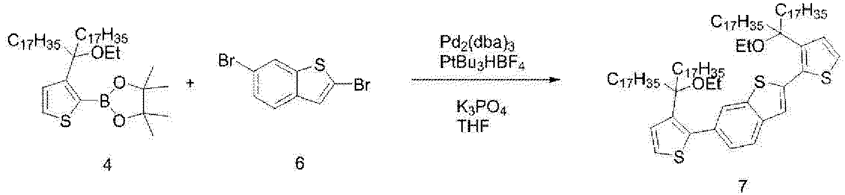

A nitrogen gas atmosphere was prepared in a reaction vessel equipped with a reflux tube, then, the compound 4 (3.5 g, 12.0 mmol) and dry THF (100 mL) were added and the mixture was deaerated for 30 minutes by argon gas bubbling. Thereafter, to this were added tris(dibenzylideneacetone)dipalladium(0) (0.11 g, 0.12 mmol), tri-tert-butylphosphonium tetrafluoroborate (0.14 g, 0.48 mmol) and a 3 M potassium phosphate aqueous solution (44 mL), and the mixture was heated at 80°C. Thereafter, into this, a dry THF (3 mL) solution of the compound 6 (22.8 g, 30.0 mmol) deaerated for 30 minutes by argon gas bubbling was dropped at 80°C over a period of 2 minutes, and the mixture was heated at the same temperature for 2.5 hours. Thereafter, the reaction product was extracted using hexane. The resultant organic layer was washed with saturated saline, and dried over anhydrous magnesium sulfate and filtrated. The resultant filtrate was concentrated by an evaporator, then, the solvent was distilled off. The resultant residue was purified by silica gel column chromatography using a mixed solvent of hexane and chloroform as a moving bed, to obtain 9 g of a compound 7. The yield was 22%.

¹H-NMR (300 MHz, CDCl₃): δ (ppm) = 0.89 (t, 12H), 1.05 (m, 126H), 1.55 (m, 4H), 1.85 (m, 4H), 3.23 (m, 4H), 7.05 (d, 2H), 7.20 (d, 1H), 7.27 (d, 1H), 7.37 (dd, 1H), 7.41 (s, 1H), 7.67 (d, 1H), 7.78 (s, 1H).

### Synthesis Example 6

### (Synthesis of compound 8)

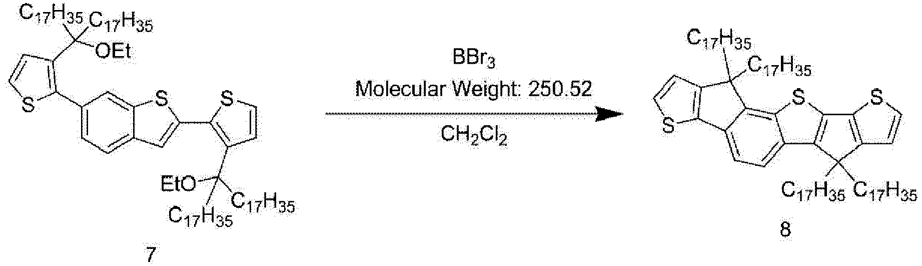

A nitrogen gas atmosphere was prepared in a reaction vessel, then, the compound 7 (7.61 g, 5.56 mmol) and dry methylene chloride (129 mL) were added. Thereafter, to this was added a 1 M boron tribromide methylene chloride solution (22.2 mL, 22.2 mmol) at 0°C, and the mixture was stirred at room temperature (25°C) for 24 hours. Thereafter, to this was added water, and the reaction product was extracted using chloroform. The resultant organic layer was washed with water, and dried over anhydrous magnesium sulfate and filtrated. The resultant filtrate was concentrated by an evaporator, then, the solvent was distilled off. The resultant residue was purified by silica gel column chromatography using hexane as a moving bed, to obtain 4.5 g of a compound 8. The yield was 53%.

¹H-NMR (300 MHz, CDCl₃): δ (ppm) = 0.89 (t, 12H), 1.23 (m, 120H), 2.11 (m, 8H), 7.03 (m, 2H), 7.23 (d, 1H), 7.28 (d, 1H), 7.47 (d, 1H), 7.65 (d, 1H).

### Synthesis Example 7

### (Synthesis of compound 9)

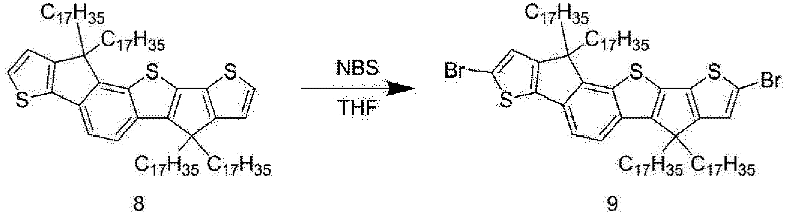

A nitrogen gas atmosphere was prepared in a reaction vessel, then, the compound 8 (7.6 g, 5.56 mmol) and dry THF (130 mL) were added. Thereafter, to this was added N-bromosuccinic imide (5.57 g, 22.2 mmol) at room temperature, and the mixture was stirred at room temperature for 3 hours. Thereafter, to this were added a saturated sodium thiosulfate aqueous solution (2 mL) and water (100 mL), and the mixture was stirred at room temperature for 5 minutes, then, the reaction product was extracted using hexane. The resultant organic layer was washed with water, and dried over anhydrous magnesium sulfate and filtrated. The resultant filtrate was concentrated by an evaporator, then, the solvent was distilled off. The resultant residue was purified by silica gel column chromatography using hexane as a moving bed, and re-crystallized using hexane, to obtain 4.5 g of a compound 9. The yield was 53%.

¹H-NMR (300 MHz, CDCl₃): δ (ppm) = 0.85 (t, 12H), 1.05 (m, 120H), 2.06 (m, 8H), 7.03 (s, 1H), 7.04 (s, 1H), 7.40 (d, 1H), 7.62 (d, 1H).

### Example 1

### (Synthesis of composition PB-2)

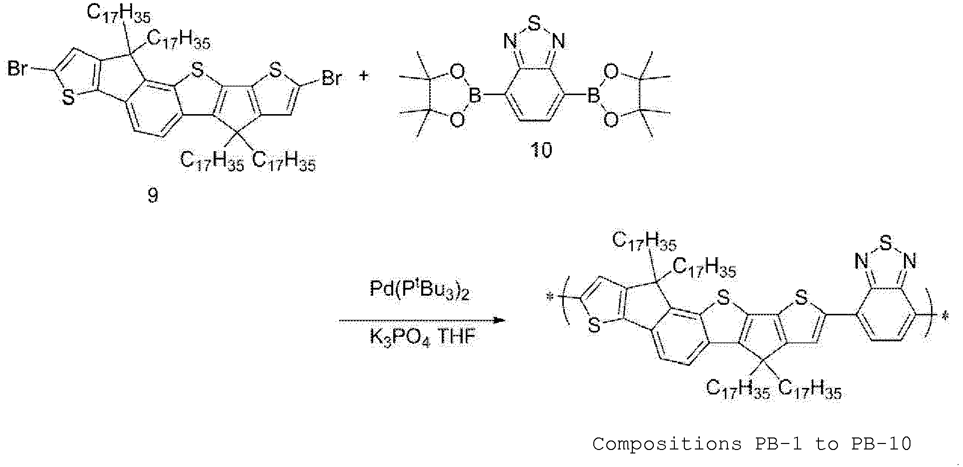

A gas in a reaction vessel was purged with a nitrogen gas, then, the compound 9 (6232.40 mg), a compound 10 (1793.02 mg) synthesized by a method described in a patent document WO2011-052805, tetrahydrofuran (413.7 mL) and bis(tri-tert-butylphosphine)palladium (107.3 mg) were added and stirred. Into the resultant reaction solution, 21 mL of a 3 mol/L potassium phosphate aqueous solution was dropped, and the mixture was refluxed for 3 hours. To the resultant reaction solution was added 512 mg of phenylboronic acid, and the mixture was refluxed for 1 hour. To the resultant reaction solution was added 35 g of sodium N,N-diethyldithiocarbamate trihydrate (chelating agent), and the mixture was refluxed for 1 hour. The resultant reaction solution was poured into water, toluene was added, and the toluene layer was extracted. The resultant toluene solution was washed with an acetic acid aqueous solution and water, then, dropped into methanol, to obtain a deposit. The resultant deposit was dissolved in toluene (1392 mL), then, alumina (326 g) was added, and the mixture was stirred at room temperature for 3 hours, then, alumina was removed by filtration. The resultant toluene solution was dropped into acetone, to obtain a deposit. The resultant deposit was washed by a Soxhlet extractor using acetone as a solvent, to obtain a solid A.

To the solid A (0.2 g) were added 55 mL of 12 N hydrochloric acid and 42 mL of toluene and the mixture was stirred at 80°C for 6 hours. After cooling, the mixture was washed with water, then, the resultant toluene solution was dropped into methanol, to obtain a deposit. The resultant deposit was collected by filtration, and dried under reduced pressure, to obtain a composition PB-2. The amount obtained was 0.2 g.

The polystyrene-equivalent number-average molecular weight was 5.6×10⁴ and the polystyrene-equivalent weight-average molecular weight was 1.1×10⁵.

The content rates of palladium (Pd) and phosphorus (P) contained in the composition PB-2 were 1.8 ppm by mass and 22 ppm by mass, respectively.

### Example 2

### (Synthesis of composition PB-1)

To the composition PB-2 (0.1 g) obtained in Example 1 were added 55 mL of 2 N hydrochloric acid and 42 mL of toluene and the mixture was stirred at 80°C for 6 hours. After cooling, the mixture was washed with water, then, the resultant toluene solution was dropped into methanol, to obtain a deposit. The resultant deposit was collected by filtration, and dried under reduced pressure, to obtain a composition PB-1. The amount obtained was 0.05 g.

The polystyrene-equivalent number-average molecular weight was 5.6×10⁴ and the polystyrene-equivalent weight-average molecular weight was 1.1×10⁵.

The content rates of palladium (Pd) and phosphorus (P) contained in the composition PB-1 were 1.1 ppm by mass and 27 ppm by mass, respectively.

### Example 3

### (Synthesis of composition PB-3)

A gas in a reaction vessel was purged with a nitrogen gas, then, the compound 9 (296.78 mg), the compound 10 (85.38 mg), tetrahydrofuran (20 mL) and bis(tri-tert-butylphosphine)palladium (5.1 mg) were added and stirred. Into the resultant reaction solution was dropped 1 mL of a 3 mol/L potassium phosphate aqueous solution, and the mixture was refluxed for 3 hours. To the resultant reaction solution was added 24.4 mg of phenylboronic acid, and the mixture was refluxed for 1 hour. To the resultant reaction solution was added 1.7 g of sodium N,N-diethyldithiocarbamate trihydrate (chelating agent), and the mixture was refluxed for 1 hour. The resultant reaction solution was poured into water, toluene was added, and the toluene layer was extracted. The resultant toluene solution was washed with an acetic acid aqueous solution and water, then, dropped into methanol, to obtain a deposit. The resultant deposit was dissolved in toluene (66.3 mL), then, alumina (15.5 g) was added, the mixture was stirred at room temperature for 3 hours, then, alumina was removed by filtration. The resultant toluene solution was dropped into acetone, to obtain a deposit. The resultant deposit was washed by a Soxhlet extractor using acetone as a solvent, to obtain a composition PB-3. The amount obtained was 0.18 g.

The polystyrene-equivalent number-average molecular weight was 2.1×10⁴ and the polystyrene-equivalent weight-average molecular weight was 3.6×10⁴.

The content rates of palladium (Pd) and phosphorus (P) contained in the composition PB-3 were 2.0 ppm by mass and 26 ppm by mass, respectively.

### Example 4

### (Synthesis of composition PB-4)

A gas in a reaction vessel was purged with a nitrogen gas, then, the compound 9 (289.22 mg), the compound 10 (85.38 mg), tetrahydrofuran (20 mL) and bis(tri-tert-butylphosphine)palladium (10.2 mg) were added and stirred. Into the resultant reaction solution was dropped 1 mL of a 3 mol/L potassium phosphate aqueous solution, and the mixture was stirred for 3 hours at room temperature (25°C). To the resultant reaction solution was added 24.4 mg of phenylboronic acid, and the mixture was stirred for 1 hour at room temperature (25°C). To the resultant reaction solution was added 1.7 g of sodium N,N-diethyldithiocarbamate trihydrate (chelating agent), and the mixture was refluxed for 1 hour. The resultant reaction solution was poured into water, toluene was added, and the toluene layer was extracted. The resultant reaction solution was poured into water, toluene was added, and the toluene layer was extracted. The resultant toluene solution was washed with an acetic acid aqueous solution and water, then, dropped into methanol, to obtain a deposit. The resultant deposit was dissolved in toluene (66 mL), then, alumina (16 g) was added. The mixture was stirred at room temperature for 3 hours, then, alumina was removed by filtration. The resultant toluene solution was dropped into acetone, to obtain a deposit. The resultant deposit was washed by a Soxhlet extractor using acetone as a solvent, to obtain a composition PB-4. The amount obtained was 0.23 g.

The polystyrene-equivalent number-average molecular weight was 7.5×10⁴ and the polystyrene-equivalent weight-average molecular weight was 2.9×10⁵.

The content rates of palladium (Pd) and phosphorus (P) contained in the composition PB-4 were 3.6 ppm by mass and 11 ppm by mass, respectively.

### Example 5

### (Synthesis of composition PB-5)

A gas in a reaction vessel was purged with a nitrogen gas, then, the compound 9 (1780.69 mg), the compound 10 (479.69 mg), tetrahydrofuran (120 mL) and bis(tri-tert-butylphosphine)palladium (30.7 mg) were added and stirred. Into the resultant reaction solution was dropped 1 mL of a 3 mol/L potassium phosphate aqueous solution, and the mixture was refluxed for 3 hours. To the resultant reaction solution was added 146.3 mg of phenylboronic acid, and the mixture was refluxed for 1 hour. To the resultant reaction solution was added 10 g of sodium N,N-diethyldithiocarbamate trihydrate (chelating agent), and the mixture was refluxed for 1 hour. The resultant reaction solution was poured into water, toluene was added, and the toluene layer was extracted. The resultant reaction solution was poured into water, toluene was added, and the toluene layer was extracted.

The resultant toluene solution was washed with an acetic acid aqueous solution and water, then, dropped into methanol, to obtain a deposit. The resultant deposit was dissolved in toluene (392 mL), then, alumina (92 g) was added. The mixture was stirred at room temperature for 3 hours, then, alumina was removed by filtration. The resultant toluene solution was dropped into acetone, to obtain a deposit. The resultant deposit was dissolved in toluene (392 mL), then, alumina (92 g) was added. The mixture was stirred at room temperature for 3 hours, then, alumina was removed by filtration. The resultant toluene solution was dropped into acetone, to obtain a deposit. The resultant deposit was dissolved in toluene (392 mL), then, alumina (92 g) was added. The mixture was stirred at room temperature for 3 hours, then, alumina was removed by filtration. The resultant toluene solution was dropped into acetone, to obtain a deposit. This operation was repeated three times. The resultant deposit was washed by a Soxhlet extractor using acetone as a solvent, to obtain a composition PB-5. The amount obtained was 0.2 g.

The polystyrene-equivalent number-average molecular weight was 4.4×10⁴ and the polystyrene-equivalent weight-average molecular weight was 1.1×10⁵.

The content rates of palladium (Pd) and phosphorus (P) contained in the composition PB-5 were 5.0 ppm by mass and 24 ppm by mass, respectively.

### Comparative Example 1

### (Synthesis of composition PB-6)

A gas in a reaction vessel was purged with a nitrogen gas, then, the compound 9 (290.0 mg), the compound 10 (62.1 mg), tetrahydrofuran (20 mL) and bis(tri-tert-butylphosphine)palladium (5.1 mg) were added and stirred. Into the resultant reaction solution was dropped 1 mL of a 3 mol/L potassium phosphate aqueous solution, and the mixture was refluxed for 3 hours. To the resultant reaction solution was added 24.4 mg of phenylboronic acid, and the mixture was refluxed for 1 hour. To the resultant reaction solution was added 1.7 g of sodium N,N-diethyldithiocarbamate trihydrate (chelating agent), and the mixture was refluxed for 1 hour. The resultant reaction solution was poured into water, toluene was added, and the toluene layer was extracted. The resultant reaction solution was poured into water, toluene was added, and the toluene layer was extracted. The resultant toluene solution was washed with an acetic acid aqueous solution and water, then, dropped into methanol, to obtain a deposit. The resultant deposit was dissolved in toluene (42 mL), then, the solution was passed through silica gel (1.9 g). The resultant toluene solution was dropped into acetone, to obtain a deposit. The resultant deposit was collected by filtration and dried, to obtain a compound PB-6. The amount obtained was 0.19 g.

The polystyrene-equivalent number-average molecular weight was 2.3×10⁴ and the polystyrene-equivalent weight-average molecular weight was 4.8×10⁴.

The content rates of palladium (Pd) and phosphorus (P) contained in the composition PB-6 were 56 ppm by mass and 32 ppm by mass, respectively.

### Comparative Example 2

### (Synthesis of composition PB-7)

A gas in a reaction vessel was purged with a nitrogen gas, then, the compound 9 (290.0 mg), the compound 10 (76.1 mg), tetrahydrofuran (20 mL) and bis(tri-tert-butylphosphine)palladium (5.1 mg) were added and stirred. Into the resultant reaction solution was dropped 1 mL of a 3 mol/L potassium phosphate aqueous solution, and the mixture was refluxed for 3 hours. To the resultant reaction solution was added 24.4 mg of phenylboronic acid, and the mixture was refluxed for 1 hour. The resultant reaction solution was poured into water, toluene was added, and the toluene layer was extracted. The resultant reaction solution was poured into water, toluene was added, and the toluene layer was extracted. The resultant toluene solution was washed with an acetic acid aqueous solution (acid) and water, then, dropped into methanol, to obtain a deposit. The resultant deposit was dissolved in toluene (42 mL), then, the solution was passed through silica gel (1.9 g). The resultant toluene solution was dropped into acetone, to obtain a deposit. The resultant deposit was collected by filtration and dried, to obtain a compound PB-7. The amount obtained was 0.19 g.

The polystyrene-equivalent number-average molecular weight was 3.7×10⁴ and the polystyrene-equivalent weight-average molecular weight was 7.6×10⁴.

The content rates of palladium (Pd) and phosphorus (P) contained in the composition PB-7 were 100 ppm by mass and 51 ppm by mass, respectively.

### Comparative Example 3

### (Synthesis of composition PB-8)

A gas in a reaction vessel was purged with a nitrogen gas, then, the compound 9 (1780.69 mg), the compound 10 (512.29 mg), tetrahydrofuran (120 mL) and bis(tri-tert-butylphosphine)palladium (30.7 mg) were added and stirred. Into the resultant reaction solution was dropped 1 mL of a 3 mol/L potassium phosphate aqueous solution (base), and the mixture was refluxed for 3 hours. Sixty milliliters (60 mL) of the resultant reaction solution was dropped into methanol, to obtain a deposit. The resultant deposit was collected by filtration and dried, to obtain a compound PB-8. The amount obtained was 0.19 g.

The polystyrene-equivalent number-average molecular weight was 9.4×10⁴ and the polystyrene-equivalent weight-average molecular weight was 1.7×10⁵.

The content rates of palladium (Pd) and phosphorus (P) contained in the composition PB-8 were 140 ppm by mass and 73 ppm by mass, respectively.

### Comparative Example 4

### (Synthesis of composition PB-9)

A gas in a reaction vessel was purged with a nitrogen gas, then, the compound 9 (1780.69 mg), the compound 10 (512.29 mg), tetrahydrofuran (120 mL) and bis(tri-tert-butylphosphine)palladium (30.7 mg) were added and stirred. Into the resultant reaction solution was dropped 1 mL of a 3 mol/L potassium phosphate aqueous solution (base), and the mixture was refluxed for 3 hours. To the resultant reaction solution was added 146.3 mg of phenylboronic acid, and the mixture was refluxed for 1 hour. Twenty five milliliters (25 mL) of the resultant reaction solution was dropped into methanol, to obtain a deposit. The resultant deposit was collected by filtration and dried, to obtain a compound PB-9. The amount obtained was 0.10 g.

The polystyrene-equivalent number-average molecular weight was 1.7×10⁴ and the polystyrene-equivalent weight-average molecular weight was 3.8×10⁵.

The content rates of palladium (Pd) and phosphorus (P) contained in the composition PB-9 were 190 ppm by mass and 71 ppm by mass, respectively.

### Comparative Example 5

### (Synthesis of composition PA-2)

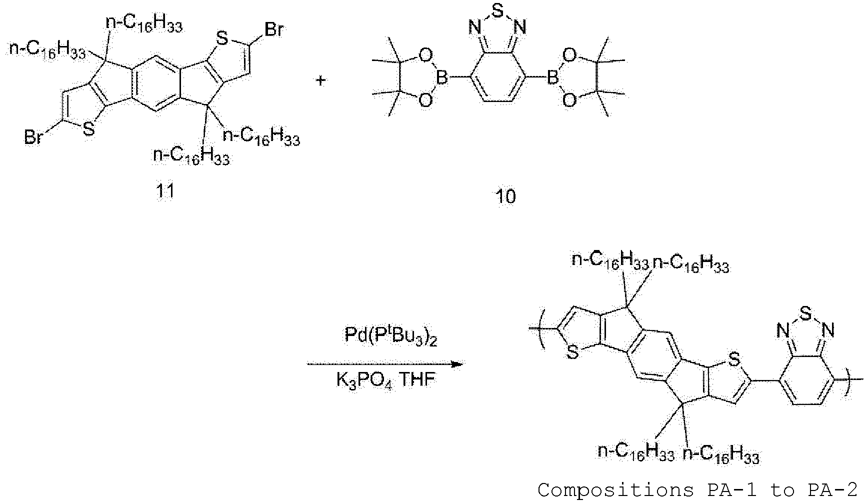

A nitrogen gas atmosphere was prepared in a reaction vessel, then, the compound 10 (89.26 mg), a compound 11 (319.77 mg) synthesized according to a method described in "J. Am. Chem. Soc., 2010, vol. 132, pp. 11437 to 11439", tetrahydrofuran (20 mL) and bis(tri-tert-butylphosphine)palladium (5.1 mg) were added and stirred. Into the resultant reaction solution was dropped 1 mL of a 3 mol/L potassium phosphate aqueous solution, and the mixture was refluxed for 3 hours. To the resultant reaction solution was added 24.4 mg of phenylboronic acid, and the mixture was refluxed for 1 hour, to obtain a reaction solution A.

The resultant reaction solution A (10 mL) was dropped into methanol, to obtain a deposit.

The resultant deposit was collected by filtration and dried, to obtain a compound PA-2. The amount obtained was 0.14 g.

The polystyrene-equivalent number-average molecular weight was 7.7×10⁴ and the polystyrene-equivalent weight-average molecular weight was 1.7×10⁵.

The content rates of palladium (Pd) and phosphorus (P) contained in the composition PA-2 were 1400 ppm by mass and 470 ppm by mass, respectively.

### Example 6

### (Synthesis of composition PA-1)

To the reaction solution A (10 mL) obtained in Comparative Example 5 was added 1.7 g of sodium N,N-diethyldithiocarbamate trihydrate (chelating agent), and the mixture was refluxed for 1 hour. The resultant reaction solution was poured into water, toluene was added, and the toluene layer was extracted. The resultant toluene solution was washed with an acetic acid aqueous solution and water, then, dropped into methanol, to obtain a deposit. The resultant deposit was dissolved in toluene (42 mL), then, alumina (10.5 g) was added, the mixture was stirred at room temperature for 3 hours, then, alumina was removed by filtration. The resultant toluene solution was dropped into acetone, to obtain a deposit. The resultant deposit was washed by a Soxhlet extractor using acetone as a solvent, to obtain a composition PA-1. The amount obtained was 0.15 g.

The polystyrene-equivalent number-average molecular weight was 8.2×10⁴ and the polystyrene-equivalent weight-average molecular weight was 1.7×10⁵.

The content rates of palladium (Pd) and phosphorus (P) contained in the composition PA-1 were 9.0 ppm by mass and 50 ppm by mass, respectively.

### Reference Example 1 (Synthesis of composition PC-1)

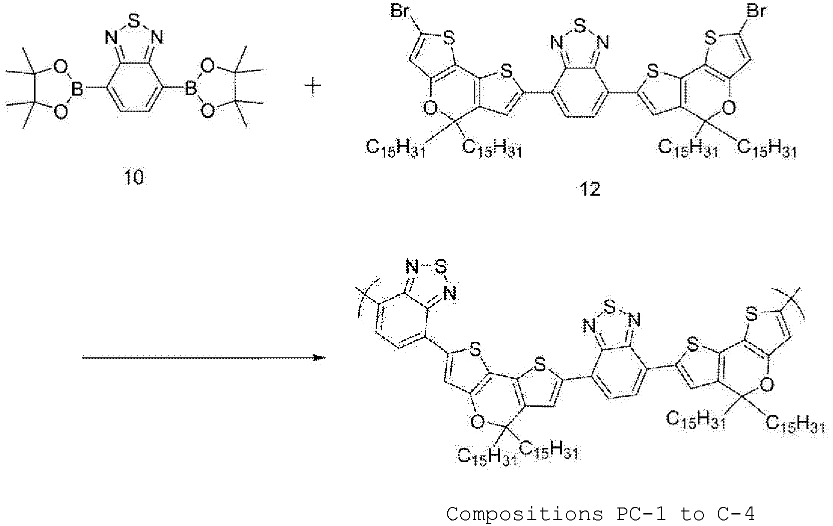

Into a four-necked flask, 1520 mg of a compound 12 synthesized by a method described in WO2011-052709 and 30 mL of chlorobenzene were added, and the mixture was bubbled with argon at room temperature (25°C) for 30 minutes. Thereafter, to the reaction solution were added 26.47 mg of tris(dibenzylideneacetone)palladium, 34.82 mg of [tri(tertiary butyl)phosphonium] tetrafluoroborate and 3.33 mL of a 3 mol/L potassium phosphate aqueous solution. A solution prepared by dissolving 361.3 mg of the compound 10 in 30 mL of tetrahydrofuran was dropped over a period of 10 minutes into the reaction solution while stirring at an oil bath temperature of 80°C, and the solution was stirred for 1 hour. Thereafter, to the reaction solution was added 100.0 mg of phenylboric acid, and the mixture was further stirred for 1 hour, then, the reaction was stopped. The reaction was conducted under an argon atmosphere.

Thereafter, to the reaction solution were added 10 g of sodium N,N-diethyldithiocarbamate trihydrate (chelating agent) and 90 mL of pure water, and the mixture was stirred while refluxing for 3 hours. The aqueous layer in the reaction solution was removed, then, the organic layer was washed with 90 mL of water twice, with 100 mL of a 3 wt% acetic acid aqueous solution twice, further with 100 mL of water twice, and poured into methanol, to cause deposition of a polymer. The polymer was filtrated, then, dried, and the resultant polymer was dissolved in toluene. The toluene solution was passed through alumina/silica gel columns, and the resultant solution was poured into methanol, to cause deposition of a polymer. The polymer was filtrated, then, dried, to obtain 745 mg of a composition PC-1. The content rates of palladium (Pd) and phosphorus (P) contained in the composition PC-1 were 20 ppm by mass and 20 ppm by mass, respectively.

### Reference Example 2 (Synthesis of composition PC-2)

Into a four-necked flask, 1520 mg of a compound 12 synthesized by a method described in WO2011-052709 and 100 mL of tetrahydrofuran were added and the mixture was bubbled with argon at room temperature (25°C) for 30 minutes. Thereafter, to the reaction solution were added 9.11 mg of tris(dibenzylideneacetone)palladium, 11.61 mg of [tri(tertiary butyl)phosphonium] tetrafluoroborate and 3.33 mL of a 3 mol/L potassium phosphate aqueous solution.

A solution prepared by dissolving 357.1 mg of the compound 10 in 30 mL of tetrahydrofuran was dropped over a period of 10 minutes into the reaction solution while stirring at an oil bath temperature of 80°C, and the solution was stirred for 1 hour. Thereafter, to the reaction solution was added 100.0 mg of phenylboric acid, and the mixture was further stirred for 1 hour, then, the reaction was stopped. The reaction was conducted under an argon atmosphere.

Thereafter, to the reaction solution were added 10 g of sodium N,N-diethyldithiocarbamate trihydrate (chelating agent) and 90 mL of pure water, and the mixture was stirred while refluxing for 3 hours. The aqueous layer in the reaction solution was removed, then, the organic layer was washed with 90 mL of water twice, with 100 mL of a 3 wt% acetic acid aqueous solution twice, further with 100 mL of water twice, and poured into methanol, to cause deposition of a polymer. The polymer was filtrated, then, dried, and the resultant polymer was dissolved in toluene. The toluene solution was passed through alumina/silica gel columns, and the resultant solution was poured into methanol, to cause deposition of a polymer. The polymer was filtrated, then, dried, to obtain 965.1 mg of a composition PC-2. The content rates of palladium (Pd) and phosphorus (P) contained in the composition PC-2 were 30 ppm by mass and 10 ppm by mass, respectively.

### Reference Example 3 (Synthesis of composition PC-3)

Into a four-necked flask, 1520 mg of a compound 12 synthesized by a method described in WO2011-052709 and 70 mL of tetrahydrofuran were added and the mixture was bubbled with argon at room temperature (25°C) for 30 minutes. Thereafter, to the reaction solution were added 45.79 mg of tris(dibenzylideneacetone)palladium, 58.03 mg of [tri(tertiary butyl)phosphonium] tetrafluoroborate and 3.33 mL of a 3 mol/L potassium phosphate aqueous solution.

A solution prepared by dissolving 351.2 mg of the compound 10 in 30 mL of tetrahydrofuran was dropped over a period of 10 minutes into the reaction solution while stirring at an oil bath temperature of 80°C, and the solution was stirred for 1 hour. Thereafter, to the reaction solution was added 100.0 mg of phenylboric acid, and the mixture was further stirred for 1 hour, then, the reaction was stopped. The reaction was conducted under an argon atmosphere.

Thereafter, to the reaction solution were added 10 g of sodium N,N-diethyldithiocarbamate trihydrate (chelating agent) and 90 mL of pure water, and the mixture was stirred while refluxing for 3 hours. The aqueous layer in the reaction solution was removed, then, the organic layer was washed with 90 mL of water twice, with 100 mL of a 3 wt% acetic acid aqueous solution twice, further with 100 mL of water twice, and poured into methanol, to cause deposition of a polymer. The polymer was filtrated, then, dried, and the resultant polymer was dissolved in toluene. The toluene solution was passed through alumina/silica gel columns, and the resultant solution was poured into methanol, to cause deposition of a polymer. The polymer was filtrated, then, dried, to obtain 956.5 mg of a composition PC-3.

The content rates of palladium (Pd) and phosphorus (P) contained in the composition PC-3 were 20 ppm by mass and 40 ppm by mass, respectively.

### Reference Example 4 (Synthesis of composition PC-4)

Into a four-necked flask, 1520 mg of a compound 12 synthesized by a method described in WO2011-052709 and 70 mL of tetrahydrofuran were added and the mixture was bubbled with argon at room temperature (25°C) for 30 minutes. Thereafter, to the reaction solution were added 9.16 mg of tris(dibenzylideneacetone)palladium, 11.61 mg of [tri(tertiary butyl)phosphonium] tetrafluoroborate and 3.33 mL of a 3 mol/L potassium phosphate aqueous solution. A solution prepared by dissolving 342.7 mg of the compound 10 in 30 mL of tetrahydrofuran was dropped over a period of 10 minutes into the reaction solution while stirring at an oil bath temperature of 80°C, and the mixture was stirred for 1 hour. Thereafter, to the reaction solution was added 100.0 mg of phenylboric acid, and the mixture was further stirred for 1 hour, then, the reaction was stopped. The reaction was conducted under an argon atmosphere.

Thereafter, to the reaction solution were added 10 g of sodium N,N-diethyldithiocarbamate trihydrate (chelating agent) and 90 mL of pure water, and the mixture was stirred while refluxing for 3 hours. The aqueous layer in the reaction solution was removed, then, the organic layer was washed with 90 mL of water twice, with 100 mL of a 3 wt% acetic acid aqueous solution twice, further with 100 mL of water twice, and poured into methanol, to cause deposition of a polymer. The polymer was filtrated, then, dried, and the resultant polymer was dissolved in toluene. The toluene solution was passed through alumina/silica gel columns, and the resultant solution was poured into methanol, to cause deposition of a polymer. The polymer was filtrated, then, dried, to obtain 781.4 mg of a composition PC-4.

The content rates of palladium (Pd) and phosphorus (P) contained in the composition PC-4 were 340 ppm by mass and 10 ppm by mass, respectively.

### Synthesis Example 8 (Synthesis of polymer compound PG-1)

Into a 50 mL pressure tight case (manufactured by Ace Glass Inc.), 2.06 g of styrene (manufactured by Wako Pure Chemical Industries, Inc.), 2.43 g of 2,3,4,5,6-pentafluorostyrene (manufactured by Aldrich), 1.00 g of 2-[O-[1'-methylpropylideneamino]carboxyamino]ethyl methacrylate (trade name: Karenz MOI-BM, manufactured by Showa Denko K.K.), 0.06 g of 2,2'-azobis(2-methylpropionitrile) and 14.06 g of PGMEA (manufactured by Wako Pure Chemical Industries, Inc.) were charged, and the mixture was bubbled with nitrogen, then, the case was sealed tightly, the materials were polymerized for 16 hours in an oil bath at 60°C, to obtain a viscous PGMEA solution containing a polymer compound PG-1 dissolved. The polystyrene-equivalent number-average molecular weight was 1.1×10⁵ and the polystyrene-equivalent weight-average molecular weight was 2.3×10⁵. The structure of the polymer compound PG-1 is as described below.

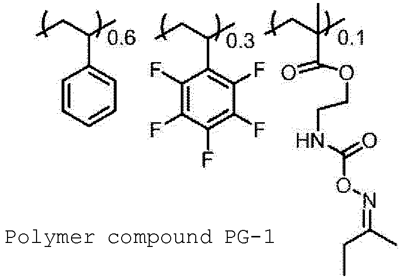

### Synthesis Example 9 (Synthesis of polymer compound PG-2)

Into a 125 mL pressure tight case (manufactured by Ace Glass Inc.), 3.50 g of 4-aminostyrene (manufactured by Aldrich), 13.32 g of 2,3,4,5,6-pentafluorostyrene (manufactured by Aldrich), 0.08 g of 2,2'-azobis(2-methylpropionitrile) and 25.36 g of PGMEA (manufactured by Wako Pure Chemical Industries, Inc.) were charged, and the mixture was bubbled with nitrogen, then, the case was sealed tightly and the materials were polymerized for 48 hours in an oil bath at 60°C, to obtain a viscous PGMEA solution containing a polymer compound PG-2 dissolved.

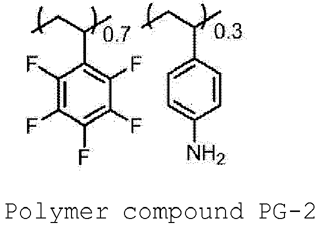

### Synthesis Example 10 (Preparation of application solution 1)

The PGMEA solution (2.00 g) of the polymer compound PG-1 obtained in Synthesis Example 8, the PGMEA solution (0.79 g) of the polymer compound PG-2 obtained in Synthesis Example 9 and PGMEA (2.00 g) were charged in a sample bottle, and stirred and dissolved, to prepare a uniform application solution 1.

### Example 7 (Fabrication and evaluation of organic thin film transistor SA-1)

Using a solution containing the composition PA-1 obtained in Example 6, a bottom gate bottom contact type organic thin film transistor device having a structure shown in Fig. 3 was fabricated.

A layer of chromium (Cr) was vapor-deposited on a substrate 1 by a sputter vapor deposition method. A gate electrode 4 was formed by a photolithography step. The application solution 1 prepared in Synthesis Example 10 was applied by a spin coat method, and dried on a hot plate at 180°C for 30 minutes, to form an insulation layer 3.

Next, a layer of gold (Au) was vapor-deposited by a vapor deposition method using a shadow mask, to form a source electrode 5 and a drain electrode 6. At this point, the source electrode 5 and the drain electrode 6 had a channel length of 20 µm and a channel width of 2 mm. Further, the above-described substrate was immersed in an isopropyl alcohol solution of perfluorobenzenethiol for 2 minutes, to modify the surface of the gold electrode formed on the substrate. Subsequently, a 0.5% by mass polymer compound PA-1 toluene solution was spin-coated and dried on a hot plate at 120°C for 30 minutes to form an organic semiconductor layer 2, to fabricate an organic thin film transistor SA-1.

The transistor characteristic was measured by changing the gate voltage Vg and the source-drain voltage Vsd of the resultant organic thin film transistor SA-1. The carrier mobility was 0.16 cm²/Vs. The results are shown in Table 1.

### Example 8 (Fabrication and evaluation of organic thin film transistor SA-2)

An organic thin film transistor SA-2 was fabricated in the same manner as in Example 7 except that a toluene solution containing the composition PA-1 and the composition PA-2 (0.5% by mass, composition PA-1/composition PA-2 = 96 parts by mass/4 parts by mass) was used instead of the toluene solution containing the composition PA-1 (0.5% by mass).

The transistor characteristic was measured by changing the gate voltage Vg and the source-drain voltage Vsd of the resultant organic thin film transistor SA-2. The carrier mobility was 0.11 cm²/Vs. The results are shown in Table 1.

### Example 9 (Fabrication and evaluation of organic thin film transistor SA-3)

An organic thin film transistor SA-3 was fabricated in the same manner as in Example 7 except that a toluene solution containing the composition PA-1 and the composition PA-2 (0.5% by mass, composition PA-1/composition PA-2 = 87 parts by mass/13 parts by mass) was used instead of the toluene solution containing the composition PA-1 (0.5% by mass).

The transistor characteristic was measured by changing the gate voltage Vg and the source-drain voltage Vsd of the resultant organic thin film transistor SA-3. The carrier mobility was 0.06 cm²/Vs. The results are shown in Table 1.

### Comparative Example 6 (Fabrication and evaluation of organic thin film transistor SA-4)

An organic thin film transistor SA-4 was fabricated in the same manner as in Example 7 except that a toluene solution containing the composition PA-1 and the composition PA-2 (0.5% by mass, composition PA-1/composition PA-2 = 61 parts by mass/39 parts by mass) was used instead of the toluene solution containing the composition PA-1 (0.5% by mass).

The transistor characteristic was measured by changing the gate voltage Vg and the source-drain voltage Vsd of the resultant organic thin film transistor SA-4. The carrier mobility was 0.015 cm²/Vs. The results are shown in Table 1.

### Comparative Example 7 (Fabrication and evaluation of organic thin film transistor SA-5)

An organic thin film transistor SA-5 was fabricated in the same manner as in Example 7 except that a toluene solution containing the composition PA-1 and the composition PA-2 (0.5% by mass, composition PA-1/composition PA-2 = 50 parts by mass/50 parts by mass) was used instead of the toluene solution containing the composition PA-1 (0.5% by mass).

The transistor characteristic was measured by changing the gate voltage Vg and the source-drain voltage Vsd of the resultant organic thin film transistor SA-5. The carrier mobility was 0.005 cm²/Vs. The results are shown in Table 1.

### Comparative Example 8 (Fabrication and evaluation of organic thin film transistor SA-6)

An organic thin film transistor SA-6 was fabricated in the same manner as in Example 7 except that a toluene solution containing the composition PA-1 and the composition PA-2 (0.5% by mass, composition PA-1/composition PA-2 = 24 parts by mass/76 parts by mass) was used instead of the toluene solution containing the composition PA-1 (0.5% by mass).

The transistor characteristic was measured by changing the gate voltage Vg and the source-drain voltage Vsd of the resultant organic thin film transistor SA-6. The carrier mobility was 0.0003 cm²/Vs. The results are shown in Table 1.

### Example 10 (Fabrication and evaluation of organic thin film transistor SB-1)

Using a solution containing the composition PB-1 obtained in Example 2, a top gate bottom contact type organic thin film transistor device having a structure shown in Fig. 1 was fabricated.

A chromium (Cr) layer and a gold (Au) layer were vapor-deposited on a substrate 1 by a vapor-deposition method using a shadow mask, to form a source electrode 5 and a drain electrode 6. At this point, the source electrode 5 and drain electrode 6 had a channel length of 20 µm and a channel width of 2 mm. Next, the above-described substrate was immersed in a toluene solution of phenylethyltrichlorosilane for 2 minutes, to silane-treat the surface of the substrate. Thereafter, the above-described substrate was further immersed in an isopropyl alcohol solution of perfluorobenzenethiol for 2 minutes, to modify the surface of the gold electrode formed on the substrate. Subsequently, a 0.5% by mass polymer compound PB-1 toluene solution (0.5% by mass) was spin-coated, and dried on a hot plate at 120°C for 30 minutes, to form an organic semiconductor layer 2. An insulation film made of teflon (registered trademark) was spin-coated to form a film with a thickness of about 600 nm, and the film was heated on a hot plate at 80°C for 10 minutes, to form an insulation layer 3. On this insulation layer 3, aluminum acting as a gate electrode 4 was formed by a vapor deposition method using a shadow mask, to fabricate an organic thin film transistor SB-1.

The transistor characteristic was measured by changing the gate voltage Vg and the source-drain voltage Vsd of the resultant organic thin film transistor SB-1. The carrier mobility was 1.58 cm²/Vs. The results are shown in Table 2.

### Example 11 (Fabrication and evaluation of organic thin film transistor SB-2)

An organic thin film transistor SB-2 was fabricated in the same manner as in Example 10 except that a toluene solution (0.5% by mass) containing the composition PB-2 obtained in Example 1 was used instead of the toluene solution (0.5% by mass) containing the composition PB-1.

The transistor characteristic was measured by changing the gate voltage Vg and the source-drain voltage Vsd of the resultant organic thin film transistor SB-2. The carrier mobility was 1.61 cm²/Vs. The results are shown in Table 2.

### Example 12 (Fabrication and evaluation of organic thin film transistor SB-3)

An organic thin film transistor SB-3 was fabricated in the same manner as in Example 10 except that a toluene solution (0.5% by mass) containing the composition PB-3 obtained in Example 3 was used instead of the toluene solution (0.5% by mass) containing the composition PB-1.

The transistor characteristic was measured by changing the gate voltage Vg and the source-drain voltage Vsd of the resultant organic thin film transistor SB-3. The carrier mobility was 1.23 cm²/Vs. The results are shown in Table 2.

### Example 13 (Fabrication and evaluation of organic thin film transistor SB-4)

An organic thin film transistor SB-4 was fabricated in the same manner as in Example 10 except that a toluene solution (0.5% by mass) containing the composition PB-4 obtained in Example 4 was used instead of the toluene solution (0.5% by mass) containing the composition PB-1.

The transistor characteristic was measured by changing the gate voltage Vg and the source-drain voltage Vsd of the resultant organic thin film transistor SB-4. The carrier mobility was 1.91 cm²/Vs. The results are shown in Table 2.

### Example 14 (Fabrication and evaluation of organic thin film transistor SB-5)

An organic thin film transistor SB-5 was fabricated in the same manner as in Example 10 except that a toluene solution (0.5% by mass) containing the composition PB-5 obtained in Example 5 was used instead of the toluene solution (0.5% by mass) containing the composition PB-1.

The transistor characteristic was measured by changing the gate voltage Vg and the source-drain voltage Vsd of the resultant organic thin film transistor SB-5. The carrier mobility was 1.49 cm²/Vs. The results are shown in Table 2.

### Comparative Example 9 (Fabrication and evaluation of organic thin film transistor SB-6)

An organic thin film transistor SB-6 was fabricated in the same manner as in Example 10 except that a toluene solution (0.5% by mass) containing the composition PB-6 obtained in Comparative Example 1 was used instead of the toluene solution (0.5% by mass) containing the composition PB-1.

The transistor characteristic was measured by changing the gate voltage Vg and the source-drain voltage Vsd of the resultant organic thin film transistor SB-6. The carrier mobility was 0.59 cm²/Vs. The results are shown in Table 2.

### Comparative Example 10 (Fabrication and evaluation of organic thin film transistor SB-7)

An organic thin film transistor SB-7 was fabricated in the same manner as in Example 10 except that a toluene solution (0.5% by mass) containing the composition PB-7 obtained in Comparative Example 2 was used instead of the toluene solution (0.5% by mass) containing the composition PB-1.

The transistor characteristic was measured by changing the gate voltage Vg and the source-drain voltage Vsd of the resultant organic thin film transistor SB-7. The carrier mobility was 0.84 cm²/Vs. The results are shown in Table 2.

### Comparative Example 11 (Fabrication and evaluation of organic thin film transistor SB-8)

An organic thin film transistor SB-8 was fabricated in the same manner as in Example 10 except that a toluene solution (0.5% by mass) containing the composition PB-8 obtained in Comparative Example 3 was used instead of the toluene solution (0.5% by mass) containing the composition PB-1.

The transistor characteristic was measured by changing the gate voltage Vg and the source-drain voltage Vsd of the resultant organic thin film transistor SB-8. The carrier mobility was 0.80 cm²/Vs. The results are shown in Table 2.

### Comparative Example 12 (Fabrication and evaluation of organic thin film transistor SB-9)

An organic thin film transistor SB-9 was fabricated in the same manner as in Example 10 except that a toluene solution (0.5% by mass) containing the composition PB-9 obtained in Comparative Example 4 was used instead of the toluene solution (0.5% by mass) containing the composition PB-1.

The transistor characteristic was measured by changing the gate voltage Vg and the source-drain voltage Vsd of the resultant organic thin film transistor SB-9. The carrier mobility was 0.63 cm²/Vs. The results are shown in Table 2.

### Reference Example 5 (Fabrication and evaluation of organic thin film transistor SC-1)

Using a solution containing the composition PC-1, a bottom gate bottom contact type organic thin film transistor device having a structure shown in Fig. 3 was fabricated.

The surface of an n-type silicon substrate doped at high concentration acting as a gate electrode 4 was thermally oxidized, to form a silicon oxide film (hereinafter, referred to as "thermally oxidized film") as an insulation layer 3. Next, a source electrode 5 and a drain electrode 6 made of a chromium (Cr) layer and a gold (Au) layer were formed on the thermally oxidized film by a photolithography step. At this point, the source electrode 5 and the drain electrode 6 had a channel length of 20 µm and a channel width of 2 mm. Next, the above-described substrate was immersed in a toluene solution of phenylethyltrichlorosilane for 2 minutes, to silane-treat the surface of the substrate. Thereafter, the above-described substrate was further immersed in an isopropyl alcohol solution of perfluorobenzenethiol for 2 minutes, to modify the surface of the gold electrode formed on the substrate. Next, a 0.5% by mass composition PC-1 orthodichlorobenzene solution was spin-coated, to form an organic semiconductor layer 2. Thereafter, it was heated at 170°C for 30 minutes under a nitrogen gas atmosphere, to fabricate an organic thin film transistor SC-1.

The transistor characteristic was measured by changing the gate voltage Vg and the source-drain voltage Vsd of the resultant organic thin film transistor SC-1. The carrier mobility was 0.4 cm²/Vs. The results are shown in Table 3.

### Reference Example 6 (Fabrication and evaluation of organic thin film transistor SC-2)

An organic thin film transistor SC-2 was fabricated in the same manner as in Reference Example 5 except that an orthodichlorobenzene solution (0.5% by mass) containing the polymer compound PC-2 was used instead of the orthodichlorobenzene solution (0.5% by mass) containing the polymer compound PC-1.

The transistor characteristic was measured by changing the gate voltage Vg and the source-drain voltage Vsd of the resultant organic thin film transistor SC-2. The carrier mobility was 0.19 cm²/Vs. The results are shown in Table 3.

### Reference Example 7 (Fabrication and evaluation of organic thin film transistor SC-3)

An organic thin film transistor SC-3 was fabricated in the same manner as in Reference Example 5 except that an orthodichlorobenzene solution (0.5% by mass) containing the composition PC-3 was used instead of the orthodichlorobenzene solution (0.5% by mass) containing the composition PC-1.

The transistor characteristic was measured by changing the gate voltage Vg and the source-drain voltage Vsd of the resultant organic thin film transistor SC-3. The carrier mobility was 0.04 cm²/Vs. The results are shown in Table 3.

### Reference Example 8 (Fabrication and evaluation of organic thin film transistor SC-4)

An organic thin film transistor SC-4 was fabricated in the same manner as in Reference Example 5 except that an orthodichlorobenzene solution (0.5% by mass) containing the composition PC-4 was used instead of the orthodichlorobenzene solution (0.5% by mass) containing the composition PC-1.

The transistor characteristic was measured by changing the gate voltage Vg and the source-drain voltage Vsd of the resultant organic thin film transistor SC-4. The carrier mobility was 0.77 cm²/Vs. The results are shown in Table 3.

**[Table 1]**

| | Organic transistor | Organic semiconductor layer | | Pd content rate (ppm) | P content rate (ppm) | Electric field-effect mobility (cm²/Vs) | Device structure | |
|---|---|---|---|---|---|---|---|---|
| Example 7 | SA-1 | PA-1 | | 9 | 50 | 0.16 | Fig. 3 | Transistor 120 |
| Example 8 | SA-2 | PA-1 (96 parts by weight) | PA-2 (4 parts by weight) | 66 | 67 | 0.11 | Fig. 3 | Transistor 120 |
| Example 9 | SA-3 | PA-1 (87 parts by weight) | PA-2 (13 parts by weight) | 188 | 104 | 0.06 | Fig. 3 | Transistor 120 |
| Comparative Example 6 | SA-4 | PA-1 (61 parts by weight) | PA-2 (39 parts by weight) | 553 | 214 | 0.015 | Fig. 3 | Transistor 120 |
| Comparative Example 7 | SA-5 | PA-1 (50 parts by weight) | PA-2 (50 parts by weight) | 707 | 222 | 0.005 | Fig. 3 | Transistor 120 |
| Comparative Example 8 | SA-6 | PA-1 (24 parts by weight) | PA-2 (76 parts by weight) | 1061 | 312 | 0.0003 | Fig. 3 | Transistor 120 |

**[Table 2]**

| | Organic transistor | Organic semiconductor layer | Pd content rate (ppm) | P content rate (ppm) | Electric field-effect mobility (cm²/Vs) | Device structure | |
|---|---|---|---|---|---|---|---|
| Example 10 | SB-1 | PB-1 | 1.1 | 27 | 1.58 | Fig. 1 | Transistor 100 |
| Example 11 | SB-2 | PB-2 | 1.8 | 22 | 1. 61 | Fig. 1 | Transistor 100 |
| Example 12 | SB-3 | PB-3 | 2.0 | 26 | 1.23 | Fig. 1 | Transistor 100 |
| Example 13 | SB-4 | PB-4 | 3.6 | 11 | 1. 91 | Fig. 1 | Transistor 100 |
| Example 14 | SB-5 | SB-5 | 5.0 | 24 | 1.49 | Fig. 1 | Transistor 100 |
| Comparative Example 9 | SB-6 | SB-6 | 56 | 32 | 0.59 | Fig. 1 | Transistor 100 |
| Comparative Example 10 | SB-7 | SB-7 | 100 | 51 | 0.84 | Fig. 1 | Transistor 100 |
| Comparative Example 11 | SB-8 | SB-8 | 140 | 73 | 0.80 | Fig. 1 | Transistor 100 |
| Comparative Example 12 | SB-9 | SB-9 | 190 | 71 | 0.63 | Fig. 1 | Transistor 100 |

**[Table 3]**

| | Organic transisto r | Organic semiconducto r layer | Pd content rate (ppm) | P content rate (ppm) | Electric field-effect mobility (cm ²/Vs) | Device structure | |
|---|---|---|---|---|---|---|---|
| Reference Example 5 | SC-1 | PC-1 | 20 | 20 | 0.4 | Fig. 3 | Transistor 120 |
| Reference Example 6 | SC-2 | PC-2 | 30 | 10 | 0.19 | Fig. 3 | Transistor 120 |
| Reference Example 7 | SC-3 | PC-3 | 20 | 40 | 0.04 | Fig. 3 | Transistor 120 |
| Reference Example 8 | SC-4 | PC-4 | 340 | 10 | 0.07 | Fig. 3 | Transistor 120 |

### Synthesis Example 8

### (Synthesis of compound 14)

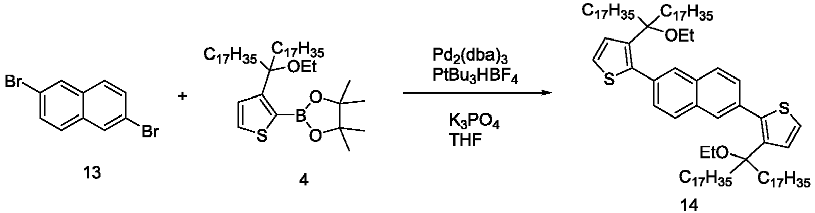

A nitrogen gas atmosphere was prepared in a reaction vessel equipped with a reflux tube, then, the compound 13 (4.80 g, 16.8 mmol) and dry THF (280 mL) were added, and the mixture was deaerated for 30 minutes by bubbling with an argon gas. Thereafter, to this were added tris(dibenzylideneacetone)dipalladium(0) (769 mg, 0.839 mmol), tri-tert-butylphosphonium tetrafluoroborate (1.02 g, 3.36 mmol) and a 3 M potassium phosphate aqueous solution (84 mL), and the mixture was heated at 80°C. Thereafter, into this, a dry THF (170 mL) solution of the compound 4 (44.7 g, 42.0 mmol) deaerated for 30 minutes by argon gas bubbling was dropped at 80°C over a period of 5 minutes, and the mixture was heated at the same temperature for 4.5 hours. Thereafter, the reaction product was extracted using hexane (200 mL). The resultant organic layer was washed with saturated saline, and dried over anhydrous magnesium sulfate and filtrated. The resultant filtrate was concentrated by an evaporator, then, the solvent was distilled off. The resultant residue was purified by silica gel column chromatography using a mixed solvent of hexane and chloroform as a moving bed, to obtain 6.8 g of a compound 14. The yield was 30%. This operation was repeated, to obtain a necessary amount of the compound 14.

¹H-NMR (300 MHz, CDCl₃): δ (ppm) = 0.88 (t, 12H), 0.98 (t, 6H), 1.24 (m, 120H), 1.66 (m, 8H), 3.21 (q, 4H), 7.10 (d, 2H), 7.22 (d, 2H), 7.53 (d, 2H), 7.74 (d, 2H), 7.85 (s, 2H) .

### Synthesis Example 9

### (Synthesis of compound 15)

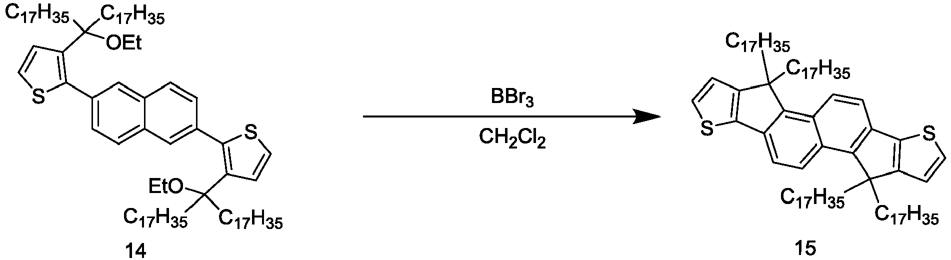

A nitrogen gas atmosphere was prepared in a reaction vessel, then, the compound 14 (7.68 g, 5.78 mmol) and dry methylene chloride (190 mL) were added. Thereafter, to this was added a 1 M boron tribromide methylene chloride solution (23.1 mL, 23.1 mmol) at -78°C, then, the mixture was heated up to room temperature and stirred for 4 hours at room temperature. Thereafter, to this was added water, and the reaction product was extracted using chloroform. The resultant organic layer was washed with water, and dried over anhydrous magnesium sulfate and filtrated. The resultant filtrate was concentrated by an evaporator, then, the solvent was distilled off. The resultant residue was purified by silica gel column chromatography using hexane as a moving bed, to obtain 4.78 g of a compound 15. The yield was 67%.

¹H-NMR (300 MHz, CD₂Cl₂): δ (ppm) = 0.93 (t, 12H), 1.24 (m, 120H), 2.35 (m, 8H), 7.13 (d, 2H), 7.40 (d, 2H), 7.74 (d, 2H), 8.18 (d, 2H).

### Synthesis Example 10

### (Synthesis of compound 16)

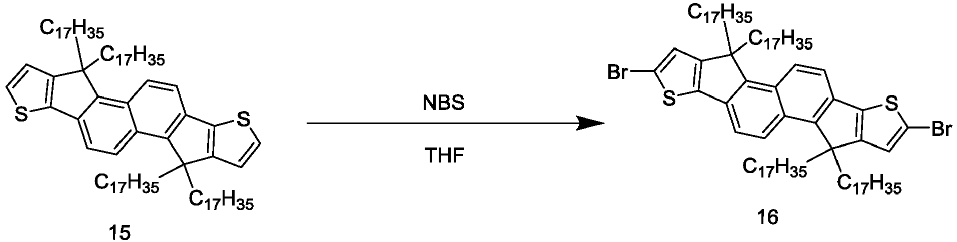

A nitrogen gas atmosphere was prepared in a reaction vessel, then, the compound 15 (4.77 g, 3.78 mmol) and dry THF (375 mL) were added. Thereafter, to this was added N-bromosuccinic imide (1.47 g, 8.26 mmol) at room temperature, and the mixture was stirred for 3 hours at room temperature. Thereafter, to this were added a saturated sodium thiosulfate aqueous solution (10 mL) and water (20 mL) and the mixture was stirred for 5 minutes. Thereafter, the reaction product was extracted using hexane. The resultant organic layer was washed with water, and dried over anhydrous magnesium sulfate and filtrated. The resultant filtrate was concentrated by an evaporator, then, the solvent was distilled off. The resultant residue was purified by silica gel column chromatography using hexane as a moving bed, and re-crystallized using hexane, to obtain 4.06 g of a compound 16. The yield was 76%.

¹H-NMR (300 MHz, CDCl₃): δ (ppm) = 0.88 (t, 12H), 1.24 (m, 120H), 2.22 (m, 8H), 7.052 (s, 2H), 7.57 (d, 2H), 7.04 (d, 2H).

### Example 15

### (Synthesis of composition PD-1)

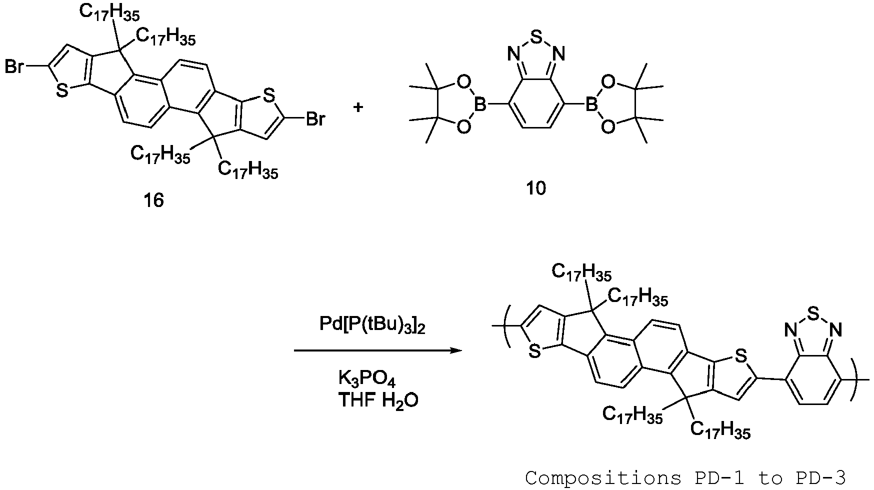

A nitrogen gas atmosphere was prepared in a reaction vessel, then, the compound 16 (0.285 g, 0.200 mmol), the compound 10 (0.078 g, 0.200 mmol), tetrahydrofuran (20 mL) and bis(tri-tert-butylphosphine)palladium (10.2 mg) were added and stirred. Thereafter, to this was added a 2 mol/L potassium carbonate aqueous solution (1.00 mL), and the mixture was stirred at 25°C for 3 hours. Thereafter, to this was added phenylboronic acid (10.0 mg), and the mixture was stirred at 25°C for 1 hour. Thereafter, to this was added sodium N,N-diethyldithiocarbamate trihydrate (0.1 g), and the mixture was stirred at 80°C for 3 hours. The resultant reaction solution was dropped into water, then, extracted using toluene. The resultant organic layer was washed with an acetic acid aqueous solution and water, then, dropped into methanol, to obtain a deposit. The resultant deposit was dissolved in toluene (63 mL), then, alumina (15 g) was added, the mixture was stirred at room temperature for 3 hours, then, alumina was removed by filtration. The resultant solution was dropped into acetone, to obtain a deposit. The resultant deposit was washed by a Soxhlet extractor using acetone as a solvent, and dried, to obtain a composition PD-1. The polystyrene-equivalent number-average molecular weight was 5.6×10⁴ and the polystyrene-equivalent weight-average molecular weight was 1.2×10⁵.

The content rates of palladium (Pd) and phosphorus (P) contained in the composition PD-1 were 3 ppm by mass and 10 ppm by mass, respectively.

### Example 16

### (Synthesis of composition PD-2)

A nitrogen gas atmosphere was prepared in a reaction vessel, then, the compound 16 (0.285 g, 0.200 mmol), the compound 10 (0.078 g, 0.200 mmol), tetrahydrofuran (20 mL) and bis(tri-tert-butylphosphine)palladium (10.2 mg) were added and stirred. Thereafter, to this was added a 2 mol/L potassium carbonate aqueous solution (1.00 mL), and the mixture was heated up to 50°C, then, stirred at 50°C for 3 hours. Thereafter, to this was added phenylboronic acid (10.0 mg), and the mixture was stirred at 50°C for 1 hours. Thereafter, to this was added sodium N,N-diethyldithiocarbamate trihydrate (0.1 g), and the mixture was stirred at 80°C for 3 hours. The resultant reaction solution was dropped into water, then, extracted using toluene. The resultant organic layer was washed with an acetic acid aqueous solution and water, then, dropped into methanol, to obtain a deposit. The resultant deposit was dissolved in toluene (63 mL), then, alumina (15 g) was added, the mixture was stirred at room temperature for 3 hours, then, alumina was removed by filtration. The resultant solution was dropped into acetone, to obtain a deposit. The resultant deposit was washed by a Soxhlet extractor using acetone as a solvent, and dried, to obtain a composition PD-2. The polystyrene-equivalent number-average molecular weight was 9.5×10⁴ and the polystyrene-equivalent weight-average molecular weight was 2.0×10⁵.

The content rates of palladium (Pd) and phosphorus (P) contained in the composition PD-2 were 5 ppm by mass and 24 ppm by mass, respectively.

### Comparative Example 13

### (Synthesis of composition PD-3)

A nitrogen gas atmosphere was prepared in a reaction vessel, then, the compound 16 (0.285 g, 0.200 mmol), the compound 10 (0.078 g, 0.200 mmol), tetrahydrofuran (20 mL) and bis(tri-tert-butylphosphine)palladium (10.2 mg) were added and stirred. Thereafter, to this was added a 2 mol/L potassium carbonate aqueous solution (1.00 mL), and the mixture was heated up to 45°C, then, stirred at 45°C for 3 hours. Thereafter, to this was added phenylboronic acid (10.0 mg), and the mixture was stirred at 45°C for 1 hour. Thereafter, to this was added sodium N,N-diethyldithiocarbamate trihydrate (0.1 g), and the mixture was stirred at 80°C for 3 hours. The resultant reaction solution was dropped into water, then, extracted using toluene. The resultant organic layer was washed with an acetic acid aqueous solution and water, then, purified by silica gel column chromatography. The resultant organic layer was dropped into acetone, to obtain a deposit. The resultant deposit was washed by a Soxhlet extractor using acetone as a solvent, and dried, to obtain a composition PD-3. The polystyrene-equivalent number-average molecular weight was 3.5×10⁴ and the polystyrene-equivalent weight-average molecular weight was 1.1×10⁵.

The content rates of palladium (Pd) and phosphorus (P) contained in the composition PD-3 were 17 ppm by mass and 145 ppm by mass, respectively.

### Comparative Example 14

### (Synthesis of composition PB-10)

A gas in a reaction vessel was purged with a nitrogen gas, then, the compound 9 (6232.40 mg), the compound 10 (1793.02 mg), tetrahydrofuran (413.7 mL) and bis(tri-tert-butylphosphine)palladium (107.3 mg) were added and stirred. Into the resultant reaction solution, 21 mL of a 3 mol/L potassium phosphate aqueous solution was dropped, and the mixture was stirred at 25°C for 3 hours. Seventeen milliliters (17 mL) of the resultant reaction solution was dropped into methanol, to obtain a deposit. The resultant deposit was collected by filtration, and dried under reduced pressure, to obtain a composition PB-10.

The polystyrene-equivalent number-average molecular weight was 4.5×10⁴ and the polystyrene-equivalent weight-average molecular weight was 1.1×10⁵.

The content rates of palladium (Pd) and phosphorus (P) contained in the composition PB-10 were 1300 ppm by mass and 37 ppm by mass, respectively.

### Example 17

### (Synthesis of composition PB-11)

The composition PB-10 (0.1 g) obtained in Comparative Example 14 was dissolved in toluene, and sodium N,N-diethyldithiocarbamate trihydrate (0.1 g) was added, and the mixture was stirred at 80°C for 1 hour. The resultant organic layer was washed with an acetic acid aqueous solution and water, then, dropped into methanol, to obtain a deposit. The resultant deposit was dissolved in toluene (63 mL), then, alumina (15 g) was added, the mixture was stirred at room temperature for 3 hours, then, alumina was removed by filtration. The resultant solution was dropped into acetone, to obtain a deposit. The resultant deposit was dissolved in toluene (63 mL) again, then, alumina (15 g) was added, the mixture was stirred at room temperature for 3 hours, then, alumina was removed by filtration. The resultant solution was dropped into acetone, to obtain a deposit. The resultant deposit was collected by filtration, and dried under reduced pressure, to obtain a composition PB-11.

The polystyrene-equivalent number-average molecular weight was 4.3×10⁴ and the polystyrene-equivalent weight-average molecular weight was 1.1×10⁵.

The content rates of palladium (Pd) and phosphorus (P) contained in the composition PB-11 were 3 ppm by mass and 12 ppm by mass, respectively.

### Example 18 (Fabrication and evaluation of organic thin film transistor SD-1)

An organic thin film transistor SD-1 was fabricated in the same manner as in Example 10 except that a toluene solution (0.5% by mass) containing the composition PD-1 obtained in Example 15 was used instead of the toluene solution (0.5% by mass) containing the composition PB-1.

The transistor characteristic was measured by changing the gate voltage Vg and the source-drain voltage Vsd of the resultant organic thin film transistor SD-1. The carrier mobility was 1.31 cm²/Vs.

### Example 19 (Fabrication and evaluation of organic thin film transistor SD-2)

An organic thin film transistor SD-2 was fabricated in the same manner as in Example 10 except that a toluene solution (0.5% by mass) containing the composition PD-2 obtained in Example 16 was used instead of the toluene solution (0.5% by mass) containing the composition PB-1.

The transistor characteristic was measured by changing the gate voltage Vg and the source-drain voltage Vsd of the resultant organic thin film transistor SD-2. The carrier mobility was 2.08 cm²/Vs.

### Comparative Example 15 (Fabrication and evaluation of organic thin film transistor SD-3)

An organic thin film transistor SD-3 was fabricated in the same manner as in Example 10 except that a toluene solution (0.5% by mass) containing the composition PD-3 obtained in Comparative Example 13 was used instead of the toluene solution (0.5% by mass) containing the composition PB-1.

The transistor characteristic was measured by changing the gate voltage Vg and the source-drain voltage Vsd of the resultant organic thin film transistor SD-3. The carrier mobility was 1.05 cm²/Vs.

### Comparative Example 16 (Fabrication and evaluation of organic thin film transistor SB-10)

An organic thin film transistor SB-10 was fabricated in the same manner as in Example 10 except that a toluene solution containing the composition PB-10 and the composition PA-11 (0.5% by mass, composition PB-10/composition PB-11 = 50 parts by mass/50 parts by mass) was used instead of the toluene solution (0.5% by mass) containing the composition PB-1.

The transistor characteristic was measured by changing the gate voltage Vg and the source-drain voltage Vsd of the resultant organic thin film transistor SB-10. The carrier mobility was 0.94 cm²/Vs.

### Industrial Applicability

According to the present invention, a composition containing a polymer compound which is useful for production of an organic thin film transistor having high electric field-effect mobility and the organic thin film transistor can be provided.

### Explanation of numeral references

1: substrate, 2: organic semiconductor layer, 3: insulation layer, 4: gate electrode, 5: source electrode, 6: drain electrode, 100: organic thin film transistor, 110: organic thin film transistor, 120: organic thin film transistor, 130: organic thin film transistor, 140: organic thin film transistor, 150: organic thin film transistor, 160: organic thin film transistor

## Claims

1. A composition comprising a polymer compound containing a structural unit represented by the formula (1) and at least one compound selected from the group consisting of a compound containing Pd, a compound containing P and a compound containing Pd and P,
wherein the content rate of the polymer compound is 95% by mass or more, the content rate of Pd is 50 ppm by mass or less and the content rate of P is 60 ppm by mass or less: 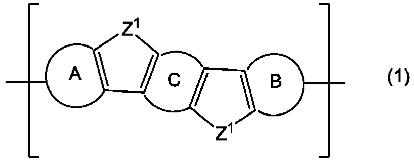 wherein
the ring A and the ring B each independently represent a hetero ring having a number of carbon atoms of 2 to 30 optionally having a substituent;
the ring C represents an aromatic hydrocarbon ring having a number of carbon atoms of 6 to 30 optionally having a substituent or a hetero ring having a number of carbon atoms of 2 to 30 optionally having a substituent and the substituent which these groups optionally have is selected from the following Group 1;
Z¹ represents a group represented by the formula (Z-1), a group represented by the formula (Z-2), a group represented by the formula (Z-3), a group represented by the formula (Z-4) or a group represented by the formula (Z-5) and a plurality of Z¹ may be mutually the same or different; and
Group 1: an alkyl group having a number of carbon atoms of 1 to 30, a cycloalkyl group having a number of carbon atoms of 3 to 30, an alkoxy group having a number of carbon atoms of 1 to 30, a cycloalkoxy group having a number of carbon atoms of 3 to 30, an alkylthio group having a number of carbon atoms of 1 to 30, a cycloalkylthio group having a number of carbon atoms of 3 to 30, an aryl group having a number of carbon atoms of 6 to 30, a monovalent hetero ring group having a number of carbon atoms of 2 to 30, a halogen atom, a group represented by -Si(R')₃ (three R' each independently represent a hydrogen atom, an alkyl group having a number of carbon atoms of 1 to 30, a cycloalkyl group having a number of carbon atoms of 3 to 30 or a monovalent hetero ring group having a number of carbon atoms of 2 to 30 optionally having an alkyl group.), a group represented by -N(R')₂ (two R' represent the same meaning as described above.), an alkenyl group having a number of carbon atoms of 2 to 30, a cycloalkenyl group having a number of carbon atoms of 3 to 30, an alkynyl group having a number of carbon atoms of 2 to 30, a cycloalkynyl group having a number of carbon atoms of 3 to 30, a hydroxy group, a nitro group, a cyano group, a carboxy group, an alkylcarbonyl group having a number of carbon atoms of 2 to 30, a cycloalkylcarbonyl group having a number of carbon atoms of 4 to 30, an alkoxycarbonyl group having a number of carbon atoms of 2 to 30 and a cycloalkoxycarbonyl group having a number of carbon atoms of 4 to 30; 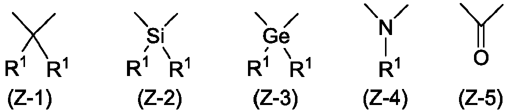 wherein
R¹ represents an alkyl group having a number of carbon atoms of 1 to 30 optionally having a substituent, a cycloalkyl group having a number of carbon atoms of 3 to 30 optionally having a substituent, an alkoxy group having a number of carbon atoms of 1 to 30 optionally having a substituent, a cycloalkoxy group having a number of carbon atoms of 3 to 30 optionally having a substituent, an alkylthio group having a number of carbon atoms of 1 to 30 optionally having a substituent, a cycloalkylthio group having a number of carbon atoms of 3 to 30 optionally having a substituent, an aryl group having a number of carbon atoms of 6 to 30 optionally having a substituent or a monovalent hetero ring group having a number of carbon atoms of 2 to 30 optionally having a substituent; and
when a plurality of R¹ are present, they may be the same or different.

2. The composition according to Claim 1, comprising a polymer compound containing a structural unit represented by the formula (1) and at least one compound selected from the group consisting of a compound containing Pd, a compound containing P and a compound containing Pd and P,
wherein the content rate of the polymer compound is 95% by mass or more, the content rate of Pd is 50 ppm by mass or less and the content rate of P is 30 ppm by mass or less.

3. The composition according to Claim 1 or 2, wherein the structural unit represented by said formula (1) is a structural unit represented by the formula (1-1), a structural unit represented by the formula (1-2) or a structural unit represented by the formula (1-3): 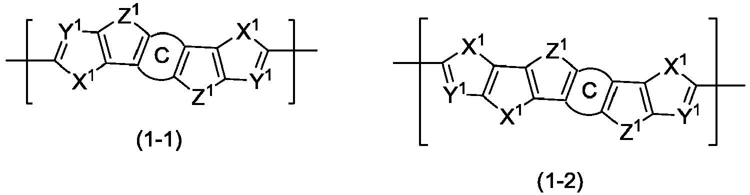 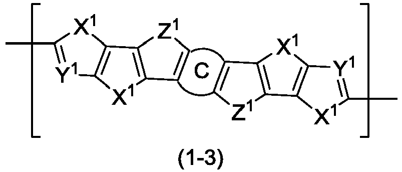 wherein
the ring C and Z¹ represent the same meaning as described above;
X¹ represents an oxygen atom, a sulfur atom or a selenium atom;
a plurality of X¹ may be mutually the same or different;
Y¹ represents a nitrogen atom or a group represented by -CR²= (R² represents a hydrogen atom, an alkyl group having a number of carbon atoms of 1 to 30 optionally having a substituent, a cycloalkyl group having a number of carbon atoms of 3 to 30 optionally having a substituent, an alkoxy group having a number of carbon atoms of 1 to 30 optionally having a substituent, a cycloalkoxy group having a number of carbon atoms of 3 to 30 optionally having a substituent, an alkylthio group having a number of carbon atoms of 1 to 30 optionally having a substituent, a cycloalkylthio group having a number of carbon atoms of 3 to 30 optionally having a substituent, an aryl group having a number of carbon atoms of 6 to 30 optionally having a substituent, a monovalent hetero ring group having a number of carbon atoms of 2 to 30 optionally having a substituent or a halogen atom); and
a plurality of Y¹ may be mutually the same or different.

4. The composition according to any one of Claims 1 to 3, wherein the ring A and the ring B in said formula (1) are each independently a hetero ring having a number of carbon atoms of 3 to 10 constituted of a 5-membered and/or 6-membered hetero ring optionally having a substituent.

5. The composition according to Claim 4, wherein the ring A and the ring B in said formula (1) are the same and represent a thiophene ring optionally having a substituent or a thienothiophene ring optionally having a substituent.

6. The composition according to any one of Claims 1 to 5, wherein said ring C is a benzene ring optionally having a substituent, a naphthalene ring optionally having a substituent, a benzodithiophene ring optionally having a substituent, a benzothiophene ring optionally having a substituent or a thienothiophene ring.

7. The composition according to Claim 6, wherein said ring C is a benzene ring optionally having a substituent or a naphthalene ring optionally having a substituent.

8. The composition according to Claim 3, 6 or 7, wherein said X¹ is a sulfur atom.

9. The composition according to Claim 3, 6, 7 or 8, wherein said Y¹ is a group represented by -CH=.

10. The composition according to any one of Claims 1 to 9, wherein said Z¹ is a group represented by said formula (Z-1).

11. The composition according to any one of Claims 1 to 10, wherein the polymer compound containing a structural unit represented by the formula (1) further contains a structural unit represented by the formula (2), which is different from said structural unit represented by the formula (1);
-[-Ar-]- (2)
wherein
Ar represents an arylene group having a number of carbon atoms of 6 to 60 optionally having a substituent or a divalent hetero ring group having a number of carbon atoms of 2 to 30 optionally having a substituent. The substituent which these groups optionally have is selected from the following Group 2. However, the structural unit represented by the formula (2) is different from the structural unit represented by the formula (1); and
Group 2: an alkyl group having a number of carbon atoms of 1 to 30, a cycloalkyl group having a number of carbon atoms of 3 to 30, an alkoxy group having a number of carbon atoms of 1 to 30, a cycloalkoxy group having a number of carbon atoms of 3 to 30, an alkylthio group having a number of carbon atoms of 1 to 30, a cycloalkylthio group having a number of carbon atoms of 3 to 30, a monovalent aryl group having a number of carbon atoms of 6 to 30, a monovalent hetero ring group having a number of carbon atoms of 2 to 30 and a halogen atom.

12. An ink composition comprising the composition according to any one of Claims 1 to 11 and an organic solvent, wherein the value of (mass of composition)/(mass of composition and organic solvent) × 100 is 0.1% by mass or more and 20% by mass or less.

13. An organic thin film transistor having a gate electrode, a source electrode, a drain electrode, an organic semiconductor layer and a gate insulation layer, wherein said organic semiconductor layer contains the composition according to any one of Claims 1 to 11.
